# EUROPEAN PATENT APPLICATION

(11) **EP 4 284 147 A1**
(43) Date of publication of application: **29.11.2023**
(21) Application number: 23175135.5
(22) Date of filing: 24.05.2023
(51) Int. Cl.: H10K 85/30, H10K 85/60, H10K 50/11, H10K 50/16

(54) **LIGHT-EMITTING DEVICE, ELECTRONIC DEVICE INCLUDING THE SAME, AND ELECTRONIC APPARATUS INCLUDING THE SAME**

(30) Priority: 24.05.2022 KR 20220063286; 29.12.2022 KR 20220189635
(71) Applicant: Samsung Display Co., Ltd., Gyeonggi-Do 17113 (KR)
(72) Inventor: Kim, Gyeongheon, 17113 Yongin-si, Gyeonggi-do (KR); Cho, Sooryun, 17113 Yongin-si, Gyeonggi-do (KR); Kim, Sohae, 17113 Yongin-si, Gyeonggi-do (KR); Kim, Jihye, 17113 Yongin-si, Gyeonggi-do (KR); Kim, Hoilim, 17113 Yongin-si, Gyeonggi-do (KR); Park, Saerom, 17113 Yongin-si, Gyeonggi-do (KR); Yoo, Dongsun, 17113 Yongin-si, Gyeonggi-do (KR); Jung, Sungyu, 17113 Yongin-si, Gyeonggi-do (KR)
(74) Representative: Gulde & Partner

(57) **Abstract**

An electronic device including the light-emitting device, and a consumer product including the light-emitting device. The light-emitting device includes a first electrode (110), a second electrode (150) facing the first electrode, and an interlayer (130) between the first electrode and the second electrode, wherein the interlayer includes an emission layer and an electron transport region, wherein the electron transport region is between the emission layer and the second electrode, and the emission layer includes a first emitter, and the electron transport region includes a heterocyclic compound. The descriptions of the first emitter and the heterocyclic compound are the same as described in the present specification.

## Description

### BACKGROUND

### 1. Field

Embodiments of the present disclosure relate to a light-emitting device, an electronic device including the same, and an electronic apparatus including the same.

### 2. Description of the Related Art

Self-emissive devices (for example, organic light-emitting devices) from among light-emitting devices have relatively wide viewing angles, high contrast ratios, short response times, and excellent or suitable characteristics in terms of luminance, driving voltage, and response speed.

In a light-emitting device, a first electrode is located on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons transition (e.g., decay) from an excited state to a ground state to thereby generate light.

### SUMMARY

Aspects of embodiments are directed toward a light-emitting device having a low driving voltage and high power efficiency, an electronic device including the same, and an electronic apparatus including the same.

Additional aspects will be set forth in part in the description which follows and, in part, will be apparent from the description, or may be learned by practice of the presented embodiments of the disclosure.

According to one or more embodiments, a light-emitting device includes
a first electrode,
a second electrode facing the first electrode, and
an interlayer located between the first electrode and the second electrode,
wherein the interlayer may include an emission layer and an electron transport region,
the electron transport region may be located between the emission layer and the second electrode,
the emission layer may include a first emitter,
the first emitter may be configured to emit first light having a first emission spectrum,
the first emitter may include platinum,
a triplet metal-to-ligand charge transfer state (³MLCT) of the first emitter is 7 % or more,
the ³MLCT may be evaluated by performing quantum chemical calculations based on density functional theory (DFT),
the electron transport region may include a heterocyclic compound, and
the heterocyclic compound may include,
a first moiety including a group represented by one of Formulae 8-1 to 8-4, and
a second moiety including a diazine group, a triazine group, or one or more combinations thereof,
wherein the first moiety and the second moiety may be linked to each other through a single bond or a first linking group: 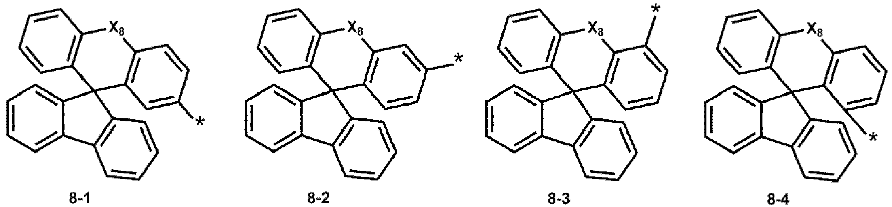 wherein, in Formulae 8-1 to 8-4,
   X₈ may be O, S, or Se, and
   * indicates a binding site to a single bond bonded to the second moiety or a first linking group bonded to the second moiety.

According to one or more embodiments, a light-emitting device includes
a first electrode,
a second electrode facing the first electrode, and
an interlayer located between the first electrode and the second electrode,
wherein the interlayer may include an emission layer and an electron transport region,
the electron transport region may be located between the emission layer and the second electrode,
the emission layer may include a first emitter,
the first emitter may be configured to emit first light having a first emission spectrum,
the first emitter may be an organometallic compound represented by Formula 1,
the electron transport region may include a heterocyclic compound, and
the heterocyclic compound may include,
a first moiety including a group represented by one of Formulae 8-1 to 8-4, and
a second moiety including a diazine group, a triazine group, or one or more combinations thereof,
wherein the first moiety and the second moiety may be linked to each other through a single bond or a first linking group:

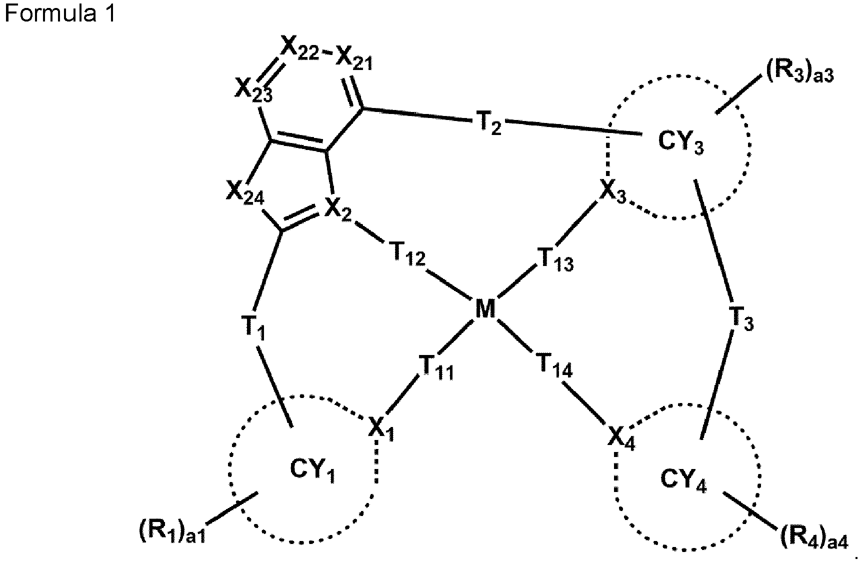

The description of Formula 1 is the same as provided to the detailed description: 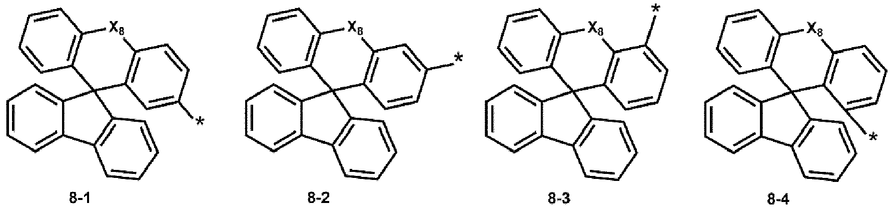 wherein, in Formulae 8-1 to 8-4,
X₈ may be O, S, or Se, and
* indicates a binding site to a single bond bonded to the second moiety or a first linking group bonded to the second moiety.

According to one or more embodiments, an electronic device includes the light-emitting device.

According to one or more embodiments, an electronic apparatus includes the light-emitting device.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 shows a schematic cross-sectional view of a light-emitting device according to an embodiment;
FIGS. 2 and 3 are cross-sectional views each schematically showing a structure of a light-emitting device, which is one of electronic devices according to an embodiment; and
FIGS. 4, 5, 6A, 6B, and 6C are diagrams each schematically showing the structure of an electronic apparatus according to an embodiment.

### DETAILED DESCRIPTION

Reference will now be made in more detail to embodiments, examples of which are illustrated in the accompanying drawings, wherein like reference numerals refer to like elements throughout, and duplicative descriptions thereof may not be provided. In this regard, the present embodiments may have different forms and should not be construed as being limited to the descriptions set forth herein. Accordingly, the embodiments are merely described, by referring to the drawings, to explain aspects of the present description. Further, the use of "may" when describing embodiments of the inventive concept refers to "one or more embodiments of the present disclosure."

As utilized herein, the term "and/or" includes any and all combinations of one or more of the associated listed items. Throughout the disclosure, the expression "at least one of a, b or c", "at least one of a-c", "at least one of a to c", "at least one of a, b, and/or c", etc., indicates only a, only b, only c, both (e.g., simultaneously) a and b, both (e.g., simultaneously) a and c, both (e.g., simultaneously) b and c, all of a, b, and c, or variations thereof.

In the present specification, "including A or B", "A and/or B", etc., represents A or B, or A and B.

Spatially relative terms, such as "beneath", "below", "lower", "downward", "above", "upper", "left", "right", and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

Unless explicitly described to the contrary, the word "comprise", and variations such as "comprises" or "comprising", will be understood to imply the inclusion of stated elements but not the exclusion of any other elements. As used herein, the term "substantially," "about," and similar terms are used as terms of approximation and not as terms of degree, and are intended to account for the inherent deviations in measured or calculated values that would be recognized by those of ordinary skill in the art. "About" or "substantially", as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" or "substantially" may mean within one or more standard deviations, or within ± 30%, 20%, 10%, 5% of the stated value.

A light-emitting device according to an embodiment includes: a first electrode; a second electrode facing the first electrode; and an interlayer disposed between the first electrode and the second electrode.

The interlayer may include an emission layer and an electron transport region.

The electron transport region may be disposed between the emission layer and the second electrode.

The emission layer may include a first emitter. The first emitter may be configured to emit first light having a first emission spectrum.

The emission peak wavelength of the first light (maximum emission wavelength, or maximum emission peak wavelength) may be about 510 nm to about 610 nm, or about 511 nm to about 604 nm.

The full width at half maximum (FWHM) of the first light may be about 15 nm to about 85 nm.

For example, the FWHM of the first light may be about 20 nm to about 85 nm, about 25 nm to about 85 nm, about 15 nm to about 80 nm, about 20 nm to about 80 nm, about 25 nm to about 80 nm, about 15 nm to about 75 nm, about 20 nm to about 75 nm, about 25 nm to about 75 nm, about 15 nm to about 70 nm, about 20 nm to about 70 nm, about 25 nm to about 70 nm, about 15 nm to about 65 nm, about 20 nm to about 65 nm, about 25 nm to about 65 nm, about 15 nm to about 60 nm, about 20 nm to about 60 nm, or about 25 nm to about 60 nm.

The emission peak wavelength (or maximum emission wavelength) and FWHM of the first light described in the present specification may be evaluated from the emission spectrum of a film including the first emitter (for example, see Evaluation Example 2). The emission peak wavelength in the present specification refers to the peak wavelength having the maximum emission intensity in the emission spectrum or the electroluminescence spectrum.

The first light may be a green light.

The first emitter may include platinum.

For example, the first emitter may be an organometallic compound including platinum. The first emitter may be neutral, may include one platinum, and may not include (e.g., may exclude) transition metals other than platinum.

The triplet metal-to-ligand charge transfer state (³MLCT) of the first emitter may be 7% or more.

For example, ³MLCT of the first emitter may be about 7% to about 30%, about 7% to about 25%, about 7% to about 20%, about 7% to about 18%, about 7% to about 16%, about 8% to about 30%, about 8% to about 25%, about 8% to about 20%, about 8% to about 18%, about 8% to about 16%, about 9% to about 30%, about 9% to about 25%, about 9% to about 20%, about 9% to about 18%, or about 9% to about 16%.

The ³MLCT is evaluated by performing quantum chemical calculations based on density functional theory (DFT) (for example, refer to Evaluation Example 1).

In an embodiment, the first emitter may include, in addition to the platinum, a first ligand bound to the platinum.

In an embodiment, the first emitter may satisfy at least one of Condition A to Condition C:

### Condition A

The first ligand is a tetradentate ligand, and
the number of cyclometallated rings formed by a chemical bond between the platinum and the first ligand is three.

### Condition B

Each of carbon, nitrogen and oxygen of the first ligand is chemically bonded to the platinum.

### Condition C

The first ligand includes an imidazole group, a benzimidazole group, a naphthoimidazole group, or one or more combinations thereof.

In an embodiment, the first emitter may satisfy all of Condition A to Condition C.

More details for the first emitter are as described herein.

The electron transport region may include a heterocyclic compound.

The heterocyclic compound may include:
a first moiety including a group represented by one of Formulae 8-1 to 8-4; and
a second moiety including a diazine group (for example, a pyrimidine group, a pyrazine group, a pyridazine group, etc.), a triazine group, or a combination thereof.

The description of Formulae 8-1 to 8-4 may be understood by referring to the related description to be presented later.

The first moiety and the second moiety may be linked to each other through a single bond or a first linking group. The description of the first linking group may be the same as provided in connection with *-(Ar₃)ₓ₃-*' in Formula 8. 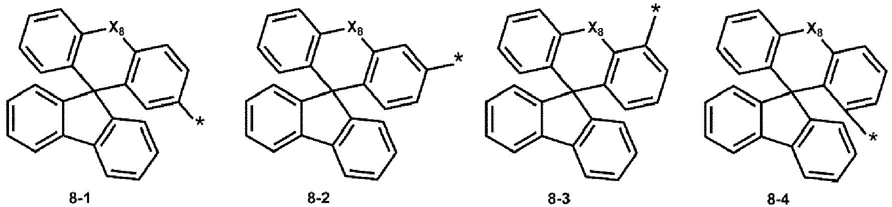 wherein, in Formulae 8-1 to 8-4,
X₈ may be O, S, or Se, and
* indicates a binding site to a single bond bonded to the second moiety or a first linking group bonded to the second moiety.

More details for the heterocyclic compound are as described herein.

The light-emitting device includes 1) an emission layer including the first emitter and 2) an electron transport region including the heterocyclic compound, and thus, electrons may be efficiently transferred to the emission layer so that the recombination balance of electrons and holes in the emission layer may be increased. As a result, the light-emitting device has a low driving voltage and high power efficiency. Accordingly, the light-emitting device may enable the manufacture of a high-quality electronic device and a high-quality electronic apparatus.

In an embodiment, from among the color coordinates of the light emitted from the light-emitting device, CIEx may be 0.20 to 0.80, or 0.23 to 0.70.

In an embodiment, from among the color coordinates of the light emitted from the light-emitting device, CIEx may be 0.20 to 0.80, or 0.30 to 0.71.

In an embodiment, the first emitter may include at least one deuterium.

In an embodiment, the first emitter may include a deuterated C₁-C₂₀ alkyl group, a deuterated C₃-C₁₀ cycloalkyl group, or a combination thereof.

In an embodiment, the highest occupied molecular orbital (HOMO) energy level of the first emitter may be -5.50 eV to -4.70 eV or -5.20 eV to -4.84 eV.

In an embodiment, the lowest unoccupied molecular orbital (LUMO) energy level of the first emitter may be -2.70 eV to -1.60 eV or -2.55 eV to -1.66 eV.

The HOMO and LUMO energy levels may be evaluated through cyclic voltammetry analysis of the organometallic compound (for example, Evaluation Example 1).

According to another aspect, the first emitter may be an organometallic compound represented by Formula 1. The detailed description of Formula 1 is the same as described in the present specification.

For example, the organometallic compound represented by Formula 1 may satisfy the ³MLCT, conditions for first light, HOMO energy levels and/or LUMO energy levels of the first emitter described in the present specification.

The emission layer may further include, in addition to the first emitter, a host, an auxiliary dopant, a sensitizer, a delayed fluorescence material, or one or more combinations thereof. Each of the host, the auxiliary dopant, the sensitizer, the delayed fluorescence material, or one or more combinations thereof may include at least one deuterium.

For example, the emission layer may include the first emitter and the host. The host may be different from the first emitter, and the host may include an electron-transporting compound, a hole-transporting compound, a bipolar compound, or one or more combinations thereof. The host may not include (e.g., may exclude) metal. The electron-transporting compound, the hole-transporting compound, and the bipolar compound are different from each other.

In an embodiment, the emission layer includes the first emitter and a host, and the host may include an electron-transporting compound and a hole-transporting compound. The electron-transporting compound and the hole-transporting compound may form an exciplex.

For example, the electron-transporting compound may include at least one π electron-deficient nitrogen-containing C₁-C₆₀ cyclic group. For example, the electron-transporting compound may include a pyridine group, a pyrimidine group, a pyrazine group, a pyridazine group, a triazine group, or one or more combinations thereof.

In an embodiment, the hole-transporting compound may include at least one π electron-rich C₃-C₆₀ cyclic group, a pyridine group, or a combination thereof, and may not include (e.g., may exclude) an electron-transporting group (for example, a π electron-deficient nitrogen-containing C₁-C₆₀ cyclic group, a cyano group, a sulfoxide group, and a phosphine oxide group, not a pyridine group).

In an embodiment, the following compounds may be excluded from the hole-transporting compound:

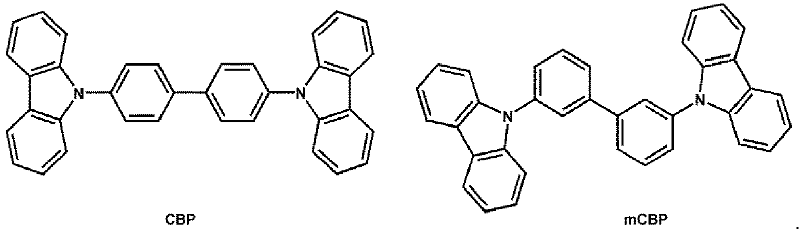

In an embodiment, the electron-transporting compound may include a compound represented by Formula 2-1 or a compound represented by Formula 2-2: 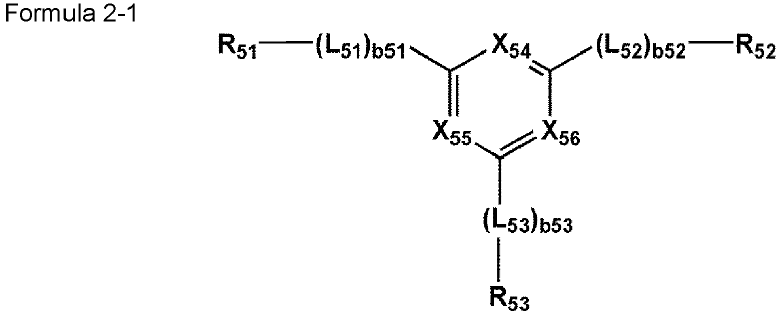 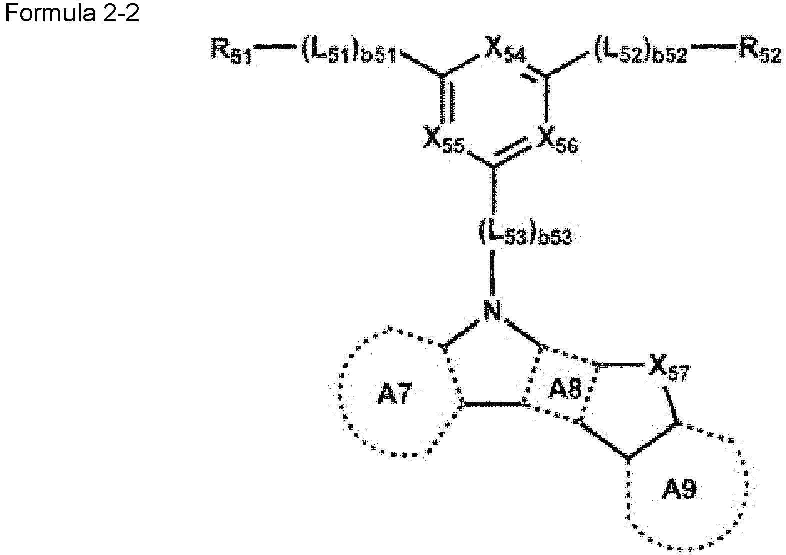 wherein, in Formulae 2-1 and 2-2,
L₅₁ to L₅₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
b51 to b53 may each independently be an integer from 1 to 5,
A₇ to A₉ may each independently be a C₃-C₆₀ carbocyclic group unsubstituted or substituted with at least one R₁₀ₐ or a C₁-C₆₀ heterocyclic group unsubstituted or substituted with at least one R₁₀ₐ (for example, a benzene group or a naphthalene group, each unsubstituted or substituted with at least one R₁₀ₐ),
X₅₄ may be N or C(R₅₄), X₅₅ may be N or C(R₅₅), X₅₆ may be N or C(R₅₆), and at least one of X₅₄ to X₅₆ may be N,
X₅₇ may be O, S, N(R₅₇), C(R₅₇ₐ)(R_{57b}), or Si(R₅₇ₐ)(R_{57b}), and
R₅₁ to R₅₇, R₅₇ₐ, R_{57b}, and R₁₀ₐ are each the same as described above.

In an embodiment, the hole-transporting compound may include a compound represented by Formula 3-1, a compound represented by Formula 3-2, a compound represented by Formula 3-3, a compound represented by Formula 3-4, a compound represented by Formula 3-5, or one or more combinations thereof: 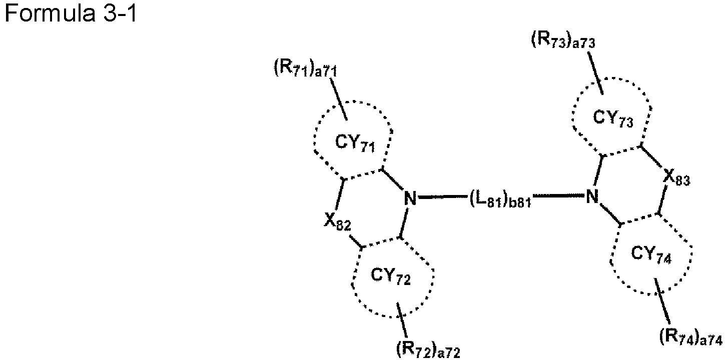 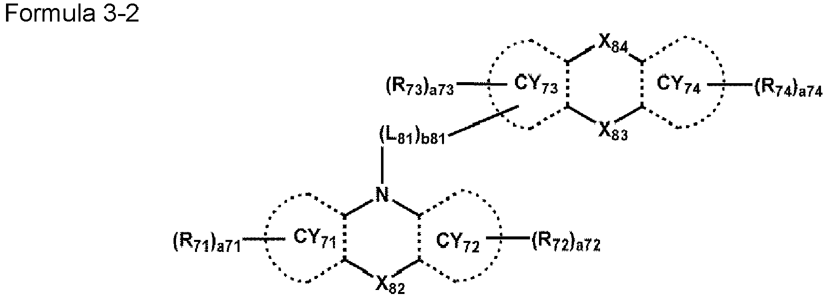 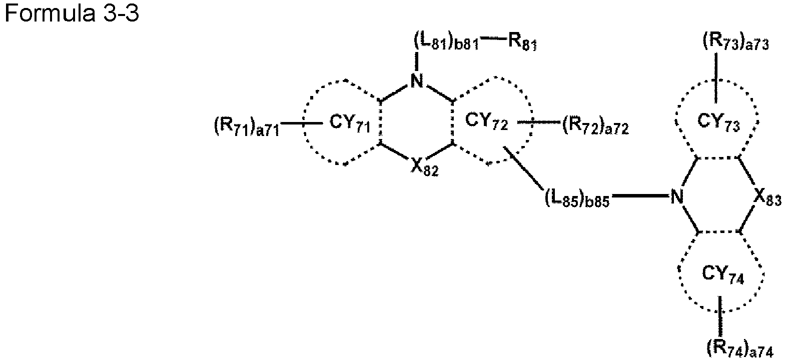 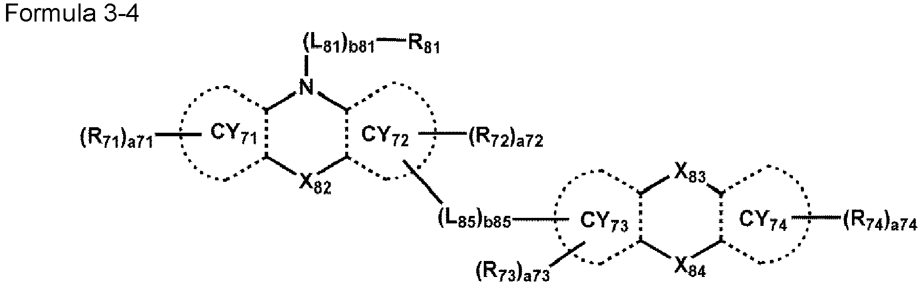 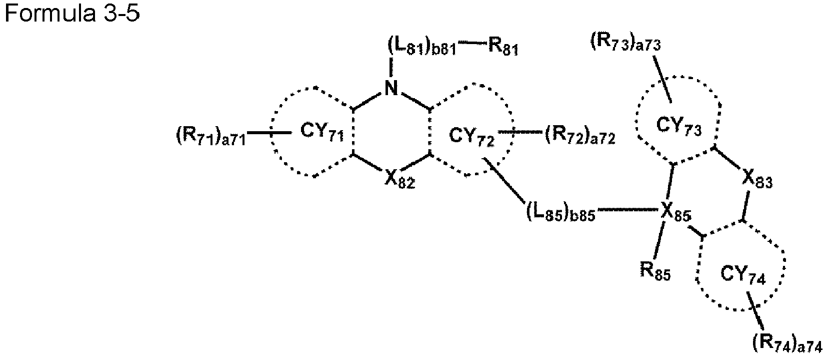 wherein, in Formulae 3-1 to 3-5,
ring CY₇₁ to ring CY₇₄ may each independently be a π electron-rich C₃-C₆₀ cyclic group (for example, a benzene group, a naphthalene group, a fluorene group, a anthracene group, a carbazole group, a dibenzofuran group, or a dibenzothiophene group), or a pyridine group,
X₈₂ may be a single bond, O, S, N-[(L₈₂)_{b82}-R₈₂], C(R₈₂ₐ)(R_{82b}), or Si(R82a)(R82b),
X₈₃ may be a single bond, O, S, N-[(L₈₃)_{b83}-R₈₃], C(R₈₃ₐ)(R_{83b}), or Si(R83a)(R83b),
X₈₄ may be O, S, N-[(L₈₄)_{b84}-R₈₄], C(R₈₄ₐ)(R_{84b}), or Si(R₈₄ₐ)(R_{84b}),
X₈₅ may be C or Si,
L₈₁ to L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ (for example, a benzene group, a naphthalene group, a fluorene group, a anthracene group, a carbazole group, a dibenzofuran group, or a dibenzothiophene group, each unsubstituted or substituted with at least one R₁₀ₐ), or a pyridine group unsubstituted or substituted with at least one R₁₀ₐ, wherein Q₄ and Q₅ may each independently be the same as described in connection with Q₁,
b81 to b85 may each independently be an integer from 1 to 5,
R₇₁ to R₇₄, R₈₁ to R₈₅, R₈₂ₐ, R_{82b}, R₈₃ₐ, R_{83b}, R₈₄ₐ, and R_{84b} are respectively the same as described in the present specification,
a71 to a74 may each independently be an integer from 0 to 20, and
R₁₀ₐ may be understood by referring to the description of R₁₀ₐ provided herein.

The description of Formulae 3-1 to 3-5 may be understood by referring to the related description to be presented later.

The electron transport region may include a hole-blocking layer, a buffer layer, an electron transport layer, an electron injection layer, or a combination thereof.

In an embodiment, the electron transport region may include an electron transport layer, and the heterocyclic compound may be included in the electron transport layer. The electron transport layer may further include a metal-containing material in addition to the heterocyclic compound. The metal-containing material may be understood by referring to the description provided herein.

In an embodiment, the electron transport layer including the heterocyclic compound may be in direct contact with the emission layer.

In an embodiment, the electron transport region may include a hole-blocking layer and an electron transport layer, the hole-blocking layer may be disposed between the emission layer and the electron transport layer, the hole-blocking layer may not include (e.g., may exclude) the heterocyclic compound, and the electron transport layer may include the heterocyclic compound.

The wording "the interlayer (or the electron transport region) includes a first emitter (or includes the heterocyclic compound)" can be interpreted as "the interlayer (or the electron transport region) may include one type or kind of compound belonging to the category of the first emitter or two or more different compounds belonging to the category of the first emitter (or one type or kind of compound belonging to the category of the heterocyclic compound or two or more different compounds belonging to the category of the heterocyclic compound).

The term "interlayer" as utilized herein refers to a single layer and/or all of a plurality of layers located between the first electrode and the second electrode of the light-emitting device.

Another aspect provides an electronic device including the light-emitting device. The electronic device may further include a thin-film transistor. For example, the electronic device may further include a thin-film transistor including a source electrode and a drain electrode, wherein the first electrode of the light-emitting device may be electrically connected to the source electrode or the drain electrode. In an embodiment, the electronic device may further include a color filter, a color conversion layer, a touch screen layer, a polarizing layer, or one or more combinations thereof. For more details on the electronic device, related descriptions provided herein may be referred to.

Another aspect provides an electronic apparatus including the light-emitting device. By utilizing the light-emitting device having an emission layer including the first emitter and an electron transport region including the heterocyclic compound as described in the present specification, the display quality, power consumption, or durability of the electronic apparatus may be improved.

For example, the consumer product may be one of a flat panel display, a curved display, a computer monitor, a medical monitor, a TV, a billboard, indoor or outdoor illuminations and/or signal light, a head-up display, a fully or partially transparent display, a flexible display, a rollable display, a foldable display, a stretchable display, a laser printer, a phone, a cell phone, a tablet, a phablet, a personal digital assistant (PDA), a wearable device, laptop computers, digital cameras, camcorders, viewfinders, micro displays, 3D displays, virtual or augmented reality displays, vehicles, a video wall including multiple displays tiled together, a theater or stadium screen, a phototherapy device, and a signage.

### Description of Formula

For example, the first emitter may be an organometallic compound represented by Formula 1: 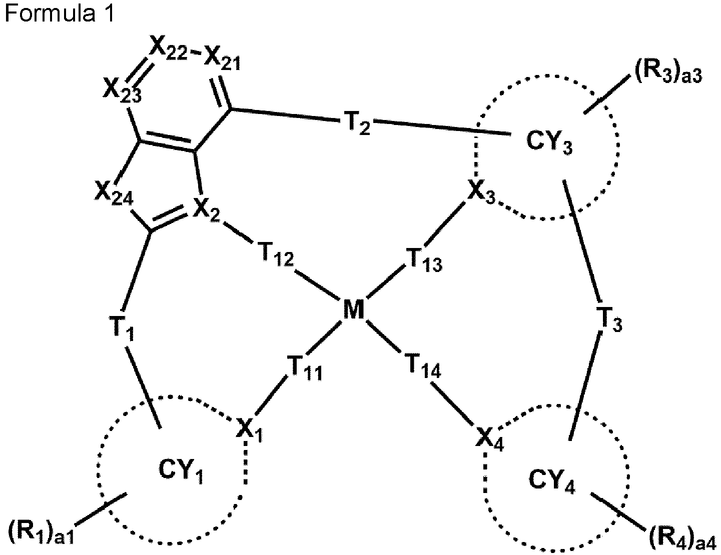 wherein, in Formula 1,
M may be Pt,
X₁ to X₄ may each independently be N or C,
T₁₁ to T₁₄ may each independently be a chemical bond, O, S, B(R'), N(R'), P(R'), C(R')(R"), Si(R')(R"), Ge(R')(R"), C(=O), B(R')(R"), N(R')(R"), or P(R')(R"),
when T₁₁ is a chemical bond, X₁ and M may be directly bonded to each other, when T₁₂ is a chemical bond, X₂ and M may be directly bonded to each other, when T₁₃ is a chemical bond, X₃ and M may be directly bonded to each other, when T₁₄ is a chemical bond, X₄ and M may be directly bonded to each other,
two of the bonds selected from a bond between X₁ or T₁₁ and M, a bond between X₂ or T₁₂ and M, a bond between X₃ or T₁₃ and M, and a bond between X₄ or T₁₄ and M may be coordinate bonds, and the other two bonds may be covalent bonds,
T₁ may be a single bond, a double bond, *-N(R₅)-*', *-B(R₅)-*', *-P(R₅)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*", *-C(=O)-*', *-S(=O)-*', *-S(=O)₂-*', *-C(R₅)=*', *=C(R₅)-*', *-C(R₅ₐ)=C(R_{5b})-*', *-C(=S)-*', or *-C≡C-*'
T₂ may be a single bond, a double bond, *-N(R₆)-*', *-B(R₆)-*', *-P(R₆)-*', *-C(R₆ₐ)(R_{6b})-*', *-Si(R₆ₐ)(R_{6b})-*', *-Ge(R₆ₐ)(R_{6b})-*', *-S-*', *-Se-*', *-O-*', *-C(=O)-*', *-S(=O)-*', *-S(=O)₂-*', *-C(R₆)=*', *=C(R₆)-*', *-C(R₆ₐ)=C(R_{6b})-*', *-C(=S)-*', or *-C≡C-*'
T₃ may be a single bond, a double bond, *-N(R₇)-*', *-B(R₇)-*', *-P(R₇)-*', *-C(R₇ₐ)(R_{7b})-*', *-Si(R₇ₐ)(R_{7b})-*', *-Ge(R₇ₐ)(R_{7b})-*', *-S-*', *-Se-*', *-O-*', *-C(=O)-*', *-S(=O)-*', *-S(=O)₂-*', *-C(R₇)=*', *=C(R₇)-*', *-C(R₇a)=C(R_{7b})-*', *-C(=S)-*', or *-C≡C-*'
ring CY₁, ring CY₃, and ring CY₄ may each independently be a C₃-C₆₀ carbocyclic group or a C₁-C₆₀ heterocyclic group,
X₂₁ may be N or C(R₂₁), X₂₂ may be N or C(R₂₂), and X₂₃ may be N or C(R₂₃),
X₂₄ may be O, S, N(R₂₄) or C(R₂₄ₐ)(R_{24b}),
R₁, R₂₁ to R₂₄, R₂₄ₐ, R_{24b}, R₃ to R₇, R₅ₐ, R_{5b}, R₆ₐ, R_{6b}, R₇ₐ, R_{7b}, R', and R" may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with R₁₀ₐ, a C₂-C₆₀ alkynyl group unsubstituted or substituted with R₁₀ₐ, a C₁-C₆₀ alkoxy group unsubstituted or substituted with R₁₀ₐ, a C₃-C₆₀ carbocyclic group unsubstituted or substituted with R₁₀ₐ, a C₁-C₆₀ heterocyclic group unsubstituted or substituted with R₁₀ₐ, a C₆-C₆₀ aryloxy unsubstituted or substituted with R₁₀ₐ, a C₆-C₆₀ arylthio group unsubstituted or substituted with R₁₀ₐ, a C₇-C₆₀ arylalkyl group unsubstituted or substituted with R₁₀ₐ, a C₂-C₆₀ heteroarylalkyl group unsubstituted or substituted with R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁),-S(=O)₂(Q₁), or -P(=O)(Q₁)(Q₂),
a1, a3, and a4 may each independently be an integer from 0 to 20,
* and *' each indicate a binding site to an adjacent atom, and
i) two groups of a1 R₁, ii) two groups of R₂₁ to R₂₃, iii) two groups of a3 R₃, iv) two groups of a4 R₄, v) R₅ₐ and R_{5b}, vi) R₆ₐ and R_{6b}, and vii) R₇ₐ and R_{7b} may each optionally be linked to each other via a single bond, a double bond, or a first linking group to form a C₃-C₆₀ carbocyclic group unsubstituted or substituted with at least one R₁₀ₐ or a C₁-C₆₀ heterocyclic group unsubstituted or substituted with at least one R₁₀ₐ, and
R₁₀ₐ may be:
   deuterium, -F, -Cl, -Br, -I, a hydroxyl group, a cyano group, or a nitro group;
   a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(O₁₁)(O₁₂)(O₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or one or more combinations thereof;
   a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂),-B(Q₂₁)(Q₂₂), -C(=O)(Q₂₁), -S(=O)₂(Q₂₁), -P(=O)(Q₂₁)(Q₂₂), or one or more combinations thereof; or
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
   wherein Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or one or more combinations thereof.

In one or more embodiments, in Formula 1,
i) X₁ and X₃ may be C, and X₂ and X₄ may be N,
ii) X₁ and X₄ may be C, and X₂ and X₃ may be N, or
iii) X₁, X₂, and X₃ may be C, and X₄ may be N.

In one or more embodiments, in Formula 1,
T₁₁ may be O or S, and
T₁₂ to T₁₄ may each be a chemical bond.

In one or more embodiments, regarding Formula 1,
T₁₁ may be O or S,
T₁₂ to T₁₄ may each be a chemical bond, and
i) a bond between T₁₁ and M and a bond between X₃ and M may each be a covalent bond, and a bond between X₂ and M and a bond between X₄ and M may each be a coordinate bond, or ii) a bond between T₁₁ and M and a bond between X₄ and M may each be a covalent bond, and a bond between X₂ and M and a bond between X₃ and M may each be a coordinate bond.

In an embodiment, each of T₁ to T₃ in Formula 1 may be a single bond.

In an embodiment, a ring CY₁ in Formula 1 may be a benzene group, a naphthalene group, a dibenzofuran group, a dibenzothiophene group, a carbazole group, a fluorene group, or a dibenzosilole group.

In an embodiment, in Formula 1, X₂₁ may be C(R₂₁), X₂₂ may be C(R₂₂), and X₂₃ may be C(R₂₃).

In an embodiment, X₂₄ in Formula 1 may be N(R₂₄).

In an embodiment, a ring CY₃ in Formula 1 may be a benzene group, a naphthalene group, a dibenzofuran group, a dibenzothiophene group, a carbazole group, a fluorene group, a dibenzosilole group, a pyridine group, a pyrimidine group, a pyrazine group, a pyridazine group, a quinoline group, an isoquinoline group, a quinoxaline group, an azadibenzofuran group, an azadibenzothiophene group, an azacarbazole group, an azafluorene group, or an azadibenzosilole group.

In an embodiment, a ring CY₄ in Formula 1 may be a benzene group, a naphthalene group, a dibenzofuran group, a dibenzothiophene group, a carbazole group, a fluorene group, a dibenzosilole group, a pyridine group, a pyrimidine group, a pyrazine group, a pyridazine group, a quinoline group, an isoquinoline group, a quinoxaline group, an azadibenzofuran group, an azadibenzothiophene group, an azacarbazole group, an azafluorene group, an azadibenzosilole group, an imidazole group, a benzimidazole group, or a naphthoimidazole group.

In an embodiment, ring CY₄ in Formula 1 may not be an imidazole group and a benzimidazole group.

In an embodiment, R₁, R₂₁ to R₂₄, R₂₄ₐ, R_{24b}, R₃ to R₇, R₅ₐ, R_{5b}, R₆ₐ, R_{6b}, R₇ₐ, R_{7b}, R', and R" in Formula 1 may each independently be:
hydrogen, deuterium, -F, or a cyano group;
a C₁-C₂₀ alkyl group or a C₃-C₁₀ cycloalkyl group, each unsubstituted or substituted with deuterium, -F, cyano group, or one or more combinations thereof; or
a phenyl group, a biphenyl group, a naphthyl group, a dibenzofuranyl group, or a dibenzothiophenyl group (or a thienyl group), each unsubstituted or substituted with deuterium, -F, cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₉alkyl)biphenyl group, or one or more combinations thereof.
a1, a3, and a4 in Formula 1 indicate the number of R₁, the number of R₃, and the number of R₄, respectively, and may each independently be, for example, 0, 1, 2, 3, 4, 5, or 6.

In an embodiment, X₂₄ may be N(R₂₄), and R₂₄ may be a C₁-C₆₀ alkyl group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ.

In an embodiment, at least one of R₁, R₃, and R₄ may be a C₃-C₆₀ carbocyclic group unsubstituted or substituted with R₁₀ₐ, or a C₁-C₆₀ heterocyclic group unsubstituted or substituted with R₁₀ₐ.

In one or more embodiments, a group represented by 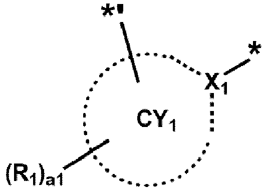 in Formula 1 may be a group represented by one of CY1(1) to CY1(16): 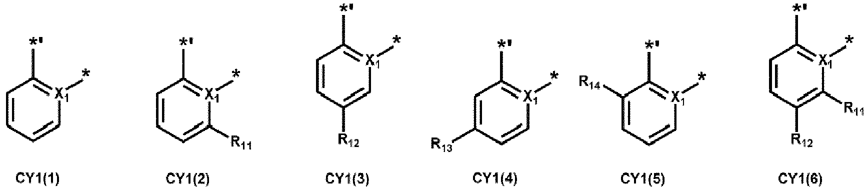 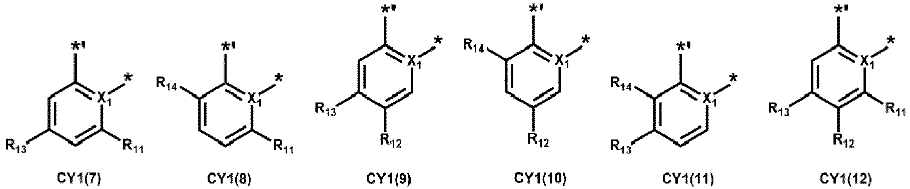 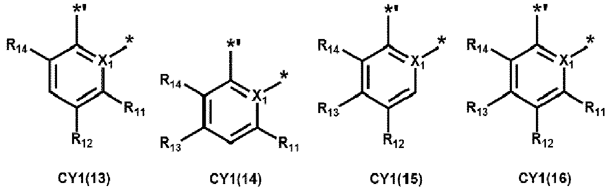 wherein, in Formulae CY1(1) to CY1(16),
X₁ is the same as described above,
R₁₁ to R₁₄ are each the same as described in connection with R₁ in the present specification, wherein R₁₁ to R₁₄ are each not hydrogen,
* indicates a binding site to T₁₁ in Formula 1, and
*' indicates a binding site to T₁ in Formula 1.

In one or more embodiments, a group represented by 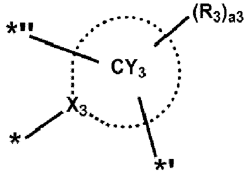 in Formula 1 may be a group represented by one of CY3(1) to CY3(12): 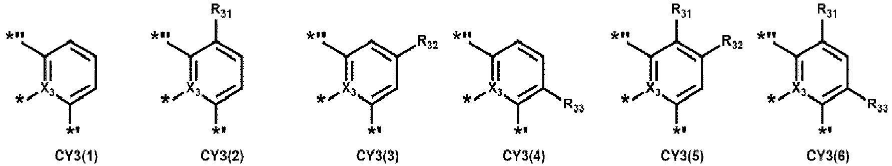 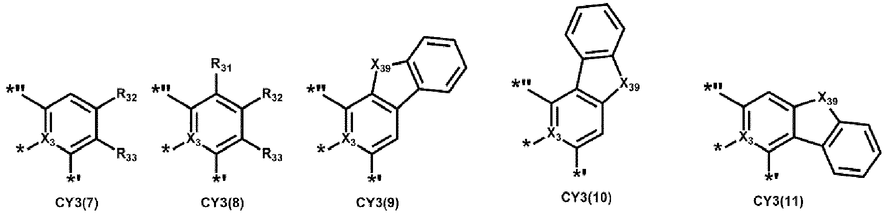 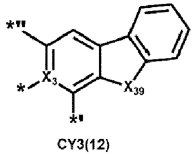 wherein, in Formulae CY3(1) to CY3(12),
X₃ is the same as described in the present specification,
X₃₉ may be O, S, N(R₃₉), C(R₃₉ₐ)(R_{39b}), or Si(R₃₉ₐ)(R_{39b}),
R₃₁ to R₃₃, R₃₉, R₃₉ₐ, and R_{39b} are each the same as described in connection with R₃ in the present specification, wherein R₃₁ to R₃₃ are each not hydrogen,
* indicates a binding site to T₁₃ in Formula 1,
*' indicates a binding site to T₃ in Formula 1, and
*" indicates a binding site to T₂ in Formula 1.

In one or more embodiments, a group represented by 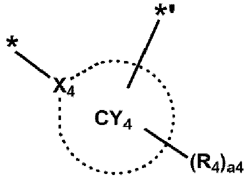 in Formula 1 may be a group represented by one of CY4(1) to CY4(27): 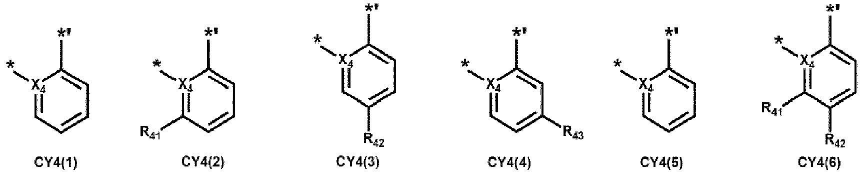 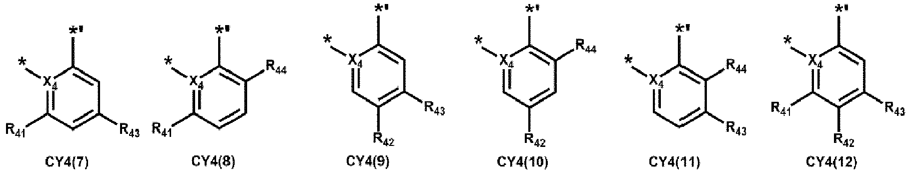 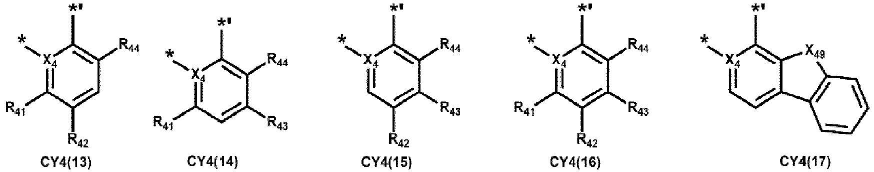 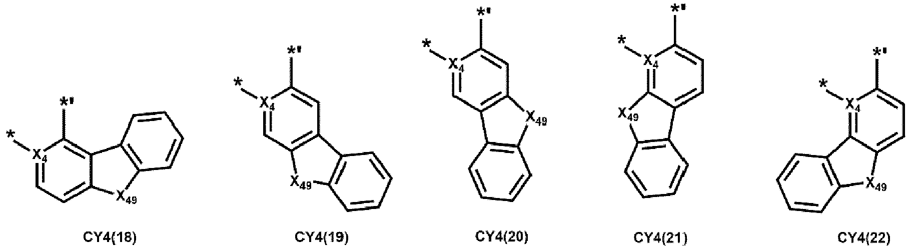 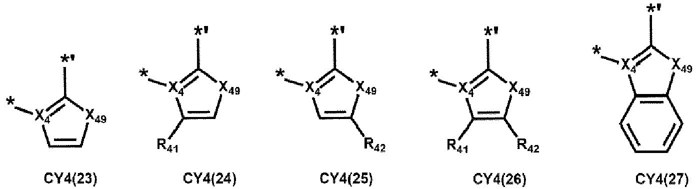 wherein, in Formulae CY4(1) to CY4(27),
X₄ is the same as described in the present specification,
X₄₉ may be O, S, N(R₄₉), C(R₄₉ₐ)(R_{49b}), or Si(R₄₉ₐ)(R_{49b}),
R₄₁ to R₄₄, R₄₉, R₄₉ₐ, and R_{49b} are each the same as described in connection with R₄, and R₄₁ to R₄₄ are each not hydrogen,
* indicates a binding site to T₁₄ in Formula 1, and
*' indicates a binding site to T₃ in Formula 1.

In an embodiment, a group represented by 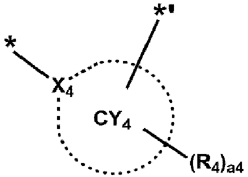 in Formula 1 may be a group represented by one of Formulae CY4(1) to CY4(23).

In an embodiment, at least one of R₁, R₂₁ to R₂₄, R₂₄ₐ, R_{24b}, R₃ to R₇, R₅ₐ, R_{5b}, R₆ₐ, R_{6b}, R₇ₐ, R_{7b}, R', and R" may include at least one deuterium.

In an embodiment, at least one of R₁, R₂₁ to R₂₄, R₂₄ₐ, R_{24b}, R₃ to R₇, R₅ₐ, R_{5b}, R₆ₐ, R_{6b}, R₇ₐ, R_{7b}, R', and R" may be a deuterated C₁-C₂₀ alkyl group or a deuterated C₃-C₁₀ cycloalkyl group.

In some embodiments, the heterocyclic compound may be a compound represented by Formula 8: 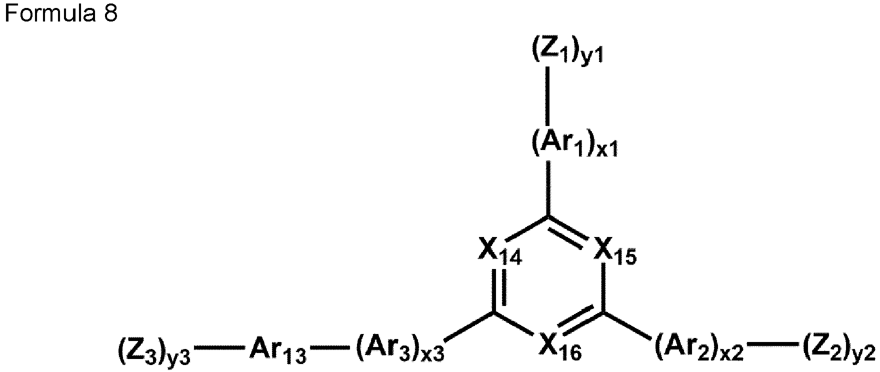 wherein, in Formula 8,
X₁₄ may be N or C(Z₄), X₁₅ may be N or C(Z₅), and X₁₆ may be N or C(Z₆),
two or more of X₁₄ to X₁₆ may each be N,
Ar₁ to Ar₃ may each independently be a C₃-C₆₀ carbocyclic group unsubstituted or substituted with R₁₀ₐ, or a C₁-C₆₀ heterocyclic group unsubstituted or substituted with R₁₀ₐ,
x1 to x3 may each independently be an integer from 0 to 10,
i) when x1 is 0, *-(Ar1)ₓ₁-*' may be a single bond, ii) when x2 is 0, *-(Ar₂)ₓ₂-*' may be a single bond, and iii) when x3 is 0, *-(Ar₃)ₓ₃-*' may be a single bond,
Ar₁₃ may be a group represented by one of Formulae 8-1 to 8-4,
Z₁ to Z₆ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃),-Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
y1 to y3 may each independently be one of the integers from 0 to 5, and
R₁₀ₐ may be the same as described in connection with R₁₀ₐ in Formula 1: 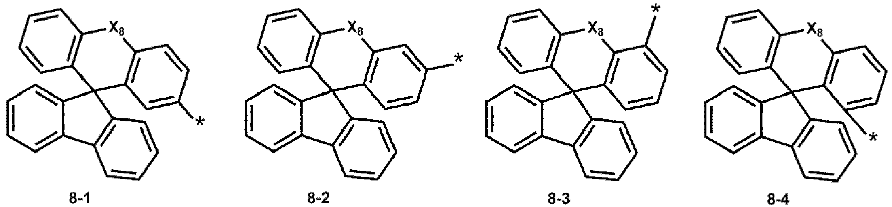 wherein, in Formulae 8-1 to 8-4,
   X₈ may be O, S, or Se, and
   * indicates a binding site with Ar₃ in Formula 8.

In an embodiment, Ar₁ to Ar₃ in Formula 8 may each independently be a benzene group, a naphthalene group, a phenanthrene group, an anthracene group, a dibenzofuran group, a dibenzothiophene group, a carbazole group, a fluorene group, or a pyridine group, each unsubstituted or substituted with R₁₀ₐ.

x1 to x3 in Formula 8 represent the number of Ar₁ to the number of Ar₃, respectively. When x1 is 2 or greater, two or more of Ar₁ may be identical to or different from each other, when x2 is 2 or greater, two or more of Ar₂ may be identical to or different from each other, and when x3 is 2 or greater, two or more of Ar₃ may be identical to or different from each other. For example, in Formula 8, x1 and x2 may each independently be an integer from 1 to 10, and x3 may be 0, 1 or 2.

In an embodiment, at least one of x1 and x2 in Formula 8 may be 2 or more (for example, 2, 3, 4, or 5).

In an embodiment, in Formula 8, x1 and x2 may each independently be an integer from 1 to 10, x3 may be 0, 1, or 2, Ar₁ to Ar₃ may each independently be a benzene group, a naphthalene group, a phenanthrene group, an anthracene group, a dibenzofuran group, a dibenzothiophene group, a carbazole group, a fluorene group, or a pyridine group, each unsubstituted or substituted with R₁₀ₐ.

In an embodiment, in Formula 8, one or more of Ar₁ in number of x1, one or more of Ar₂ in number of x2, or a combination thereof may each independently be a dibenzofuran group, a dibenzothiophene group, a carbazole group, a fluorene group, or a pyridine group, each unsubstituted or substituted with R₁₀ₐ.

In an embodiment, in Formula 8, one or more of Ar₁ in number of x1, one or more of Ar₂ in number of x2, or a combination thereof may each independently be a dibenzofuran group, a dibenzothiophene group, or a carbazole group, each unsubstituted or substituted with R₁₀ₐ.

Ar₁₃ in Formula 8 is a group represented by any one of Formulae 8-1 to 8-4, and Z₃ that is not hydrogen, may be substituted at any position of Ar₁₃.

In an embodiment, Z₁ to Z₆ in Formula 8 may each independently be:
hydrogen, deuterium, -F, or a cyano group;
a C₁-C₂₀ alkyl group or a C₃-C₁₀ cycloalkyl group, each unsubstituted or substituted with deuterium, -F, a cyano group, or one or more combinations thereof; or
a phenyl group, a biphenyl group, a naphthyl group, a dibenzofuranyl group, or a dibenzothiophenyl group (or a thienyl group), each unsubstituted or substituted with deuterium, -F, cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or one or more combinations thereof; or
-Si(Q₁)(Q₂)(Q₃).

In this regard, Q₁ to Q₃ are each the same as described above.

In an embodiment, at least one of Z₁ to Z₆ may include at least one deuterium.

In an embodiment, at least one of Z₁ to Z₆ may be a deuterated C₁-C₂₀ alkyl group, or a deuterated C₃-C₁₀ cycloalkyl group.

y1 to y3 in Formula 8 indicate the number of Z₁ to the number of Z₃, respectively, and may be, for example, one of integers from 0 to 5. For example, y1 to y3 may each independently 0, 1, or 2.

The term "biphenyl group" as utilized herein refers to a monovalent substituent having a structure in which two benzene groups are connected to each other through a single bond.

Examples of the C₃-C₁₀ cycloalkyl group as utilized herein are a cyclopentyl group, a cyclohexyl group, a cycloheptyl group, an adamantanyl group, a norbornanyl group, and/or the like.

The term "deuterated" utilized herein includes (refers to) both (e.g., simultaneously) fully deuterated and partially deuterated.

The term "fluorinated" utilized herein includes (refers to) both (e.g., simultaneously) fully fluorinated and partially fluorinated.

b51 to b53 in Formulae 2-1 and 2-2 indicate numbers of L₅₁ to L₅₃, respectively, and may each be an integer from 1 to 5. When b51 is 2 or more, two or more of L₅₁(s) may be identical to or different from each other, when b52 is 2 or more, two or more of L₅₂(s) may be identical to or different from each other, and when b53 is 2 or more, two or more of L₅₃(s) may be identical to or different from each other. In an embodiment, b51 to b53 may each independently be 1 or 2.

L₅₁ to L₅₃ in Formulae 2-1 and 2-2 may each independently be:
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a oxazole group, a isoxazole group, a thiazole group, an isothiazole group, an oxadiazole group, a thiadiazole group, a benzopyrazole group, a benzimidazole group, a benzoxazole group, a benzothiazole group, a benzooxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxine group, a dibenzooxathiine group, a dibenzooxazine group, a dibenzopyran group, a dibenzodithiine group, a dibenzothiazine group, a dibenzothiopyran group, a dibenzocyclohexadiene group, a dibenzodihydropyridine group, a dibenzodihydropyrazine group, an indolocarbazole group, an indolodibenzofuran group, or an indolodibenzothiophene group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁),-Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁),-S(=O)₂(Q₃₁), -P(=O)(Q₃₁)(Q₃₂), or one or more combinations thereof,
wherein Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In Formulae 2-1 and 2-2, X₅₄ may be N or C(R₅₄), X₅₅ may be N or C(R₅₅), X₅₆ may be N or C(R₅₆), and at least one of X₅₄ to X₅₆ may be N. R₅₄ to R₅₆ may each independently be the same as described above. In an embodiment, two or three of X₅₄ to X₅₆ may be N.

R₅₁ to R₅₇, R₅₇ₐ, R_{57b}, R₇₁ to R₇₄, R₈₁ to R₈₅, R₈₂ₐ, R_{82b}, R₈₃ₐ, R_{83b}, R₈₄ₐ, and R_{84b} may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ aryl alkyl group unsubstituted or substituted with at least one R₁₀ₐ, a C₂-C₆₀ heteroaryl alkyl group unsubstituted or substituted with at least one R₁₀ₐ, -C(Q₁)(Q₂)(Q₃),-Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂). Q₁ to Q₃ may each independently be the same as described in the present specification.

For example, i) R₁, R₂₁ to R₂₄, R₂₄ₐ, R_{24b}, R₃ to R₇, R₅ₐ, R_{5b}, R₆ₐ, R_{6b}, R₇ₐ, R_{7b}, R', and R" in Formula 1, ii) R₅₁ to R₅₇, R₅₇ₐ, R_{57b}, R₇₁ to R₇₄, R₈₁ to R₈₅, R₈₂ₐ, R_{82b}, R₈₃ₐ, R_{83b}, R₈₄ₐ, and R_{84b} Formulae 2-1, 2-2 and 3-1 to 3-5, and iii) R₁₀ₐ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or one or more combinations thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃),-N(Q₃₁)(Q₃₂), -B(Q₃₁)(Q₃₂), -P(Q₃₁)(Q₃₂), -C(=O)(Q₃₁), -S(=O)₂(Q₃₁), -P(=O)(Q₃₁)(Q₃₂), or one or more combinations thereof; or
-C(Q₁)(Q₂)(Q₃), -Si(Q₁)(Q₂)(Q₃), -N(Q₁)(Q₂), -B(Q₁)(Q₂), -C(=O)(Q₁),-S(=O)₂(Q₁), or -P(=O)(Q₁)(Q₂),
wherein Q₁ to Q₃ and Q₃₁ to Q₃₃ may each independently be:
   -CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H, or -CD₂CDH₂; or
   an n-propyl group, an iso-propyl group, an n-butyl group, an isobutyl group, a sec-butyl group, a tert-butyl group, an n-pentyl group, an isopentyl group, a secpentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or one or more combinations thereof: 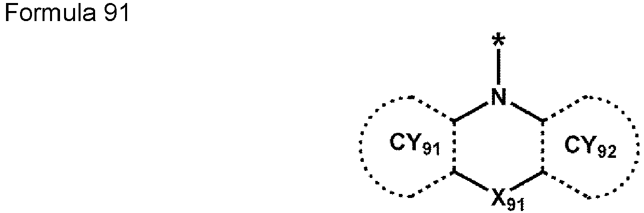 wherein, in Formula 91,
      ring CY₉₁ and ring CY₉₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ,
      X₉₁ may be a single bond, O, S, N(R₉₁), B(R₉₁), C(R₉₁ₐ)(R_{91b}), or Si(R91a)(R91b),
      R₉₁, R₉₁ₐ, and R_{91b} may respectively be understood by referring to the descriptions of R₈₂, R₈₂ₐ, and R_{82b} provided herein,
      R₁₀ₐ may be understood by referring to the description of R₁₀ₐ provided herein, and
      * indicates a binding site to an adjacent atom.

For example, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ,
R₉₁, R₉₁ₐ, and R_{91b} may each independently be selected from:
hydrogen or a C₁-C₁₀ alkyl group; or
a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or one or more combinations thereof.

In an embodiment, i) R₁, R₂₁ to R₂₄, R₂₄ₐ, R_{24b}, R₃ to R₇, R₅ₐ, R_{5b}, R₆ₐ, R_{6b}, R₇ₐ, R_{7b}, R', and R" in Formula 1, ii) R₅₁ to R₅₇, R₅₇ₐ, R_{57b}, R₇₁ to R₇₄, R₈₁ to R₈₅, R₈₂ₐ, R_{82b}, R₈₃ₐ, R_{83b}, R₈₄ₐ and R_{84b} in Formulae 2-1, 2-2, and 3-1 to 3-5, and iii) R₁₀ₐ may each independently be hydrogen, deuterium, -F, a cyano group, a nitro group,-CH₃, -CD₃, -CD₂H, -CDH₂, -CF₃, -CF₂H, -CFH₂, a group represented by one of Formulae 9-1 to 9-19, a group represented by one of Formulae 10-1 to 10-246,-C(Q₁)(Q₂)(Q₃), -Si(Q₁)(Q₂)(Q₃), or -P(=O)(Q₁)(Q₂)(wherein Q₁ to Q₃ may each independently be the same described herein)(provided that R₁₀ₐ is not hydrogen): 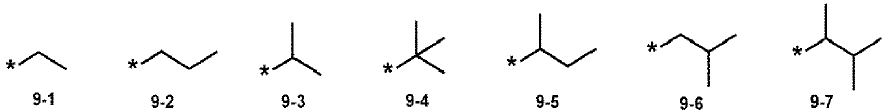 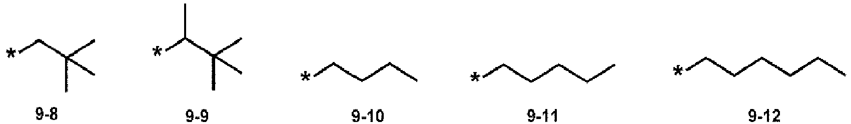 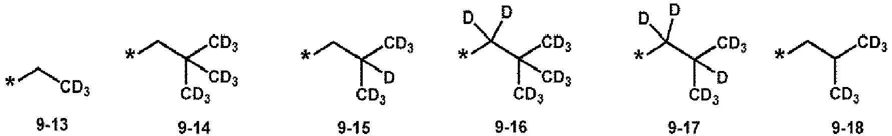 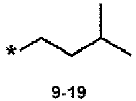 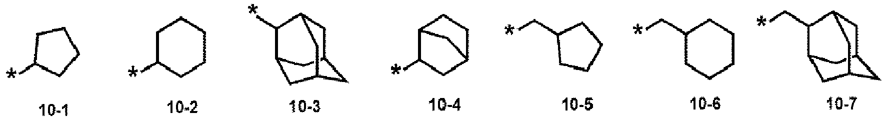 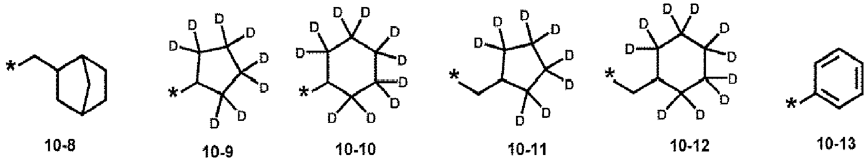 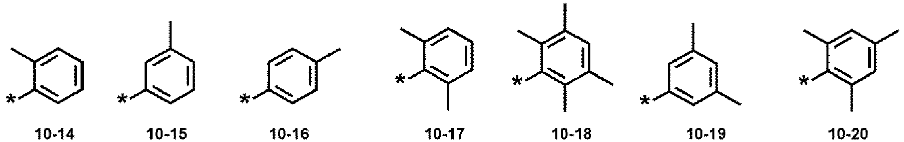 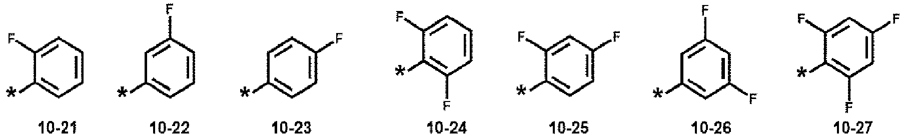 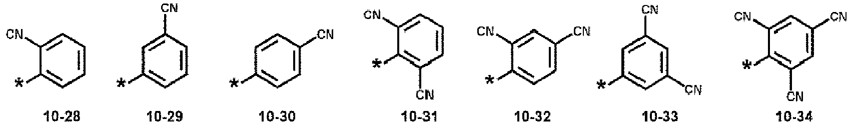 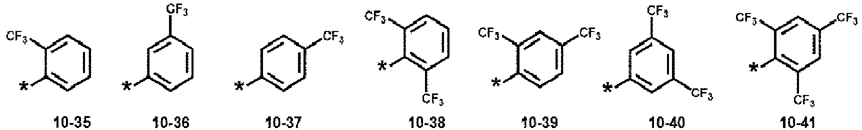 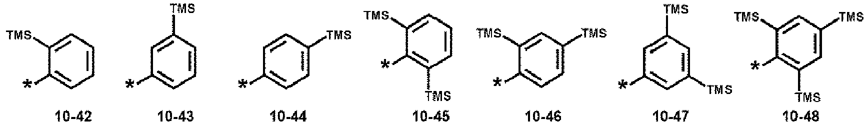 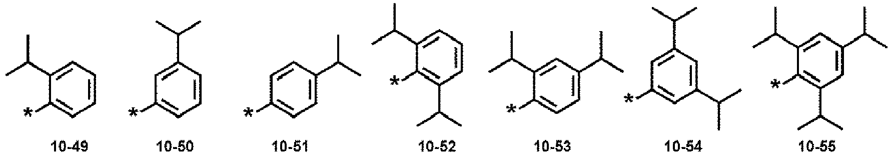 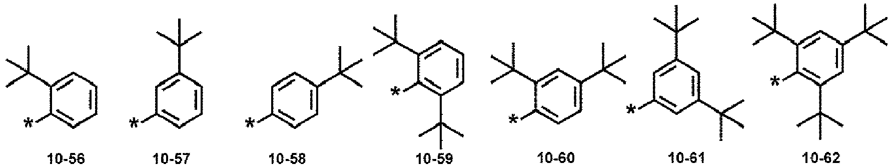 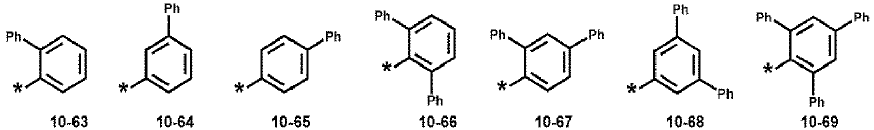 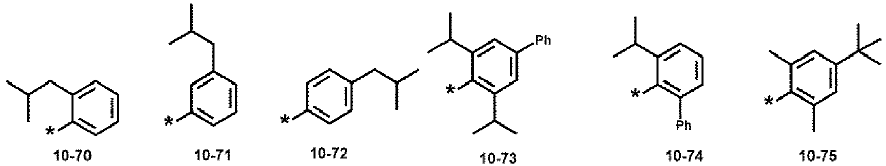 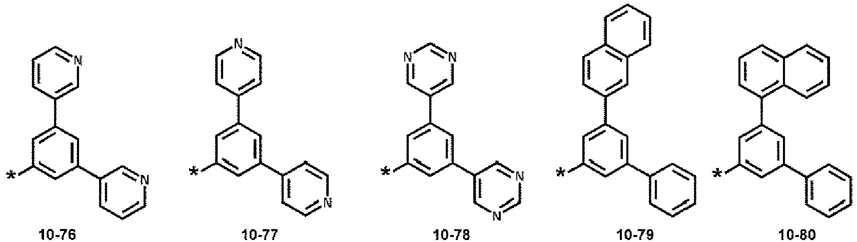 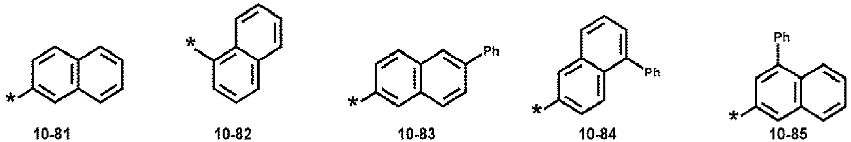 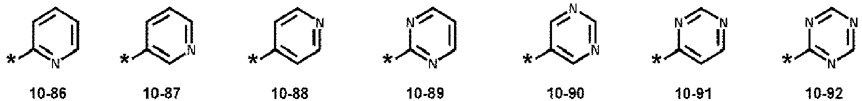 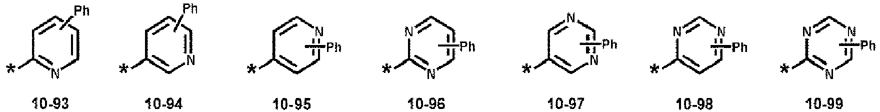 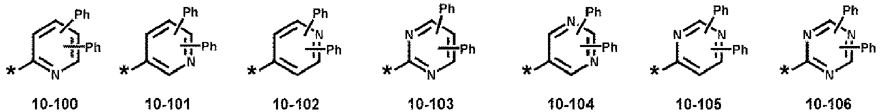 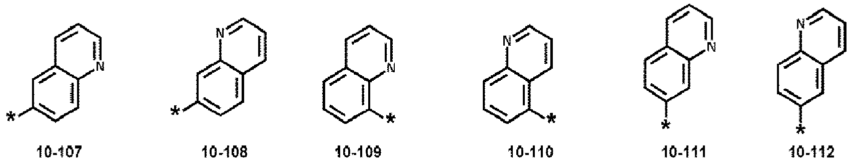 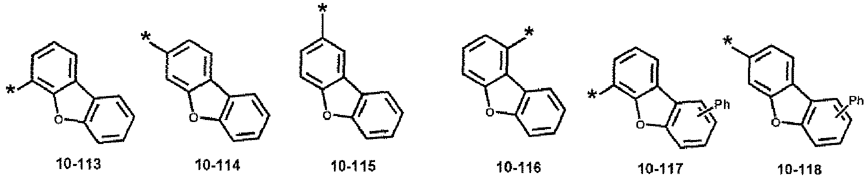 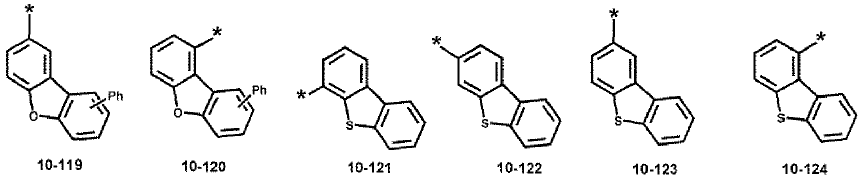 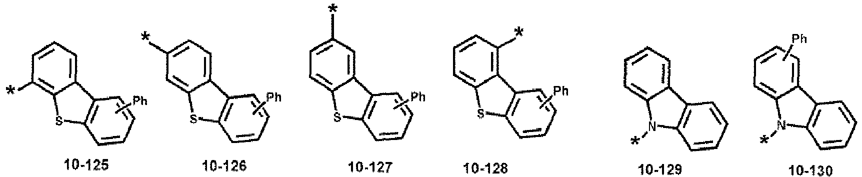 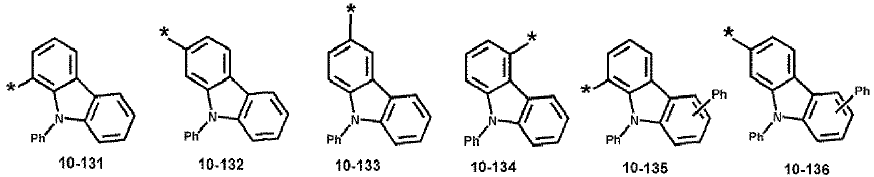 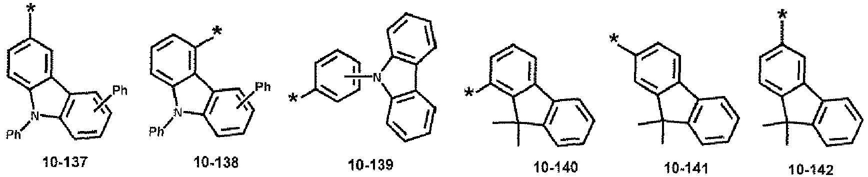 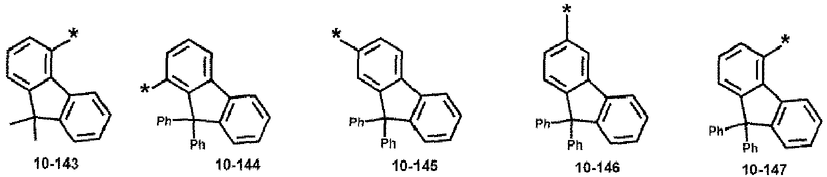 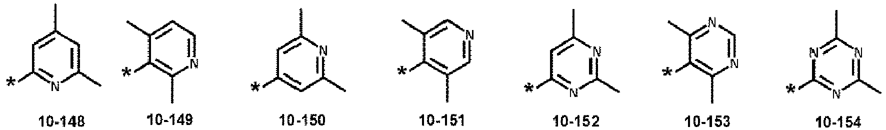 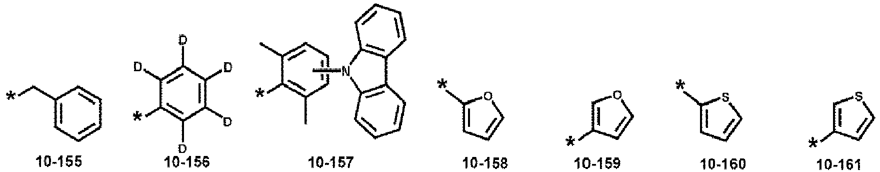 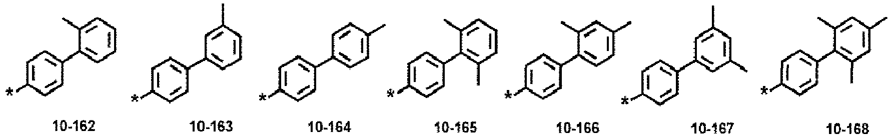 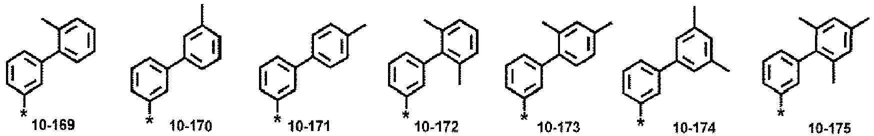 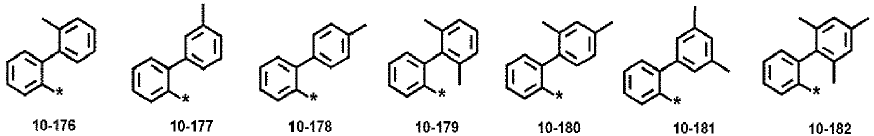 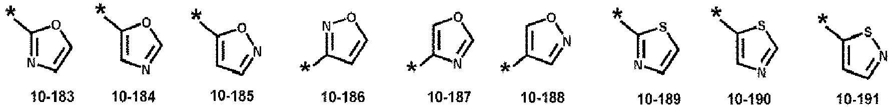 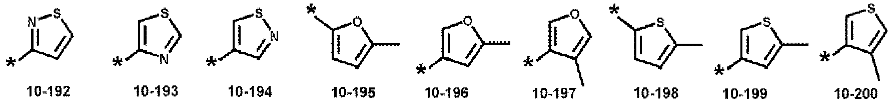 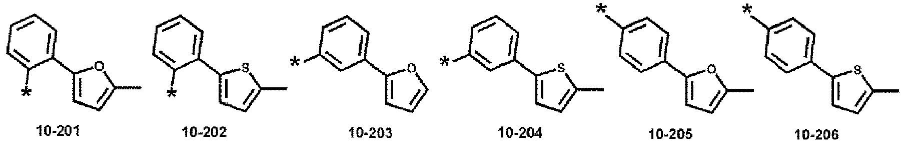 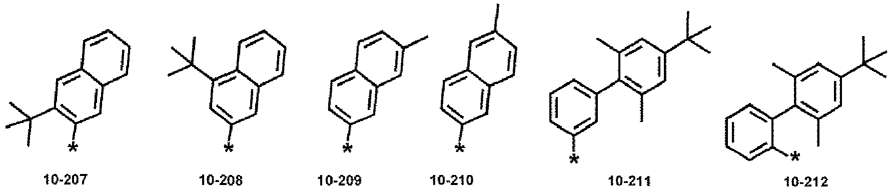 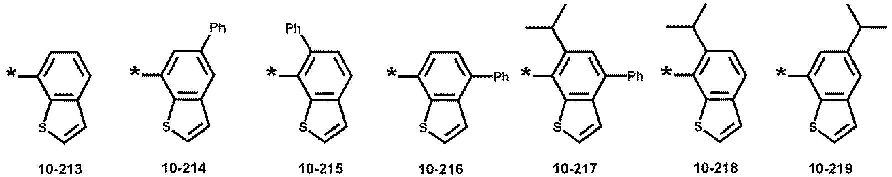 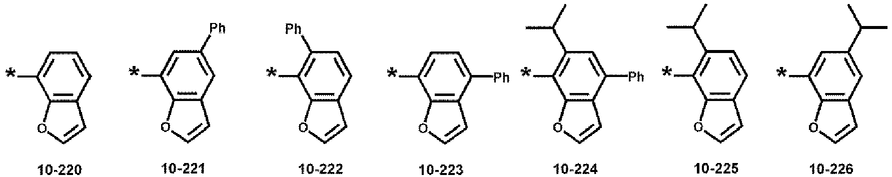 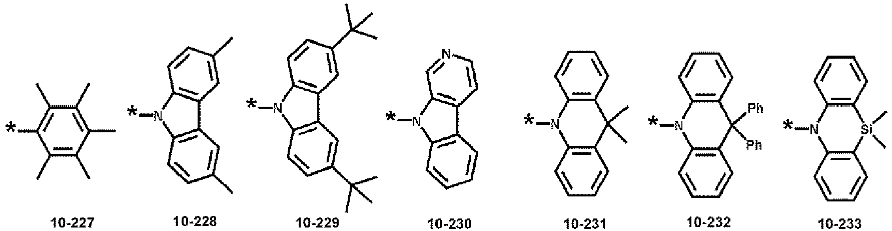 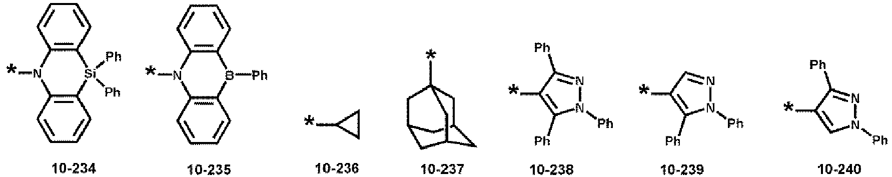 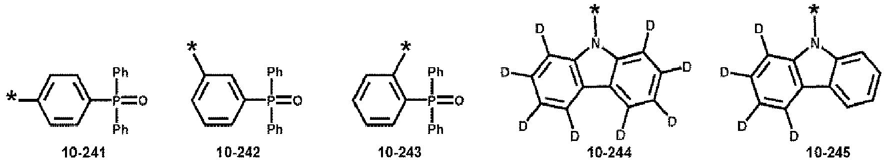 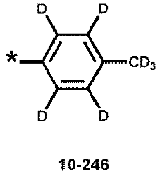 wherein, in Formulae 9-1 to 9-19 and 10-1 to 10-246, * indicates a binding site to an adjacent atom, "Ph" represents a phenyl group, and "TMS" represents a trimethylsilyl group.

a71 to a74 in Formulae 3-1 to 3-5 respectively indicate numbers of R₇₁ to R₇₄, and may each independently be an integer from 0 to 20. When a71 is 2 or more, two or more of R₇₁(s) may be identical to or different from each other, when a72 is 2 or more, two or more of R₇₂(s) may be identical to or different from each other, when a73 is 2 or more, two or more of R₇₃(s) may be identical to or different from each other, and when a74 is 2 or more, two or more of R₇₄(s) may be identical to or different from each other. a71 to a74 may each independently be an integer from 0 to 8.

Regarding Formula 1, i) two groups of a1 R₁, ii) two groups of R₂₁ to R₂₃, iii) two groups of a3 R₃, iv) two groups of a4 R₄, v) R₅ₐ and R_{5b}, vi) R₆ₐ and R_{6b}, and vii) R₇ₐ and R_{7b} may each optionally be linked to each other via a single bond, a double bond, or a first linking group to form a C₃-C₆₀ carbocyclic group unsubstituted or substituted with at least one R₁₀ₐ or a C₁-C₆₀ heterocyclic group unsubstituted or substituted with at least one R₁₀ₐ.

In Formulae 3-1 to 3-5, L₈₁ to L₈₅ may each independently be:
a single bond;
*-C(Q₄)(Q₅)-*' or *-Si(Q₄)(Q₅)-*'; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), -Si(Q₃₁)(Q₃₂)(Q₃₃), -N(Q₃₁)(Q₃₂),-B(Q₃₁)(Q₃₂), -P(Q₃₁)(Q₃₂), -C(=O)(Q₃₁), -S(=O)₂(Q₃₁), -P(=O)(Q₃₁)(Q₃₂), or one or more combinations thereof,
wherein Q₄, Q₅, and Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In some embodiments, in Formulae 3-1 and 3-2, a group represented by 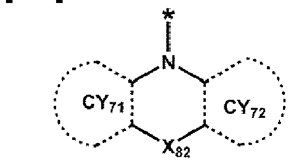 may be represented by one of Formulae CY71-1(1) to CY71-1(8), and/or
in Formulae 3-1 and 3-3, a group represented by 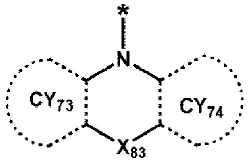 may be represented by one of Formulae CY71-2(1) to CY71-2(8), and/or
in Formulae 3-2 and 3-4, a group represented by 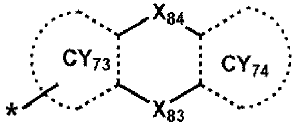 may be represented by one of Formulae CY71-3(1) to CY71-3(32),
in Formulae 3-3 to 3-5, a group represented by 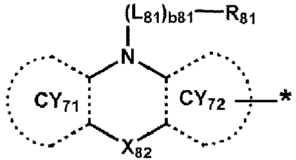 may be represented by one of Formulae CY71-4(1) to CY71-4(32), and/or
in Formula 3-5, a group represented by 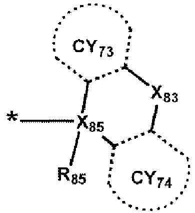 may be represented by one of Formulae CY71-5(1) to CY71-5(8): 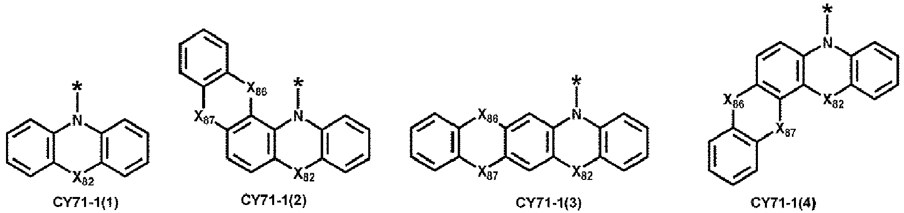 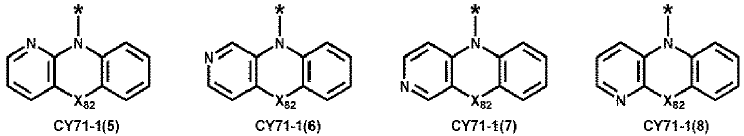 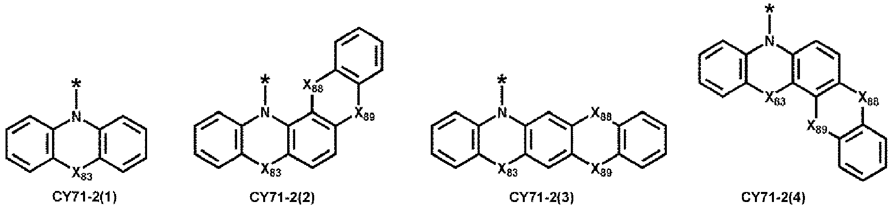 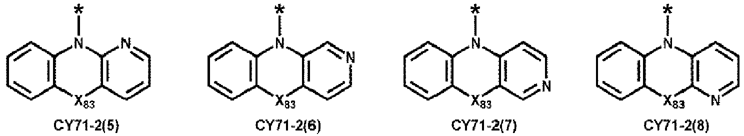 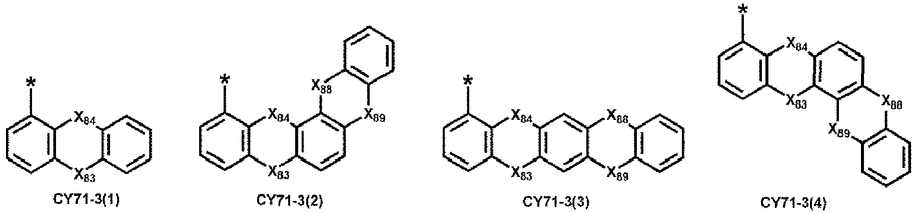 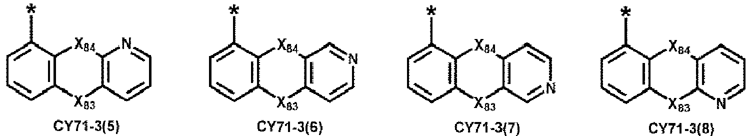 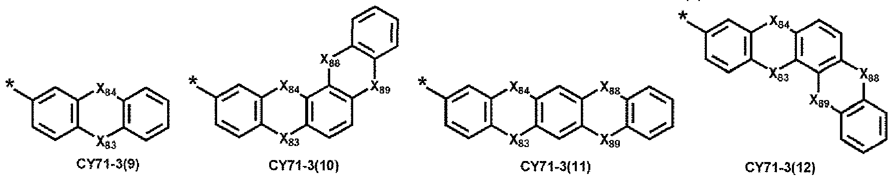 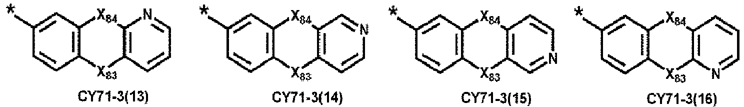 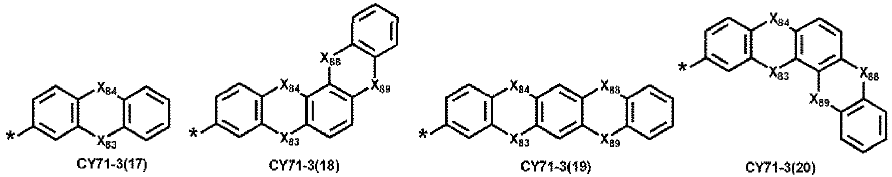 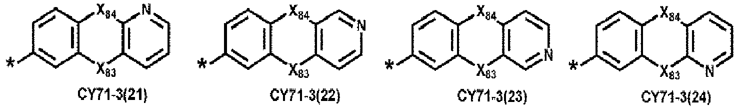 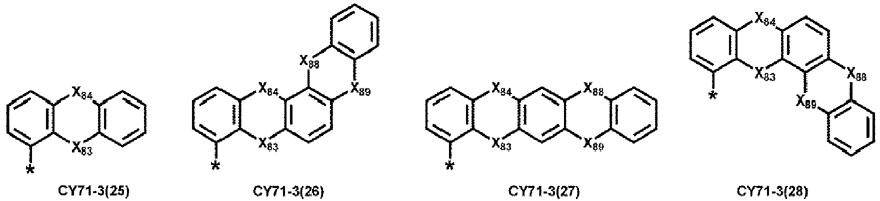 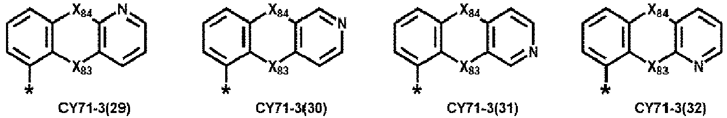 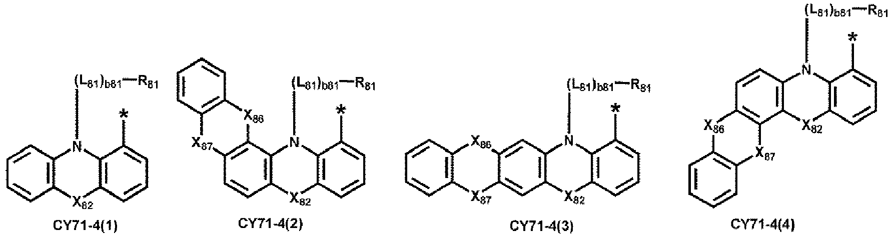 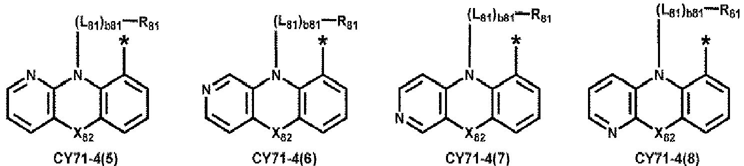 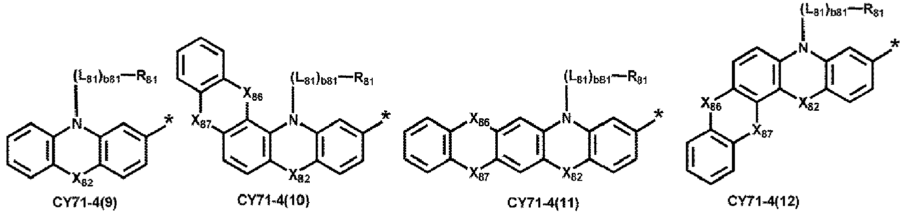 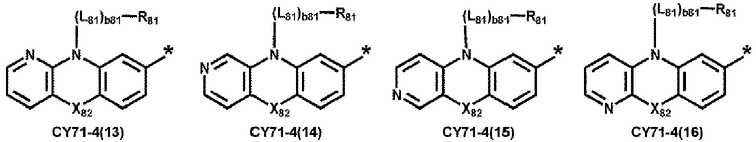 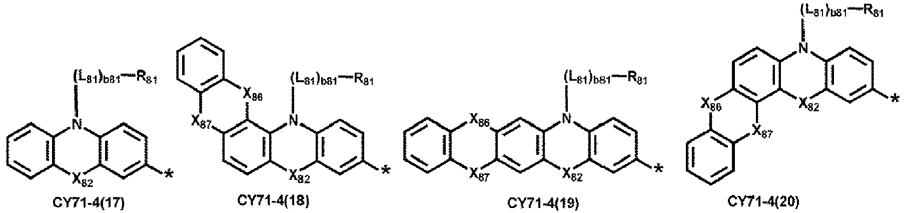 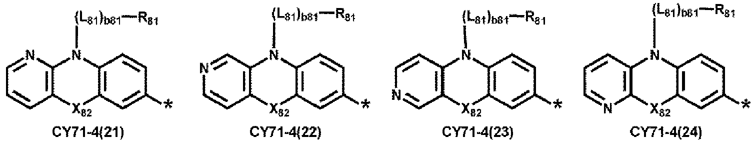 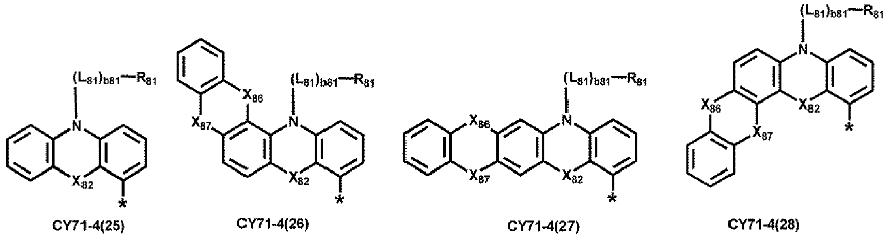 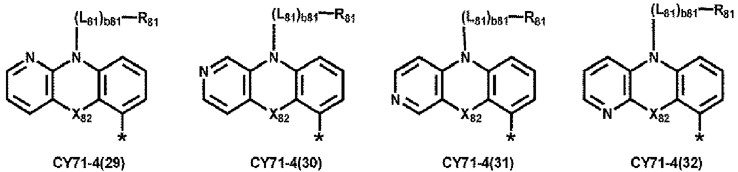 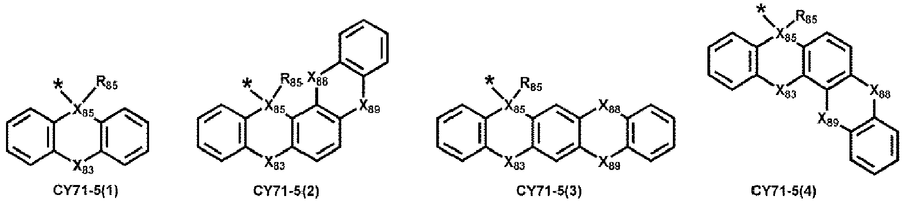 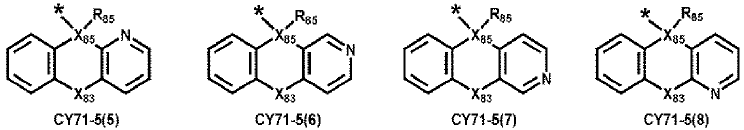
wherein, in Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
X₈₁ to X₈₅, L₈₁, b81, R₈₁, and R₈₅ may respectively be understood by referring to the descriptions of X₈₁ to X₈₅, L₈₁, b81, R₈₁, and R₈₅ provided herein,
X₈₆ may be a single bond, O, S, N(R₈₆), B(R₈₆), C(R₈₆ₐ)(R_{86b}), or Si(R₈₆ₐ)(R_{86b}),
X₈₇ may be a single bond, O, S, N(R₈₇), B(R₈₇), C(R₈₇ₐ)(R_{87b}), or Si(R87a)(R87b),
in Formulae CY71-1(1) to CY71-1(8) and CY71-4(1) to CY71-4(32), X₈₆ and X₈₇ may not be a single bond at the same time,
X₈₈ may be a single bond, O, S, N(R₈₈), B(R₈₈), C(R₈₈ₐ)(R_{88b}), or Si(R₈₈ₐ)(R_{88b}),
X₈₉ may be a single bond, O, S, N(R₈₉), B(R₈₉), C(R₈₉ₐ)(R_{89b}), or Si(R₈₉ₐ)(R_{89b}),
regarding Formulae CY71-2(1) to CY71-2(8), CY71-3(1) to CY71-3(32), and CY71-5(1) to CY71-5(8), X₈₈ and X₈₉ may not be a single bond at the same time, and
R₈₆ to R₈₉, R₈₆ₐ, R_{86b}, R₈₇ₐ, R_{87b}, R₈₈ₐ, R_{88b}, R₈₉ₐ, and R_{89b} may each be understood by referring to the description of R₈₁ provided herein.

### Examples of Compounds

In an embodiment, the first emitter or the organometallic compound represented by Formula 1 may be one of the following compounds PD01 to PD08:

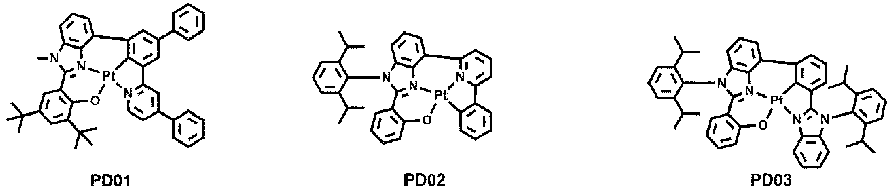

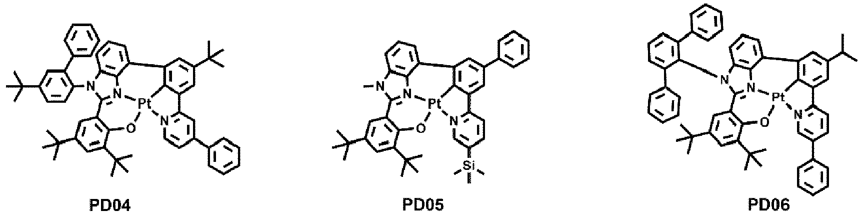

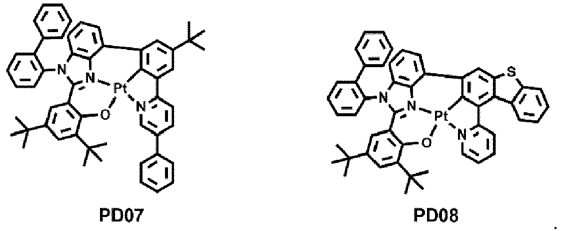

According to another embodiment, the heterocyclic compound may be one of the following compounds ET-1 to ET-6:

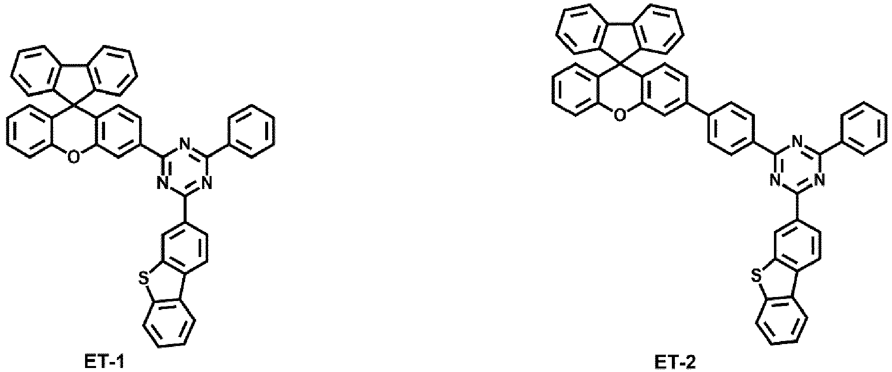

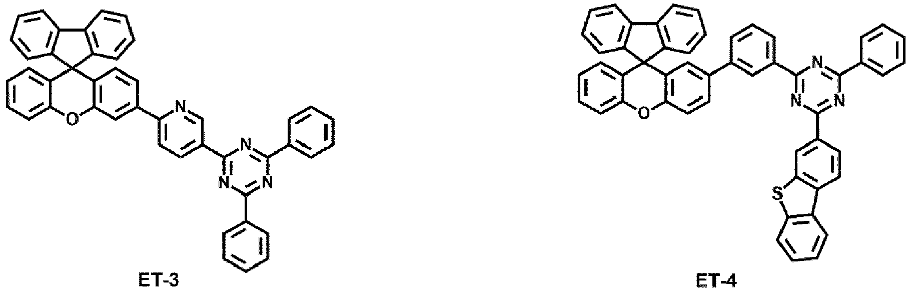

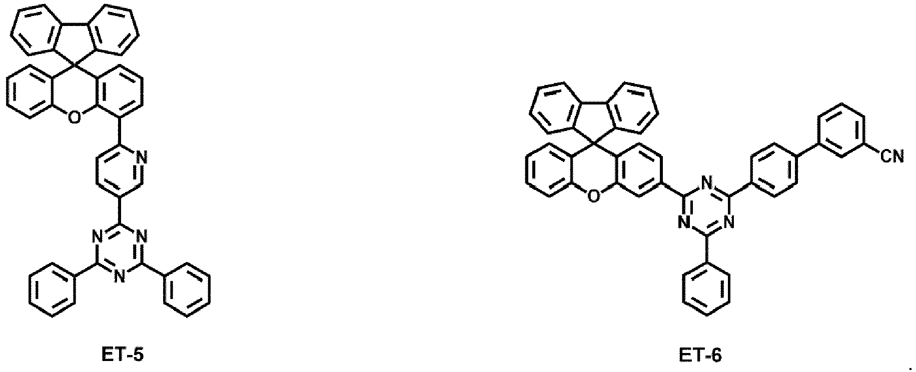

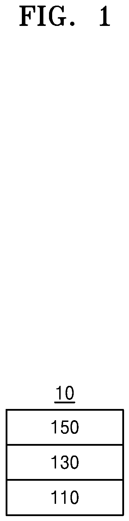

### Description of FIG. 1

FIG. 1 is a schematic cross-sectional view of a light-emitting device 10 according to an embodiment. The light-emitting device 10 includes a first electrode 110, an interlayer 130, and a second electrode 150.

Hereinafter, the structure of the light-emitting device 10 according to an embodiment and a method of manufacturing the light-emitting device 10 will be described with reference to FIG. 1.

### First electrode 110

In FIG. 1, a substrate may be additionally located under the first electrode 110 or on the second electrode 150. As the substrate, a glass substrate or a plastic substrate may be utilized. In one or more embodiments, the substrate may be a flexible substrate, and may include plastics with excellent or suitable heat resistance and durability, such as polyimide, polyethylene terephthalate (PET), polycarbonate, polyethylene napthalate, polyarylate (PAR), polyetherimide, or one or more combinations thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. When the first electrode 110 is a transmissive electrode, a material for forming the first electrode 110 may include indium tin oxide (ITO), indium zinc oxide (IZO), tin oxide (SnO₂), zinc oxide (ZnO), or one or more combinations thereof. In one or more embodiments, when the first electrode 110 is a semi-transmissive electrode or a reflective electrode, a material for forming the first electrode 110 may include magnesium (Mg), silver (Ag), aluminum (Al), aluminumlithium (Al-Li), calcium (Ca), magnesium-indium (Mg-In), magnesium-silver (Mg-Ag), or one or more combinations thereof.

The first electrode 110 may have a single-layered structure consisting of a single layer or a multi-layered structure including a plurality of layers. For example, the first electrode 110 may have a three-layered structure of ITO/Ag/ITO.

### Interlayer 130

The interlayer 130 may be located on the first electrode 110. The interlayer 130 may include an emission layer.

The interlayer 130 may further include a hole transport region located between the first electrode 110 and the emission layer, and an electron transport region located between the emission layer and the second electrode 150.

The interlayer 130 may further include, in addition to one or more suitable organic materials, a metal-containing compound such as an organometallic compound, an inorganic material such as quantum dots, and/or the like.

In an embodiment, the interlayer 130 may include i) two or more emitting units sequentially stacked between the first electrode 110 and the second electrode 150, and ii) a charge generation layer located between two neighboring emitting units. When the interlayer 130 includes emitting units and a charge generation layer as described above, the light-emitting device 10 may be a tandem light-emitting device.

### Hole transport region in interlayer 130

The hole transport region may have: i) a single-layered structure consisting of a single layer consisting of a single material, ii) a single-layered structure consisting of a single layer consisting of a plurality of different materials, or iii) a multi-layered structure including a plurality of layers including different materials.

The hole transport region may include a hole injection layer, a hole transport layer, an emission auxiliary layer, an electron-blocking layer, or one or more combinations thereof.

For example, the hole transport region may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, the layers of each structure being stacked sequentially from the first electrode 110.

The hole transport region may include a compound represented by Formula 201, a compound represented by Formula 202, or one or more combinations thereof: 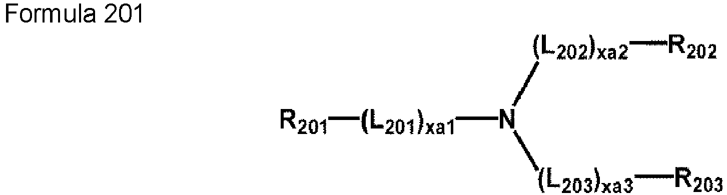 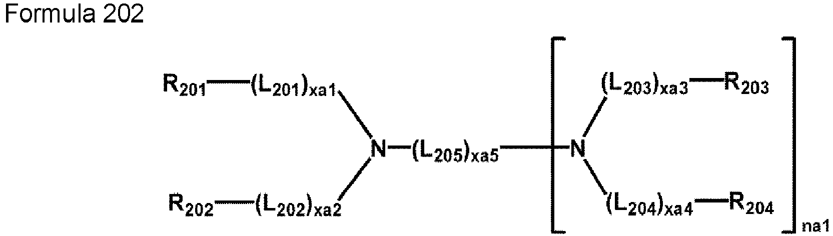 wherein, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ, or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ to form a C₈-C₆₀ polycyclic group (for example, a carbazole group and/or the like) unsubstituted or substituted with at least one R₁₀ₐ (for example, see Compound HT16),
R₂₀₃ and R₂₀₄ may optionally be linked to each other, via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

For example, each of Formulae 201 and 202 may include at least one of groups represented by Formulae CY201 to CY217.

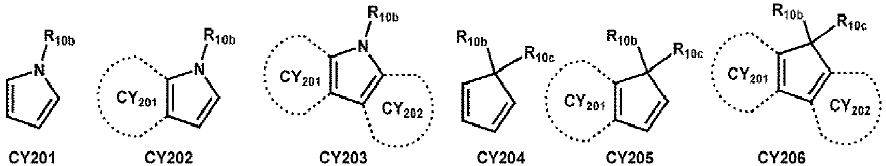

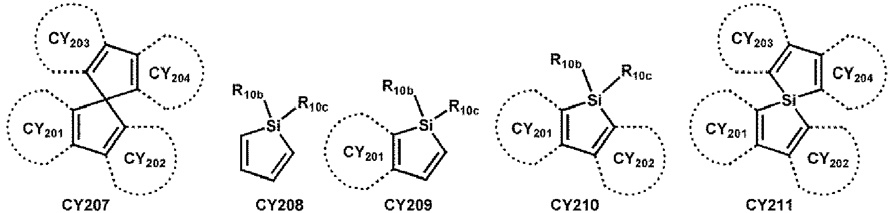

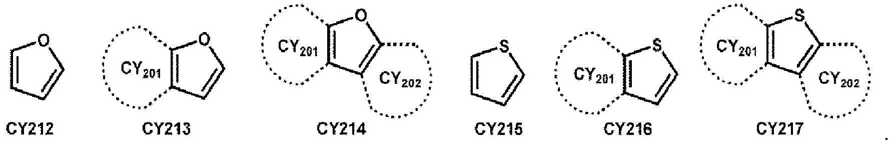

R_{10b} and R_{10c} in Formulae CY201 to CY217 may each independently be the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one of groups represented by Formulae CY201 to CY203.

In one or more embodiments, Formula 201 may include at least one of the groups represented by Formulae CY201 to CY203 and at least one of the groups represented by Formulae CY204 to CY217.

In one or more embodiments, in Formula 201, xa1 may be 1, R₂₀₁ may be a group represented by one of Formulae CY201 to CY203, xa2 may be 0, and R₂₀₂ may be a group represented by one of Formulae CY204 to CY207.

In one or more embodiments, each of Formulae 201 and 202 may not include (e.g., may exclude) a group represented by one of Formulae CY201 to CY203.

In one or more embodiments, each of Formulae 201 and 202 may not include (e.g., may exclude) a group represented by one of Formulae CY201 to CY203, and may include at least one of the groups represented by Formulae CY204 to CY217.

In one or more embodiments, each of Formulae 201 and 202 may not include (e.g., may exclude) a group represented by one of Formulae CY201 to CY217.

In an embodiment, the hole transport region may include at least one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or one or more combinations thereof:

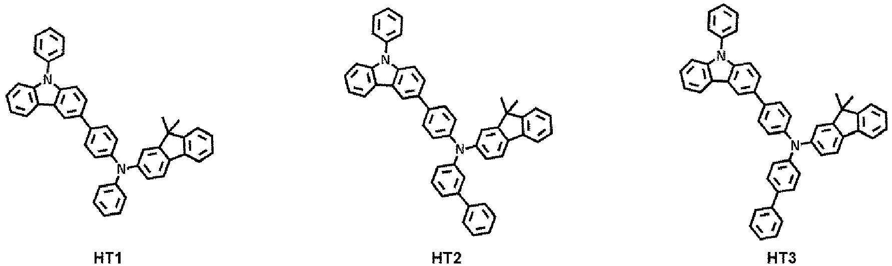

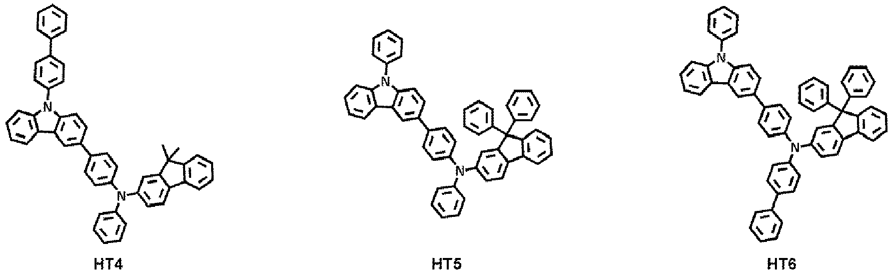

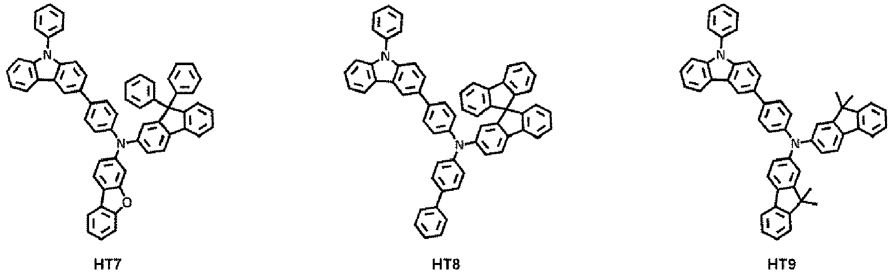

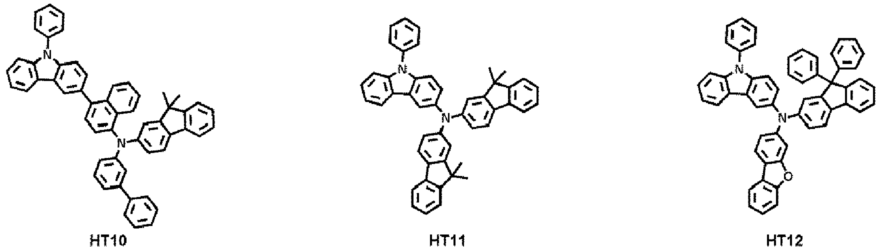

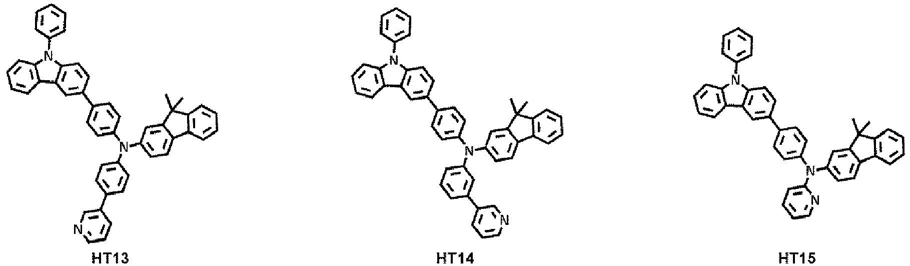

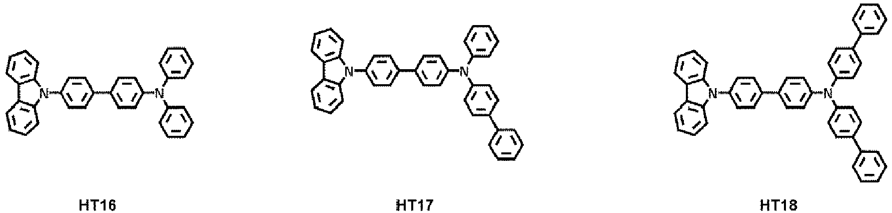

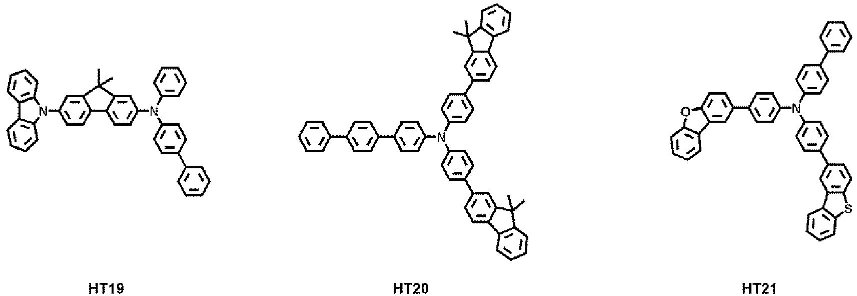

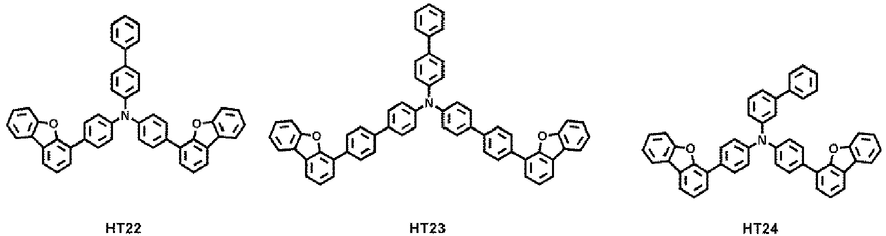

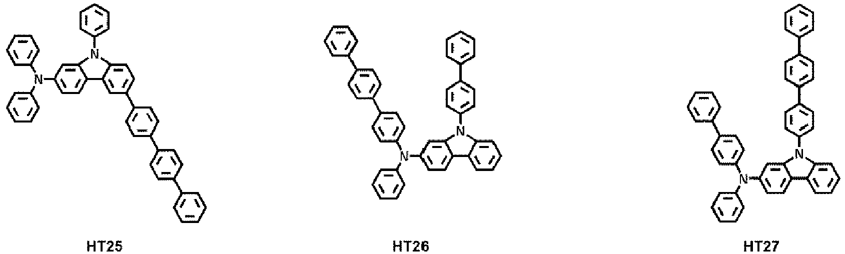

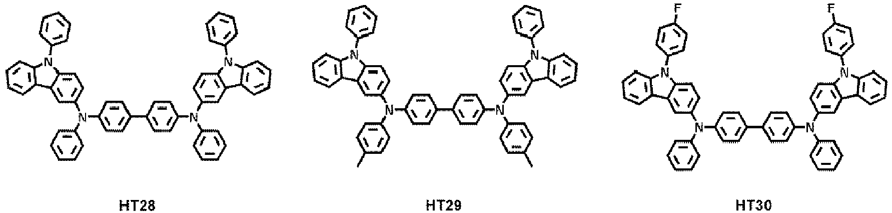

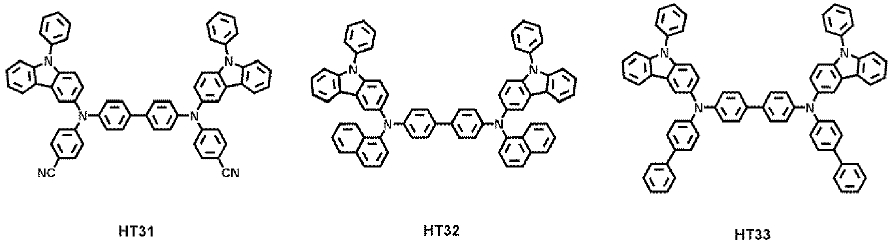

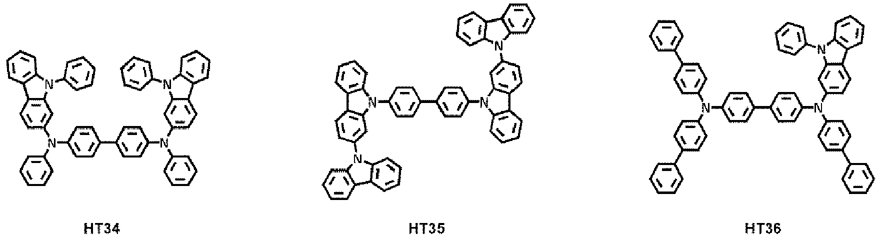

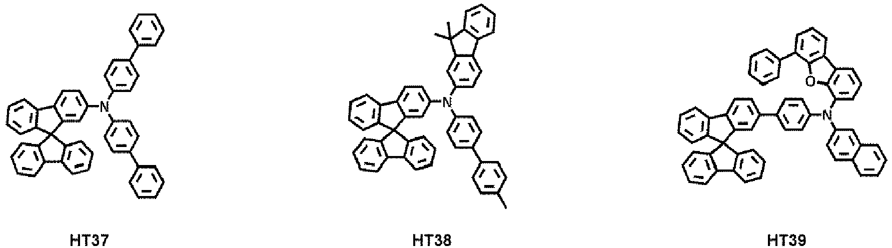

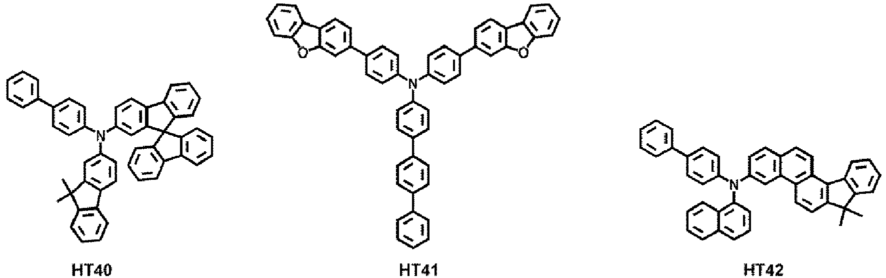

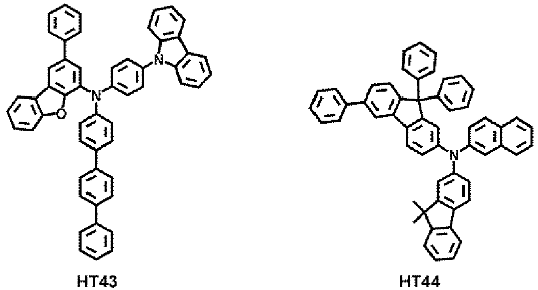

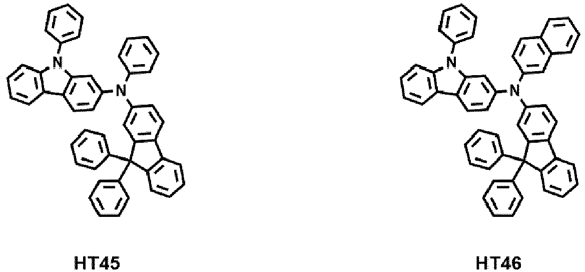

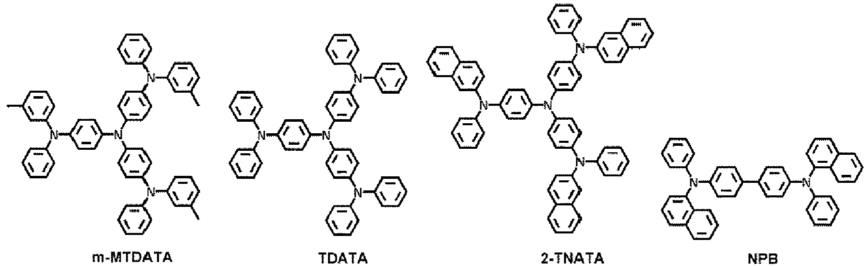

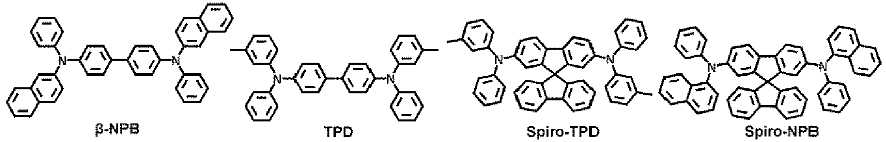

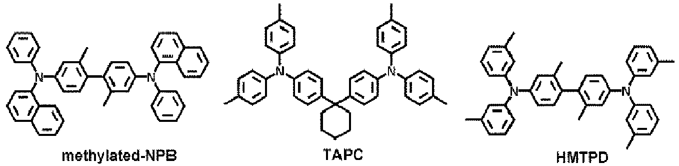

A thickness of the hole transport region may be in a range of about 50 Å to about 10,000 Å, for example, about 100 Å to about 4,000 Å. When the hole transport region includes a hole injection layer, a hole transport layer, or one or more combinations thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by an emission layer, and the electron-blocking layer may block or reduce the leakage of electrons from an emission layer to a hole transport region. Materials that may be included in the hole transport region may be included in the emission auxiliary layer and the electron-blocking layer.

### p-dopant

The hole transport region may further include, in addition to these materials, a charge-generation material for the improvement of conductive properties. The charge-generation material may be uniformly or non-uniformly dispersed in the hole transport region (for example, in the form of a single layer consisting of a charge-generation material).

The charge-generation material may be, for example, a p-dopant.

For example, the lowest unoccupied molecular orbital (LUMO) energy level of the p-dopant may be -3.5 eV or less.

In one or more embodiments, the p-dopant may include a quinone derivative, a cyano group-containing compound, a compound including element EL1 and element EL2, or one or more combinations thereof.

Examples of the quinone derivative are TCNQ, F4-TCNQ, etc.

Examples of the cyano group-containing compound are HAT-CN, and a compound represented by Formula 221.

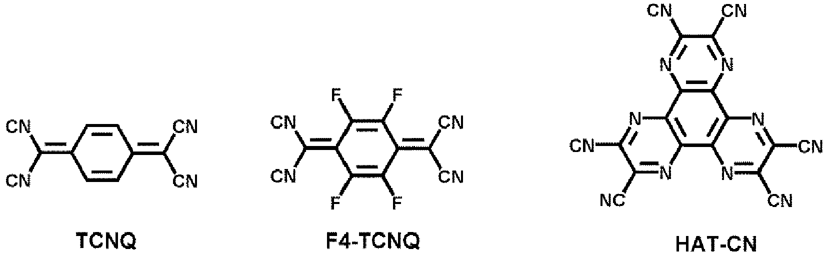

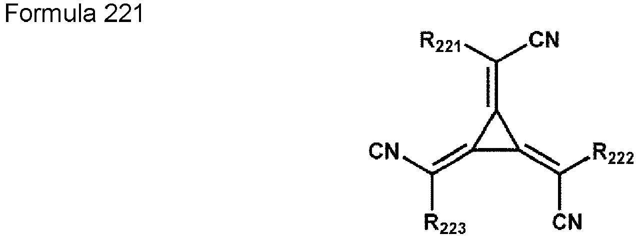

In Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, substituted with a cyano group; -F; -Cl; -Br; -I; a C₁-C₂₀ alkyl group substituted with a cyano group, -F, -Cl, -Br, -I, or a combination thereof; or one or more combinations thereof.

In the compound including element EL1 and element EL2, element EL1 may be metal, metalloid, or one or more combinations thereof, and element EL2 may be non-metal, metalloid, or one or more combinations thereof.

Examples of the metal are an alkali metal (for example, lithium (Li), sodium (Na), potassium (K), rubidium (Rb), cesium (Cs), etc.); alkaline earth metal (for example, beryllium (Be), magnesium (Mg), calcium (Ca), strontium (Sr), barium (Ba), etc.); transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); post-transition metal (for example, zinc (Zn), indium (In), tin (Sn), etc.); and lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of the metalloid are silicon (Si), antimony (Sb), and tellurium (Te).

Examples of the non-metal are oxygen (O) and halogen (for example, F, Cl, Br, I, etc.).

Examples of the compound including element EL1 and element EL2 are metal oxide, metal halide (for example, metal fluoride, metal chloride, metal bromide, or metal iodide), metalloid halide (for example, metalloid fluoride, metalloid chloride, metalloid bromide, or metalloid iodide), metal telluride, or one or more combinations thereof.

Examples of the metal oxide are tungsten oxide (for example, WO, W₂O₃, WO₂, WO₃, W₂O₅, etc.), vanadium oxide (for example, VO, V₂O₃, VO₂, V₂O₅, etc.), molybdenum oxide (MoO, Mo₂O₃, MoO₂, MoOs, Mo₂O₅, etc.), and rhenium oxide (for example, ReOs, etc.).

Examples of the metal halide are alkali metal halide, alkaline earth metal halide, transition metal halide, post-transition metal halide, and lanthanide metal halide.

Examples of the alkali metal halide are LiF, NaF, KF, RbF, CsF, LiCl, NaCl, KCl, RbCl, CsCl, LiBr, NaBr, KBr, RbBr, CsBr, Lil, Nal, KI, Rbl, and Csl.

Examples of the alkaline earth metal halide are BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, and BaI_{2.}

Examples of the transition metal halide are titanium halide (for example, TiF₄, TiCl₄, TiBr₄, TiI₄, etc.), zirconium halide (for example, ZrF₄, ZrCl₄, ZrBr₄, ZrI₄, etc.), hafnium halide (for example, HfF₄, HfCl₄, HfBr₄, HfI₄, etc.), vanadium halide (for example, VF₃, VCl₃, VBr₃, VI₃, etc.), niobium halide (for example, NbF₃, NbCl₃, NbBr₃, NbI₃, etc.), tantalum halide (for example, TaF₃, TaCl₃, TaBr₃, TaI₃, etc.), chromium halide (for example, CrFs, CrCl₃, CrBr₃, CrI₃, etc.), molybdenum halide (for example, MoF₃, MoCl₃, MoBr₃, MoI₃, etc.), tungsten halide (for example, WF₃, WCl₃, WBr₃, WI₃, etc.), manganese halide (for example, MnF₂, MnCl₂, MnBr₂, MnI₂, etc.), technetium halide (for example, TcF₂, TcCl₂, TcBr₂, TcI₂, etc.), rhenium halide (for example, ReF₂, ReCl₂, ReBr₂, ReI₂, etc.), iron halide (for example, FeF₂, FeCl₂, FeBr₂, FeI₂, etc.), ruthenium halide (for example, RuF₂, RuCl₂, RuBr₂, RuI₂, etc.), osmium halide (for example, OsF₂, OsCl₂, OsBr₂, OsI₂, etc.), cobalt halide (for example, CoF₂, CoCl₂, CoBr₂, CoI₂, etc.), rhodium halide (for example, RhF₂, RhCl₂, RhBr₂, RhI₂, etc.), iridium halide (for example, IrF₂, IrCl₂, IrBr₂, IrI₂, etc.), nickel halide (for example, NiF₂, NiCl₂, NiBr₂, NiI₂, etc.), palladium halide (for example, PdF₂, PdCl₂, PdBr₂, PdI₂, etc.), platinum halide (for example, PtF₂, PtCl₂, PtBr₂, PtI₂, etc.), copper halide (for example, CuF, CuCl, CuBr, Cul, etc.), silver halide (for example, AgF, AgCl, AgBr, Agl, etc.), and gold halide (for example, AuF, AuCl, AuBr, Aul, etc.).

Examples of the post-transition metal halide are zinc halide (for example, ZnF₂, ZnCl₂, ZnBr₂, ZnI₂, etc.), indium halide (for example, InI₃, etc.), and tin halide (for example, SnI₂, etc.).

Examples of the lanthanide metal halide may include YbF, YbF₂, YbF₃, SmF₃, YbCl, YbCl₂, YbCl₃ SmCl₃, YbBr, YbBr₂, YbBr₃, SmBr₃, YbI, YbI₂, YbI₃, SmI₃, and/or the like.

An example of the metalloid halide is antimony halide (for example, SbCl₅, etc.).

Examples of the metal telluride are alkali metal telluride (for example, Li₂Te, Na₂Te, K₂Te, Rb₂Te, Cs₂Te, etc.), alkaline earth metal telluride (for example, BeTe, MgTe, CaTe, SrTe, BaTe, etc.), transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal telluride (for example, ZnTe, etc.), and lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### Emission layer in interlayer 130

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers of a red emission layer, a green emission layer, and a blue emission layer, in which the two or more layers contact each other or are separated from each other to emit white light. In one or more embodiments, the emission layer may include two or more materials of a red light-emitting material, a green light-emitting material, and a blue light-emitting material, in which the two or more materials are mixed with each other in a single layer to emit white light.

In an embodiment, the emission layer may further include a host, an auxiliary dopant, a sensitizer, delayed fluorescence material, or one or more combinations thereof, in addition to the first emitter as described in the present specification.

When the emission layer further includes a host in addition to the first emitter, the amount of the first emitter is about 0.01 to about 15 parts by weight based on 100 parts by weight of the host.

A thickness of the emission layer may be in a range of about 100 Å to about 1,000 Å, for example, about 200 Å to about 600 Å. When the thickness of the emission layer is within these ranges, excellent or suitable light-emission characteristics may be obtained without a substantial increase in driving voltage.

### Host

The host in the emission layer may include an electron-transporting compound described herein (for example, refer to the compounds represented by Formula 2-1 or 2-2), a hole-transporting compound described herein (for example, refer to a compound represented by one of Formulae 3-1 to 3-5), or a combination thereof.

In one or more embodiments, the host may include an alkali earth metal complex, a post-transition metal complex, or one or more combinations thereof. For example, the host may include a Be complex (for example, Compound H55), an Mg complex, a Zn complex, or one or more combinations thereof.

In one or more embodiments, the host may include at least one of Compounds H1 to H130, 9,10-di(2-naphthyl)anthracene (ADN), 2-methyl-9,10-bis(naphthalen-2-yl)anthracene (MADN), 9,10-di(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or one or more combinations thereof:

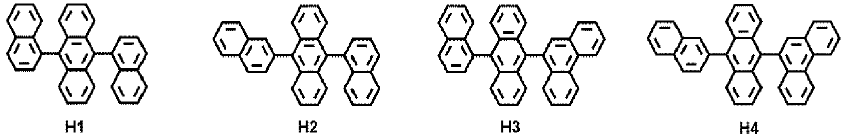

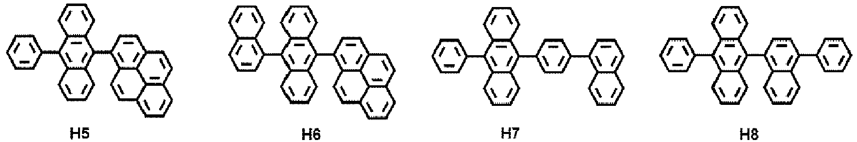

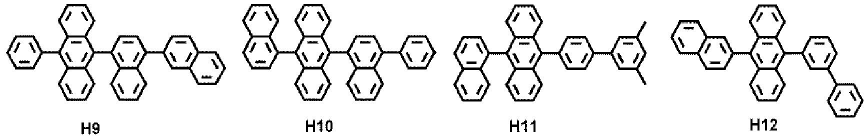

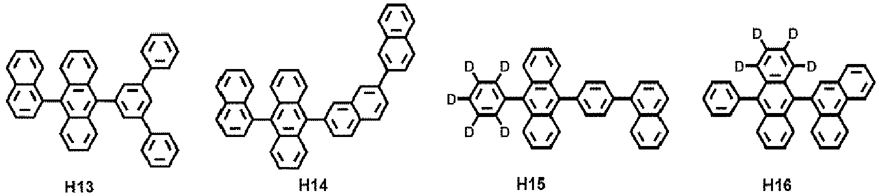

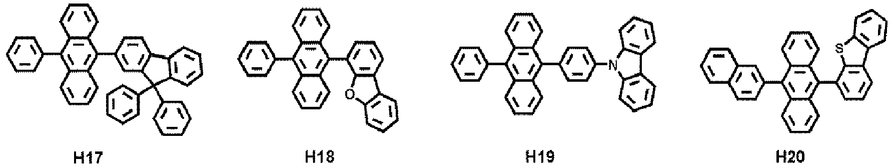

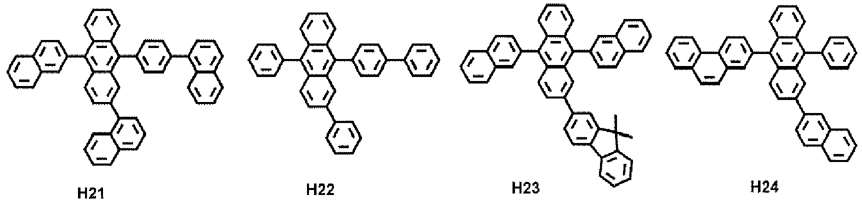

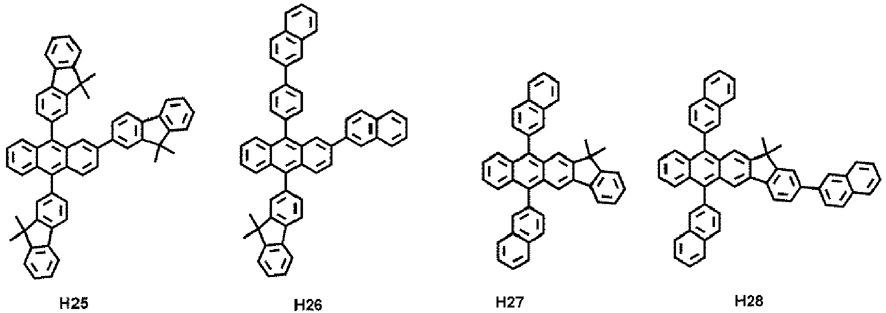

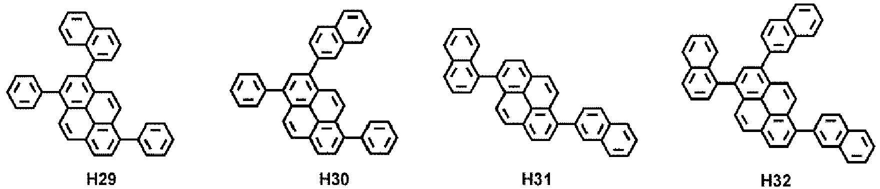

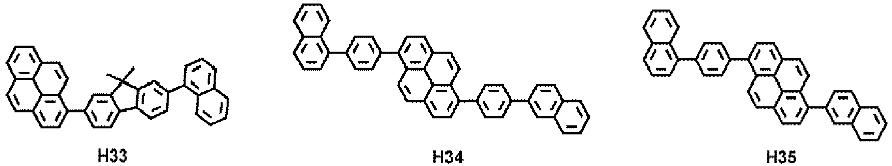

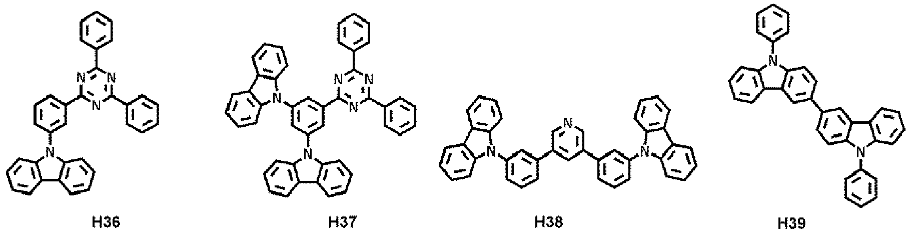

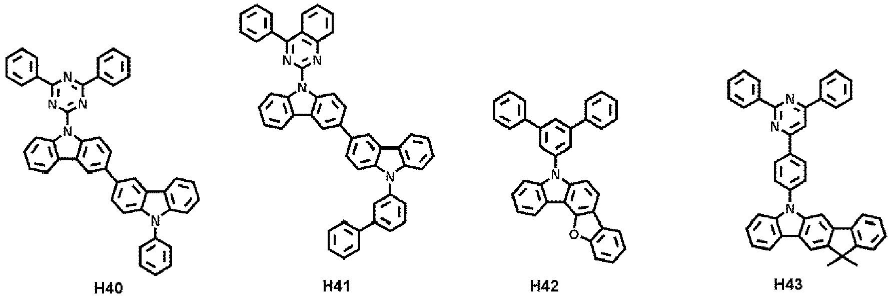

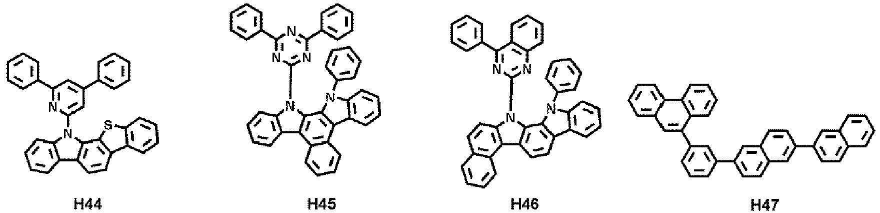

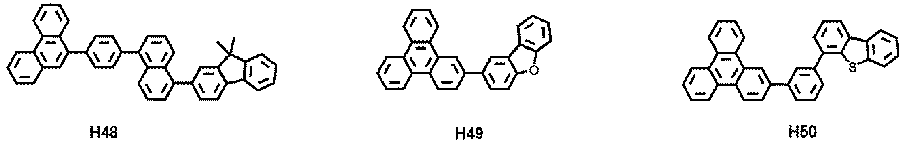

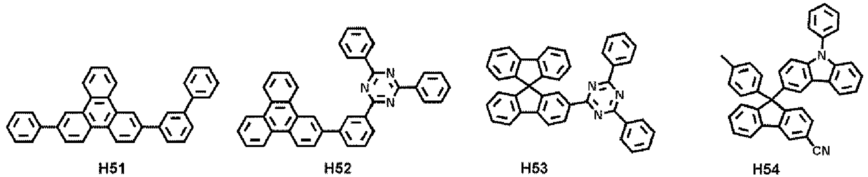

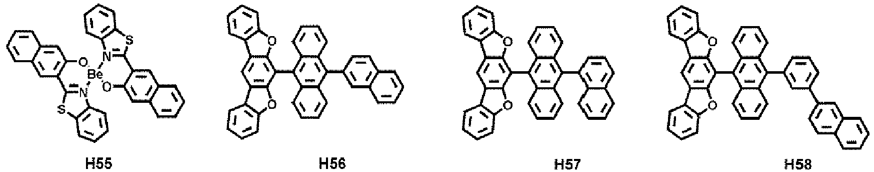

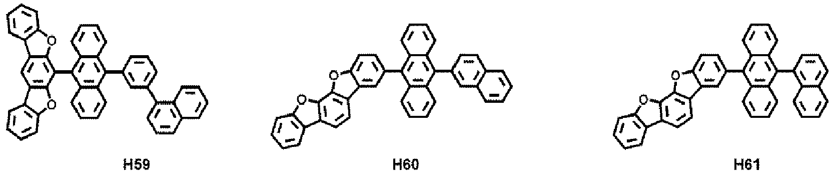

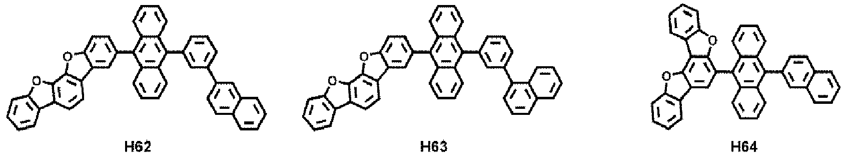

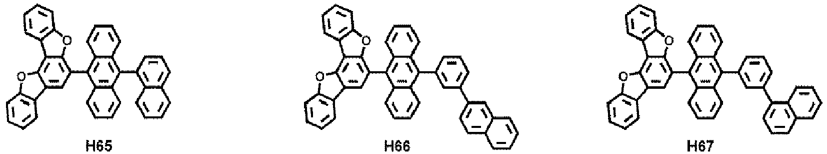

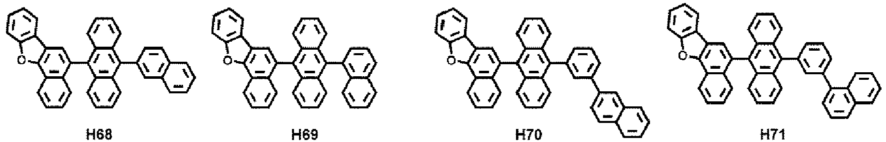

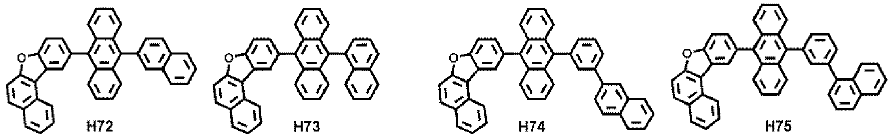

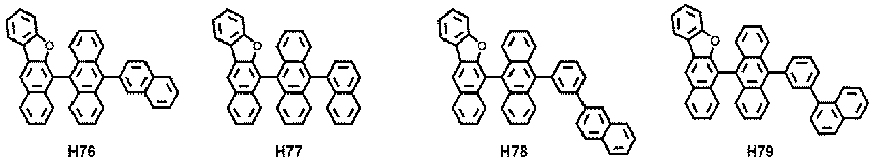

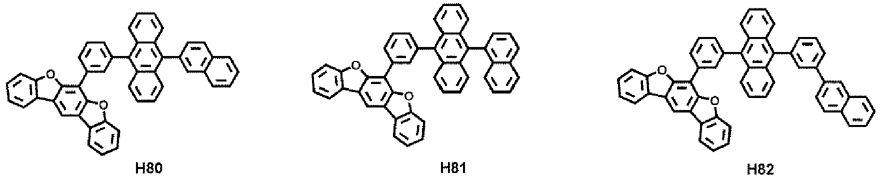

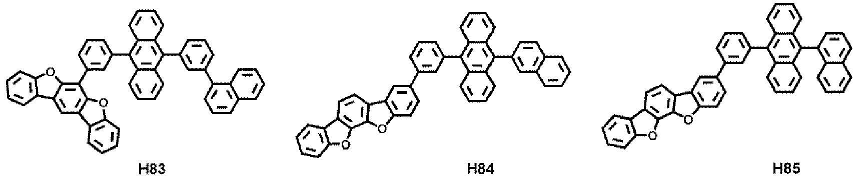

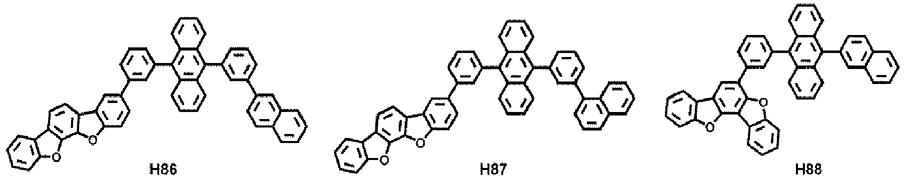

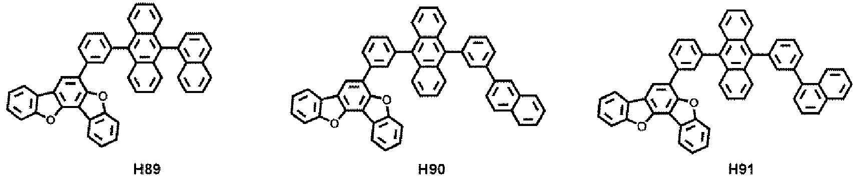

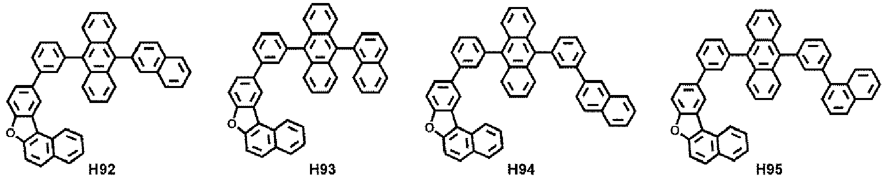

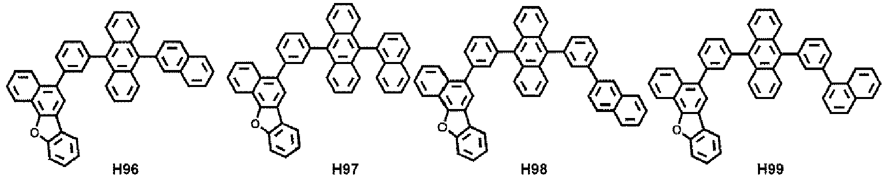

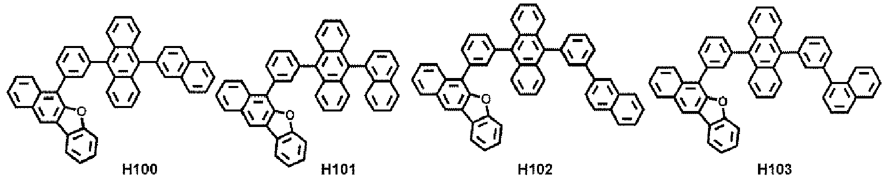

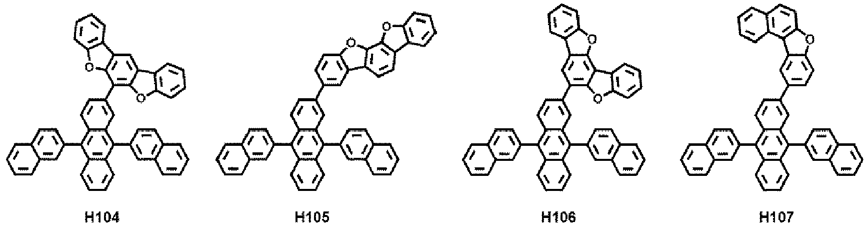

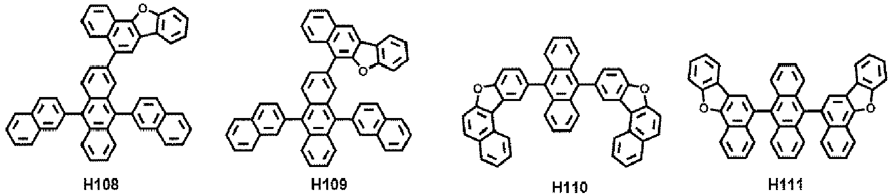

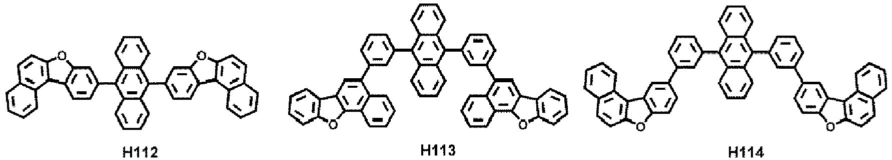

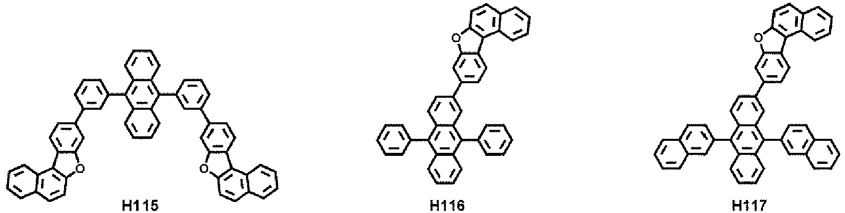

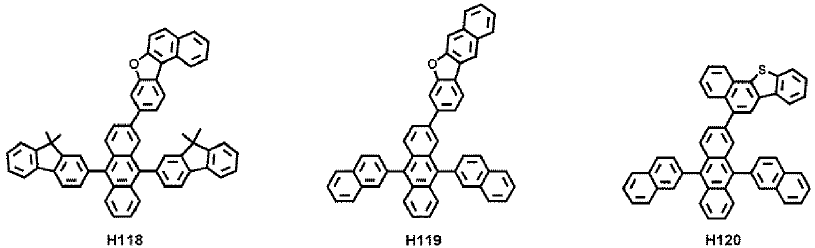

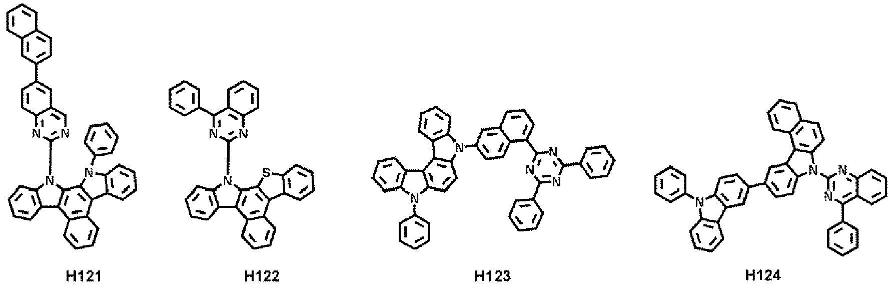

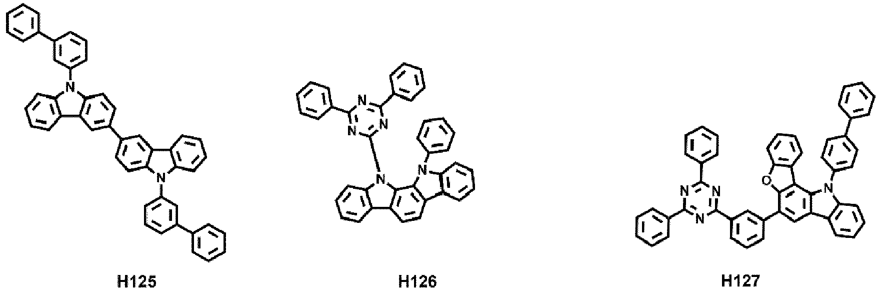

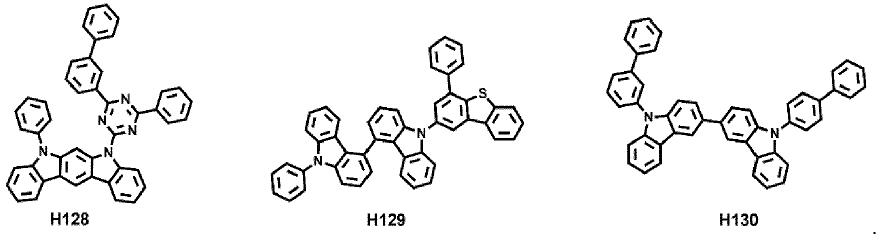

In an embodiment, the host may include a silicon-containing compound, a phosphine oxide-containing compound, or one or more combinations thereof.

The host may have one or more suitable modifications. For example, the host may include only one kind of compound, or may include two or more kinds of different compounds.

### Phosphorescent dopant

The emission layer may include, as a phosphorescent dopant, the first emitter as described herein.

In an embodiment, the emission layer may further include, in addition to the first emitter as described in the present specification, an organometallic compound represented by Formula 401:

Formula 401 M(L₄₀₁)_{xc1}(L₄₀₂)_{xc2}

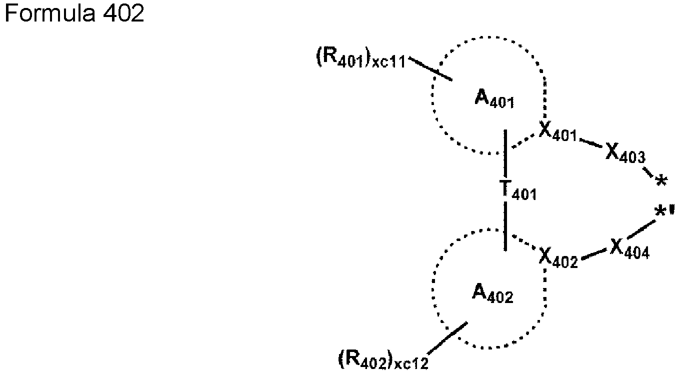

wherein, in Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein when xc1 is two or more, two or more of L₄₀₁(s) may be identical to or different from each other,
L₄₀₂ may be an organic ligand, and xc2 may be 0, 1, 2, 3, or 4, and when xc2 is 2 or more, two or more of L₄₀₂(s) may be identical to or different from each other,
X₄₀₁ and X₄₀₂ may each independently be nitrogen or carbon,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C(Q₄₁₁)=*',
X₄₀₃ and X₄₀₄ may each independently be a chemical bond (for example, a covalent bond or a coordination bond), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ may each be the same as described herein with respect to Q₁,
R₄₀₁ and R₄₀₂ may each independently be hydrogen, deuterium, -F, -Cl, -Br, - I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), - B(Q₄₀₁)(Q₄₀₂), -C(=O)(Q₄₀₁), -S(=O)₂(Q₄₀₁), or -P(=O)(Q₄₀₁)(Q₄₀₂),
Q₄₀₁ to Q₄₀₃ may each be the same as described herein with respect to Q₁,
xc11 and xc12 may each independently be an integer from 0 to 10, and
* and *' in Formula 402 each indicate a binding site to M in Formula 401.

For example, in Formula 402, i) X₄₀₁ may be nitrogen, and X₄₀₂ may be carbon, or ii) each of X₄₀₁ and X₄₀₂ may be nitrogen.

In one or more embodiments, when xc1 in Formula 402 is 2 or more, two ring A₄₀₁(s) in two or more of L₄₀₁(s) may be optionally linked to each other via T₄₀₂, which is a linking group, or two ring A₄₀₂(s) may be optionally linked to each other via T₄₀₃, which is a linking group (see Compounds PD1 to PD4 and PD7). T₄₀₂ and T₄₀₃ may each be the same as described herein with respect to T₄₀₁.

L₄₀₂ in Formula 401 may be an organic ligand. For example, L₄₀₂ may include a halogen group, a diketone group (for example, an acetylacetonate group), a carboxylic acid group (for example, a picolinate group), -C(=O), an isonitrile group, - CN group, a phosphorus group (for example, a phosphine group, a phosphite group, etc.), or one or more combinations thereof.

### Fluorescent dopant

The emission layer may further include a fluorescent dopant in addition to the first emitter as described in the present specification.

The fluorescent dopant may include an arylamine compound, a styrylamine compound, a boron-containing compound, or one or more combinations thereof.

For example, the fluorescent dopant may include a compound represented by Formula 501: 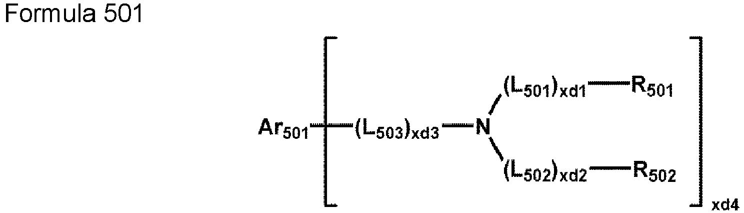 wherein, in Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

For example, Ar₅₀₁ in Formula 501 may be a condensed cyclic group (for example, an anthracene group, a chrysene group, or a pyrene group) in which three or more monocyclic groups are condensed together.

In one or more embodiments, xd4 in Formula 501 may be 2.

For example, the fluorescent dopant may include: at least one of Compounds FD1 to FD36; DPVBi; DPAVBi; or one or more combinations thereof:

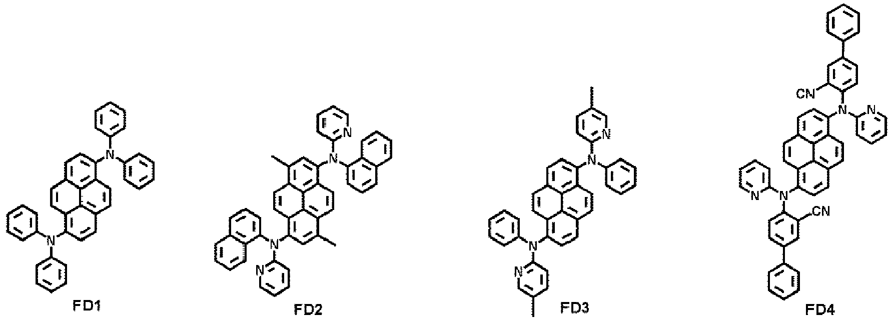

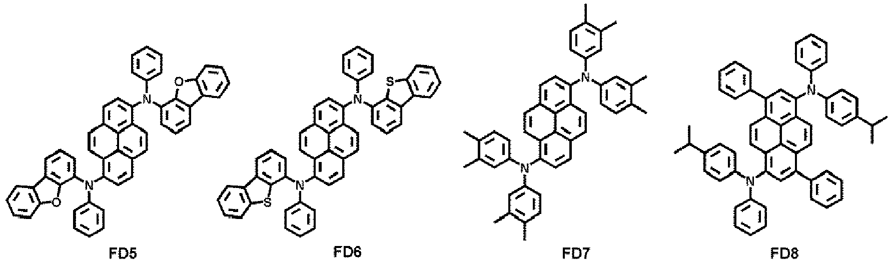

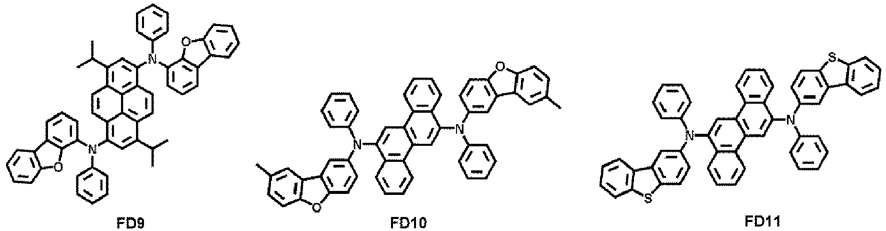

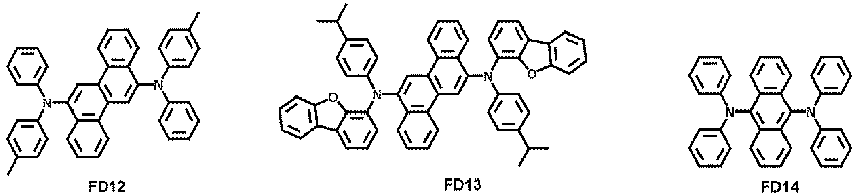

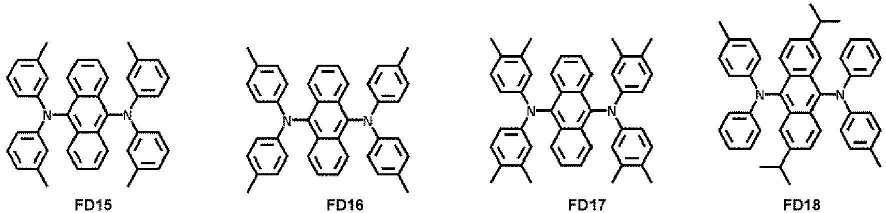

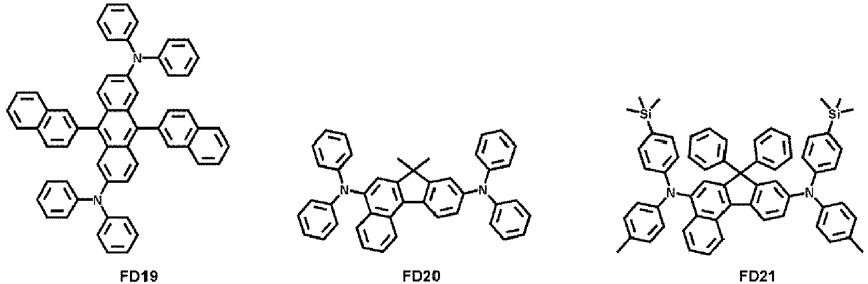

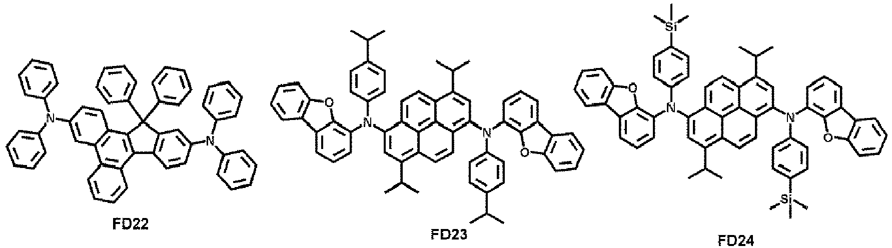

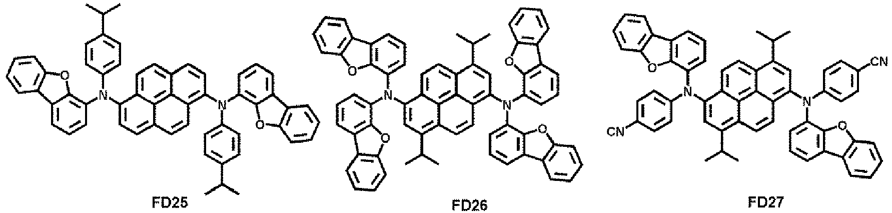

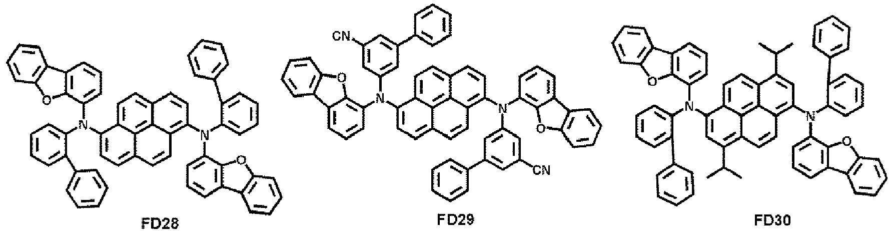

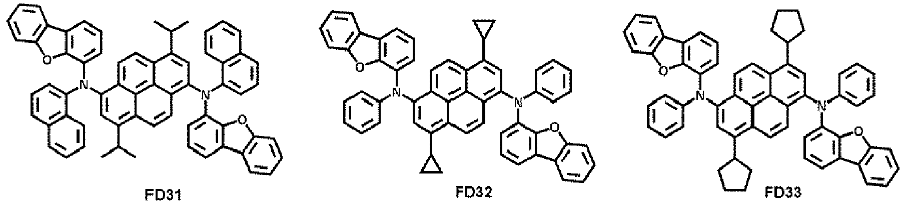

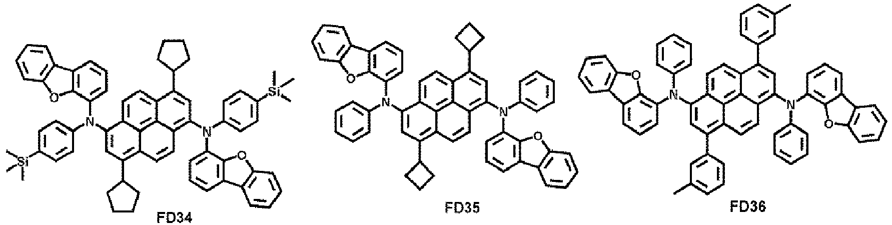

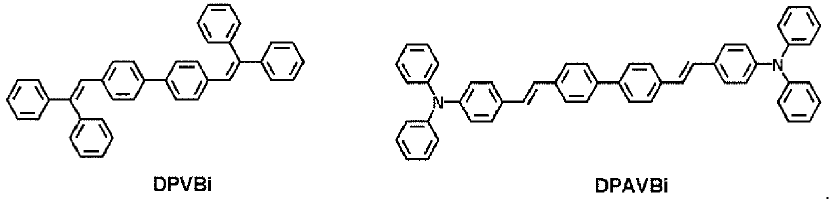

### Delayed fluorescence material

The emission layer may further include a delayed fluorescence material.

In the present specification, the delayed fluorescence material may be selected from compounds capable of emitting delayed fluorescent light based on a delayed fluorescence emission mechanism.

The delayed fluorescence material included in the emission layer may act as a host or a dopant depending on the type or kind of other materials included in the emission layer.

In one or more embodiments, the difference between the triplet energy level (eV) of the delayed fluorescence material and the singlet energy level (eV) of the delayed fluorescence material may be greater than or equal to about 0 eV and less than or equal to about 0.5 eV. When the difference between the triplet energy level (eV) of the delayed fluorescence material and the singlet energy level (eV) of the delayed fluorescence material satisfies the above-described range, up-conversion from the triplet state to the singlet state of the delayed fluorescence materials may effectively occur, and thus, the luminescence efficiency of the light-emitting device 10 may be improved.

For example, the delayed fluorescence material may include i) a material including at least one electron donor (for example, a π electron-rich C₃-C₆₀ cyclic group, such as a carbazole group) and at least one electron acceptor (for example, a sulfoxide group, a cyano group, or a π electron-deficient nitrogen-containing C₁-C₆₀ cyclic group), and ii) a material including a C₈-C₆₀ polycyclic group in which two or more cyclic groups are condensed while sharing boron (B).

Examples of the delayed fluorescence material may include at least one of Compounds DF1 to DF14:

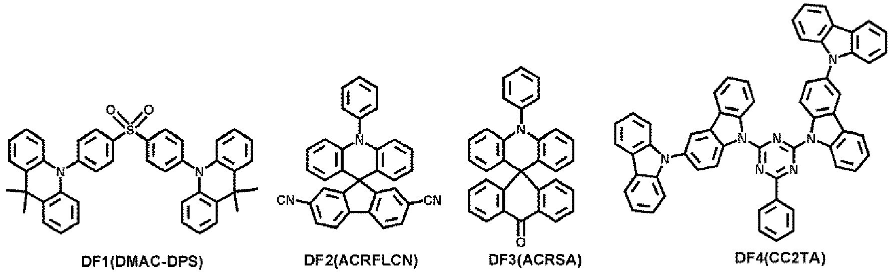

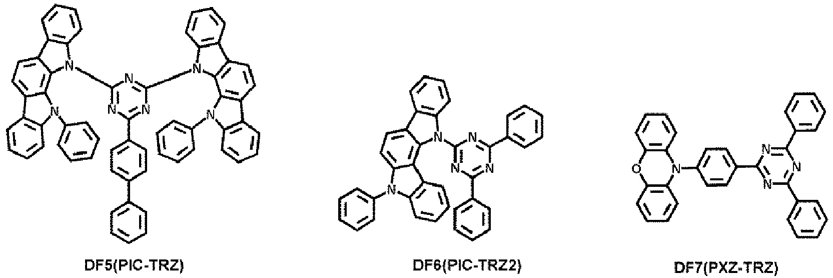

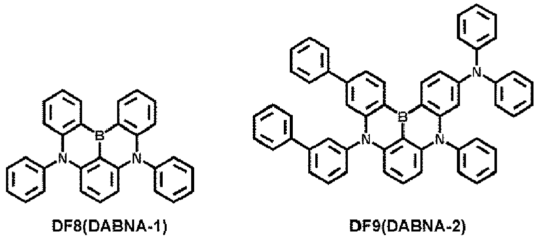

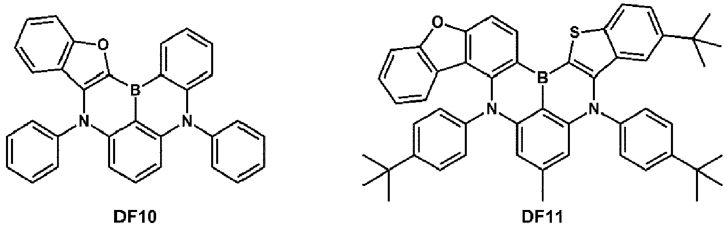

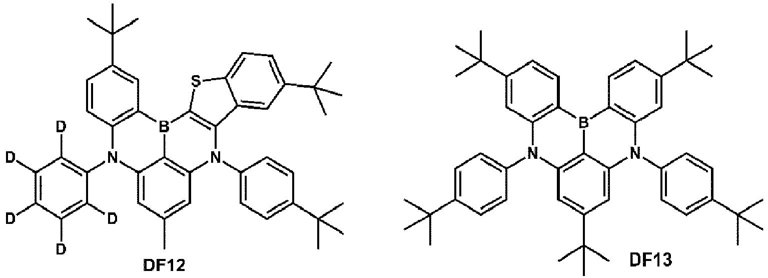

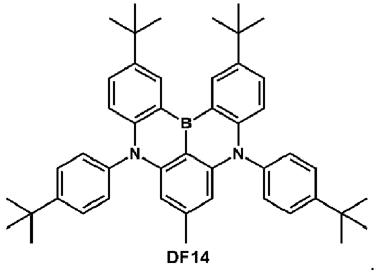

### Electron transport region in interlayer 130

The electron transport region may have: i) a single-layered structure consisting of a single layer consisting of a single material, ii) a single-layered structure consisting of a single layer consisting of a plurality of different materials, or iii) a multi-layered structure including a plurality of layers including different materials.

The electron-transporting region may include a buffer layer, a hole-blocking layer, an electron control layer, an electron-transporting layer, an electron injection layer, or one or more combinations thereof.

For example, the electron transport region may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, the constituting layers of each structure being sequentially stacked from an emission layer.

The electron transport region may include a heterocyclic compound (for example, a compound represented by Formula 8, etc.) as described in the present specification.

For example, the electron transport region may have a structure in which an electron transport layer and an electron injection layer are sequentially stacked, and the heterocyclic compound described in the present specification may be included in the electron transport layer.

In an embodiment, the electron transport region may have a structure in which a hole-blocking layer, an electron transport layer, and an electron injection layer are sequentially stacked, and the heterocyclic compound described in the present specification may be included in the electron transport layer.

The electron transport region (for example, a buffer layer, a hole-blocking layer, an electron control layer, or an electron transport layer in the electron transport region) may further include, in addition to the heterocyclic compound described herein, a metal-free compound including at least one π electron-deficient nitrogen-containing C₁-C₆₀ cyclic group.

For example, the electron transport region may further include a compound represented by Formula 601 in addition to the heterocyclic compound described in the present specification.

Formula 601 [Ar₆₀₁]ₓₑ₁₁-[(L₆₀₁)ₓₑ₁-R₆₀₁]ₓₑ₂₁

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as described herein with respect to Q₁,
xe21 may be 1, 2, 3, 4, or 5, and
at least one of Ar₆₀₁, L₆₀₁, and R₆₀₁ may each independently be a π electron-deficient nitrogen-containing C₁-C₆₀ cyclic group unsubstituted or substituted with at least one R₁₀ₐ.

For example, when xe11 in Formula 601 is 2 or more, two or more of Ar₆₀₁(s) may be linked to each other via a single bond.

In other embodiments, Ar₆₀₁ in Formula 601 may be a substituted or unsubstituted anthracene group.

For example, the electron transport region may further include a compound represented by Formula 601-1 in addition to the heterocyclic compound described in the present specification. 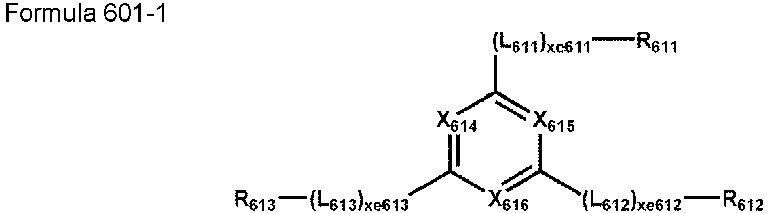 wherein, in Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ may each be the same as described herein with respect to L₆₀₁,
xe611 to xe613 may each be the same as described herein with respect to xe1,
R₆₁₁ to R₆₁₃ may each be the same as described herein with respect to R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, xe1 and xe611 to xe613 in Formulae 601 and 601-1 may each independently be 0, 1, or 2.

In an embodiment, the electron transport region may further include, in addition to the heterocyclic compound described in the present specification, at least one of the following compounds ET1 to ET46, 2,9-dimethyl-4,7-diphenyl-1,10-phenanthroline (BCP), 4,7-diphenyl-1,10-phenanthroline (Bphen), Alq3, BAlq, TAZ, NTAZ, or a combination thereof:

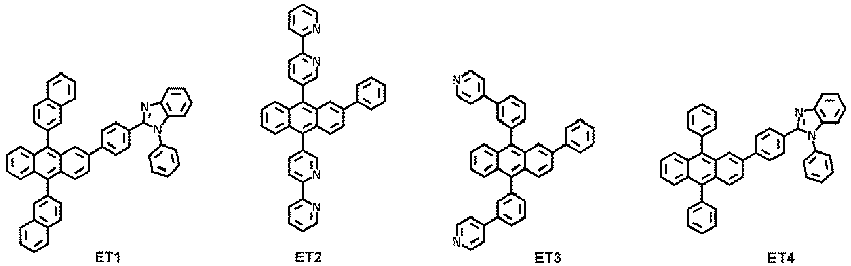

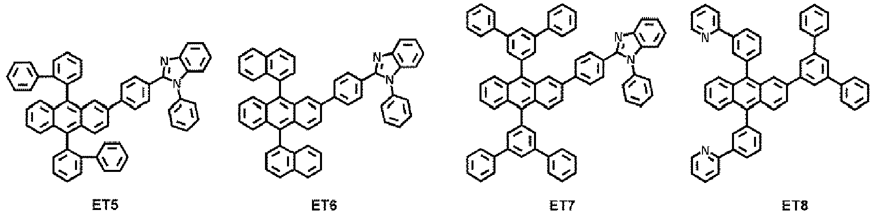

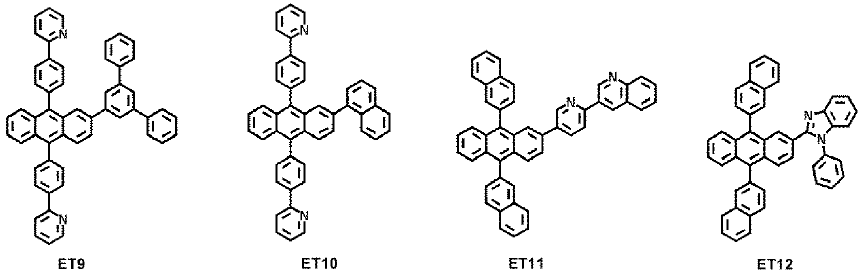

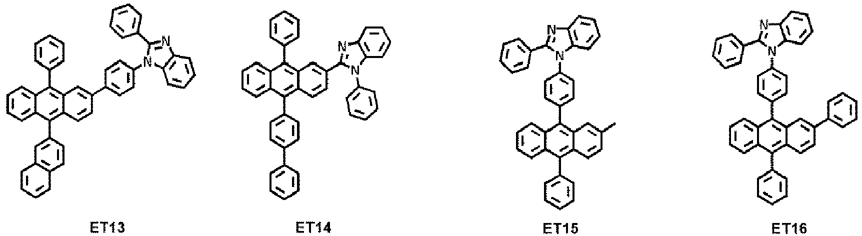

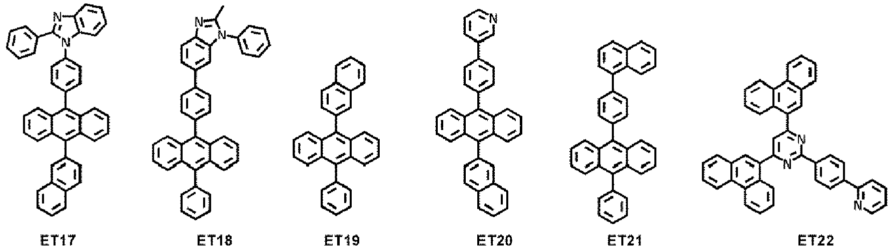

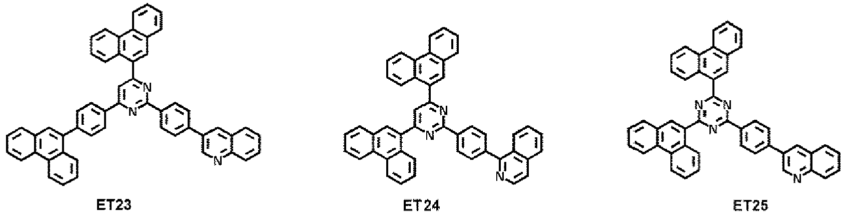

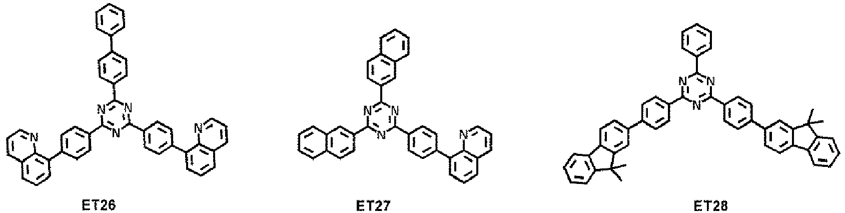

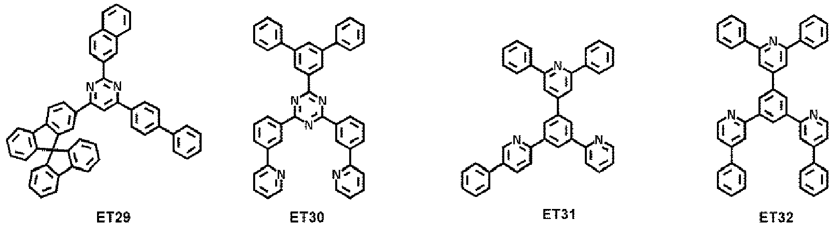

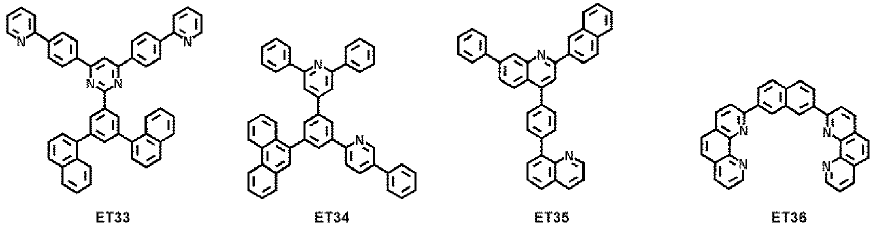

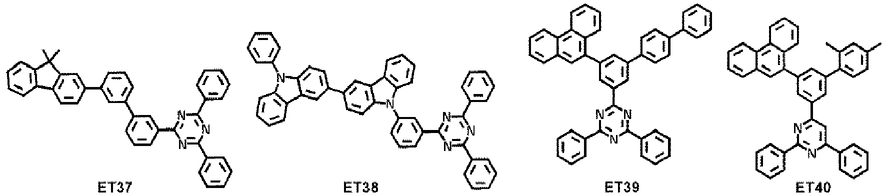

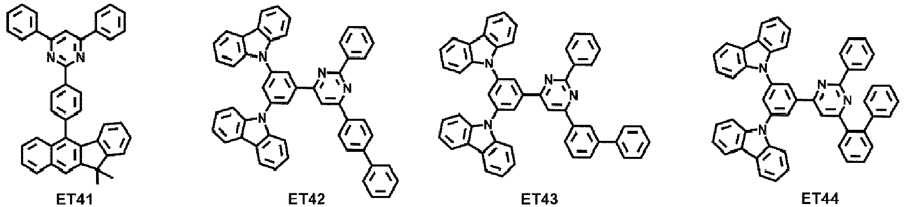

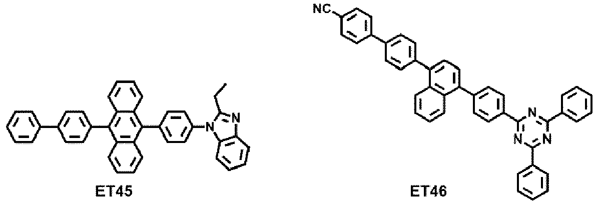

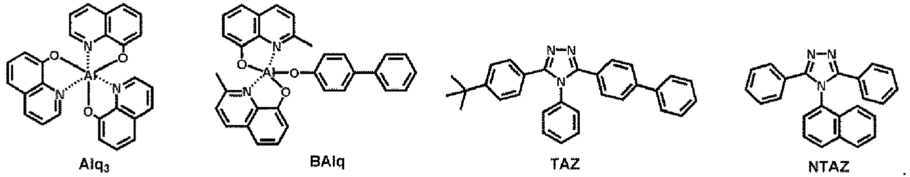

A thickness of the electron transport region may be from about 100 Å to about 5,000 Å, for example, about 160 Å to about 4,000 Å. When the electron transport region includes a buffer layer, a hole-blocking layer, an electron control layer, an electron transport layer, or one or more combinations thereof, the thickness of the buffer layer, the hole-blocking layer, or the electron control layer may each independently be from about 20 Å to about 1000 Å, for example, about 30 Å to about 300 Å, and the thickness of the electron transport layer may be from about 100 Å to about 1000 Å, for example, about 150 Å to about 500 Å. When the thickness of the buffer layer, the hole-blocking layer, the electron control layer, the electron transport layer, and/or the electron transport layer are within these ranges, satisfactory electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or one or more combinations thereof. The metal ion of an alkali metal complex may be a Li ion, a Na ion, a K ion, a Rb ion, or a Cs ion, and the metal ion of an alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or one or more combinations thereof.

For example, the metal-containing material may include a Li complex. The Li complex may include, for example, Compound ET-D1 (LiQ) or ET-D2:

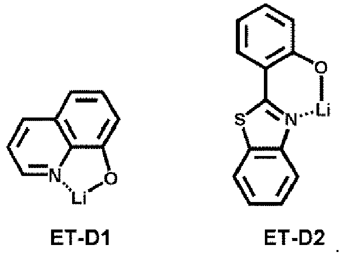

The electron transport region may include an electron injection layer that facilitates the injection of electrons from the second electrode 150. The electron injection layer may directly contact the second electrode 150.

The electron injection layer may have: i) a single-layered structure consisting of a single layer consisting of a single material, ii) a single-layered structure consisting of a single layer consisting of a plurality of different materials, or iii) a multi-layered structure including a plurality of layers including different materials.

The electron injection layer may include an alkali metal, alkaline earth metal, a rare earth metal, an alkali metal-containing compound, alkaline earth metal-containing compound, a rare earth metal-containing compound, an alkali metal complex, an alkaline earth metal complex, a rare earth metal complex, or one or more combinations thereof.

The alkali metal may include Li, Na, K, Rb, Cs, or one or more combinations thereof. The alkaline earth metal may include Mg, Ca, Sr, Ba, or one or more combinations thereof. The rare earth metal may include Sc, Y, Ce, Tb, Yb, Gd, or one or more combinations thereof.

The alkali metal-containing compound, the alkaline earth metal-containing compound, and the rare earth metal-containing compound may be oxides, halides (for example, fluorides, chlorides, bromides, or iodides), or tellurides of the alkali metal, the alkaline earth metal, and the rare earth metal, or one or more combinations thereof.

The alkali metal-containing compound may include: alkali metal oxides, such as Li₂O, Cs₂O, or K₂O; alkali metal halides, such as LiF, NaF, CsF, KF, Lil, Nal, Csl, KI, or RbI; or one or more combinations thereof. The alkaline earth metal-containing compound may include an alkaline earth metal compound, such as BaO, SrO, CaO, BaₓSr₁₋ₓO (wherein x is a real number satisfying the condition of 0<x<1), BaₓCa₁₋ₓO (wherein x is a real number satisfying the condition of 0<x<1), and/or the like. The rare earth metal-containing compound may include YbF₃, ScF₃, Sc₂O₃, Y₂O₃, Ce₂O₃, GdF₃, TbF₃, YbI₃, ScI₃, TbI₃, or one or more combinations thereof. In one or more embodiments, the rare earth metal-containing compound may include lanthanide metal telluride. Examples of the lanthanide metal telluride are LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and Lu₂Te₃.

The alkali metal complex, the alkaline earth-metal complex, and the rare earth metal complex may include i) one of metal ions of the alkali metal, the alkaline earth metal, and the rare earth metal and ii), as a ligand bonded to the metal ion, for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or one or more combinations thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or one or more combinations thereof, as described above. In one or more embodiments, the electron injection layer may further include an organic material (for example, a compound represented by Formula 601).

In one or more embodiments, the electron injection layer may include (e.g., consist of): i) an alkali metal-containing compound (for example, an alkali metal halide); or ii) a) an alkali metal-containing compound (for example, an alkali metal halide), and b) an alkali metal, an alkaline earth metal, a rare earth metal, or one or more combinations thereof. For example, the electron injection layer may be a KI:Yb co-deposited layer, an RbI:Yb co-deposited layer, a LiF:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or one or more combinations thereof may be uniformly or non-uniformly dispersed in a matrix including the organic material.

A thickness of the electron injection layer may be in a range of about 1 Å to about 100 Å, and, for example, about 3 Å to about 90 Å. When the thickness of the electron injection layer is within the ranges described above, satisfactory electron injection characteristics may be obtained without a substantial increase in driving voltage.

### Second electrode 150

The second electrode 150 may be located on the interlayer 130 having a structure as described above. The second electrode 150 may be a cathode, which is an electron injection electrode, and as the material for the second electrode 150, a metal, an alloy, an electrically conductive compound, or one or more combinations thereof, each having a low-work function, may be utilized.

The second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or one or more combinations thereof. The second electrode 150 may be a transmissive electrode, a semi-transmissive electrode, or a reflective electrode.

The second electrode 150 may have a single-layered structure or a multi-layered structure including a plurality of layers.

### Capping layer

A first capping layer may be located outside the first electrode 110, and/or a second capping layer may be located outside the second electrode 150. In particular, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in an emission layer of the interlayer 130 of the light-emitting device 10 may be extracted toward the outside through the first electrode 110 which is a semi-transmissive electrode or a transmissive electrode, and the first capping layer. Light generated in an emission layer of the interlayer 130 of the light-emitting device 10 may be extracted toward the outside through the second electrode 150 which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the luminescence efficiency of the light-emitting device 10 may be improved.

Each of the first capping layer and the second capping layer may include a material having a refractive index of 1.6 or more (at about 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer and/or the second capping layer may each independently include carbocyclic compounds, heterocyclic compounds, amine group-containing compounds, porphine derivatives, phthalocyanine derivatives, naphthalocyanine derivatives, alkali metal complexes, alkaline earth metal complexes, or one or more combinations thereof. Optionally, the carbocyclic compound, the heterocyclic compound, and the amine group-containing compound may be substituted with a substituent including O, N, S, Se, Si, F, Cl, Br, I, or one or more combinations thereof. In one or more embodiments, at least one of the first capping layer and/or the second capping layer may each independently include an amine group-containing compound.

For example, at least one of the first capping layer and/or the second capping layer may each independently include a compound represented by Formula 201, a compound represented by Formula 202, or one or more combinations thereof.

In one or more embodiments, at least one of the first capping layer and the second capping layer may each independently include at least one of Compounds HT28 to HT33, at least one of Compounds CP1 to CP6, β-NPB, or one or more combinations thereof:

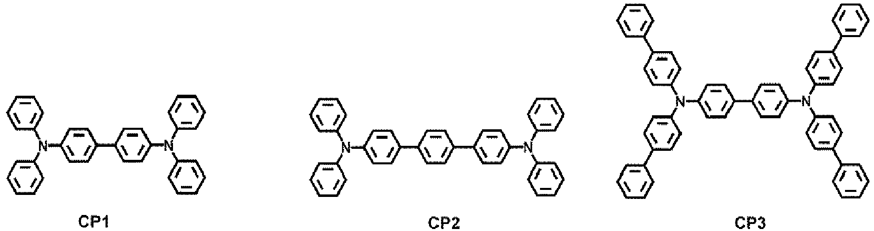

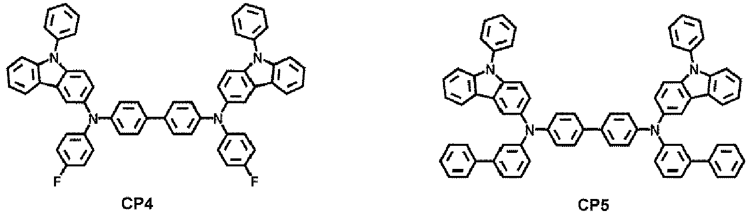

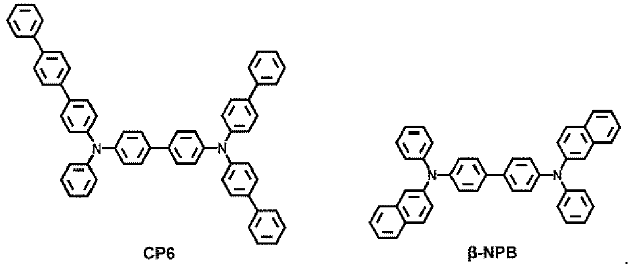

### Electronic device

The light-emitting device may be included in one or more suitable electronic devices. For example, the electronic device including the light-emitting device may be a light-emitting device, an authentication apparatus, and/or the like.

The electronic device (for example, a light-emitting device) may further include, in addition to the light-emitting device, i) a color filter, ii) a color conversion layer, or iii) a color filter and a color conversion layer. The color filter and/or the color conversion layer may be located in at least one direction in which light emitted from the light-emitting device travels. For example, the light emitted from the light-emitting device may be blue light, green light, or white light. For details on the light-emitting device, related description provided above may be referred to. In one or more embodiments, the color conversion layer may include a quantum dot.

The electronic device may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be located among the subpixel areas to define each of the subpixel areas.

The color filter may further include a plurality of color filter areas and light-shielding patterns located among the color filter areas, and the color conversion layer may further include a plurality of color conversion areas and light-shielding patterns located among the color conversion areas.

The plurality of color filter areas (or the plurality of color conversion areas) may include a first area emitting first color light, a second area emitting second color light, and/or a third area emitting third color light, wherein the first color light, the second color light, and/or the third color light may have different maximum emission wavelengths from one another. For example, the first color light may be red light, the second color light may be green light, and the third color light may be blue light. For example, the plurality of color filter areas (or the plurality of color conversion areas) may include quantum dots. In particular, the first area may include a red quantum dot, the second area may include a green quantum dot, and the third area may not include(e.g., may exclude) a quantum dot. For details on the quantum dot, related descriptions provided herein may be referred to. The first area, the second area, and/or the third area may each include a scatter.

For example, the light-emitting device may be configured to emit first light, the first area may be configured to absorb the first light to emit first-first color light, the second area may be configured to absorb the first light to emit second-first color light, and the third area may be configured to absorb the first light to emit third-first color light. In this regard, the first-first color light, the second-first color light, and the third-first color light may have different maximum emission wavelengths. In particular, the first light may be blue light, the first-first color light may be red light, the second-first color light may be green light, and the third-first color light may be blue light.

The electronic device may further include a thin-film transistor, in addition to the light-emitting device as described above. The thin-film transistor may include a source electrode, a drain electrode, and an activation layer, wherein any one of the source electrode and the drain electrode may be electrically connected to any one of the first electrode and the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

The electronic device may further include a sealing portion for sealing the light-emitting device. The sealing portion may be located between the color filter and/or the color conversion layer and the light-emitting device. The sealing portion allows light from the light-emitting device to be extracted to the outside, and concurrently (e.g., simultaneously) prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin film encapsulation layer, the electronic device may be flexible.

Various functional layers may be additionally located on the sealing portion, in addition to the color filter and/or the color conversion layer, according to the utilize of the electronic device. Examples of the functional layers may include a touch screen layer, a polarizing layer, and/or the like. The touch screen layer may be a pressure-sensitive touch screen layer, a capacitive touch screen layer, or an infrared touch screen layer. The authentication apparatus may be, for example, a biometric authentication apparatus that authenticates an individual by utilizing biometric information of a living body (for example, fingertips, pupils, etc.).

The authentication apparatus may further include, in addition to the light-emitting device as described above, a biometric information collector.

The electronic device may be applied to one or more suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (for example, meters for a vehicle, an aircraft, and a vessel), projectors, and/or the like.

### Electronic apparatus

The light-emitting device may be included in one or more suitable electronic apparatuses.

For example, the electronic apparatus including the light-emitting device may be at least one selected from among a flat panel display, a curved display, a computer monitor, a medical monitor, a television, a billboard, a light for indoor or outdoor lighting and/or signaling, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a 3D display, a virtual or augmented-reality display, a vehicle, a video wall including multiple displays tiled together, a theater or stadium screen, a phototherapy device, and a signboard.

The light-emitting device may have excellent or suitable effects in terms of luminescence efficiency long lifespan, and thus the electronic apparatus including the light-emitting device may have characteristics, such as high luminance, high resolution, and low power consumption.

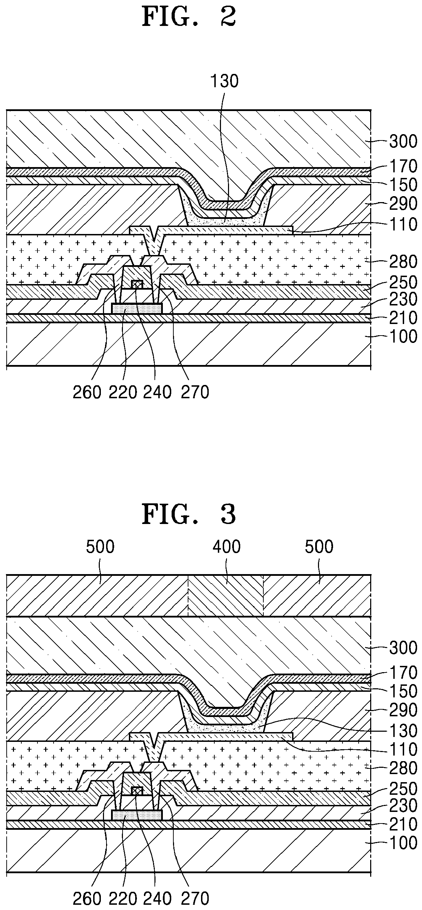

### Description of FIGS. 2 and 3

FIG. 2 is a cross-sectional view of a light-emitting device, which is one of electronic devices according to an embodiment.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be located on the substrate 100. The buffer layer 210 may prevent or reduce penetration of impurities through the substrate 100 and may provide a flat surface on the substrate 100.

A TFT may be located on the buffer layer 210. The TFT may include an activation layer 220, a gate electrode 240, a source electrode 260, and a drain electrode 270.

The activation layer 220 may include an inorganic semiconductor such as silicon or polysilicon, an organic semiconductor, or an oxide semiconductor, and may include a source region, a drain region, and a channel region.

A gate insulating film 230 for insulating the activation layer 220 from the gate electrode 240 may be located on the activation layer 220, and the gate electrode 240 may be located on the gate insulating film 230.

An interlayer insulating film 250 may be located on the gate electrode 240. The interlayer insulating film 250 may be located between the gate electrode 240 and the source electrode 260 and between the gate electrode 240 and the drain electrode 270, to insulate from one another.

The source electrode 260 and the drain electrode 270 may be located on the interlayer insulating film 250. The interlayer insulating film 250 and the gate insulating film 230 may be formed to expose the source region and the drain region of the activation layer 220, and the source electrode 260 and the drain electrode 270 may be located in contact with the exposed portions of the source region and the drain region of the activation layer 220.

The TFT is electrically connected to a light-emitting device to drive the light-emitting device, and is covered and protected by a passivation layer 280. The passivation layer 280 may include an inorganic insulating film, an organic insulating film, or one or more combinations thereof. A light-emitting device is provided on the passivation layer 280. The light-emitting device may include a first electrode 110, an interlayer 130, and a second electrode 150.

The first electrode 110 may be located on the passivation layer 280. The passivation layer 280 may be located to expose a portion of the drain electrode 270, not fully covering the drain electrode 270, and the first electrode 110 may be located to be connected to the exposed portion of the drain electrode 270.

A pixel defining layer 290 including an insulating material may be located on the first electrode 110. The pixel defining layer 290 may expose a certain region of the first electrode 110, and an interlayer 130 may be formed in the exposed region of the first electrode 110. The pixel defining layer 290 may be a polyimide or polyacrylic organic film. In some embodiments, at least some layers of the interlayer 130 may extend beyond the upper portion of the pixel defining layer 290 to be located in the form of a common layer.

A second electrode 150 may be located on the interlayer 130, and a second capping layer 170 may be additionally formed on the second electrode 150. The second capping layer 170 may be formed to cover the second electrode 150.

The encapsulation portion 300 may be located on the second capping layer 170. The encapsulation portion 300 may be located on a light-emitting device to protect the light-emitting device from moisture or oxygen. The encapsulation portion 300 may include: an inorganic film including silicon nitride (SiNx), silicon oxide (SiOx), indium tin oxide, indium zinc oxide, or one or more combinations thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or one or more combinations thereof; or one or more combinations of the inorganic film(s) and the organic film(s).

FIG. 3 is a cross-sectional view of a light-emitting device, which is one of electronic devices according to an embodiment.

The light-emitting apparatus of FIG. 3 is the same as the light-emitting apparatus of FIG. 2, except that a light-shielding pattern 500 and a functional region 400 are additionally located on the encapsulation portion 300. The functional region 400 may be i) a color filter area, ii) a color conversion area, or iii) a combination of the color filter area and the color conversion area. In an embodiment, the light-emitting device included in the light-emitting apparatus of FIG. 3 may be a tandem light-emitting device.

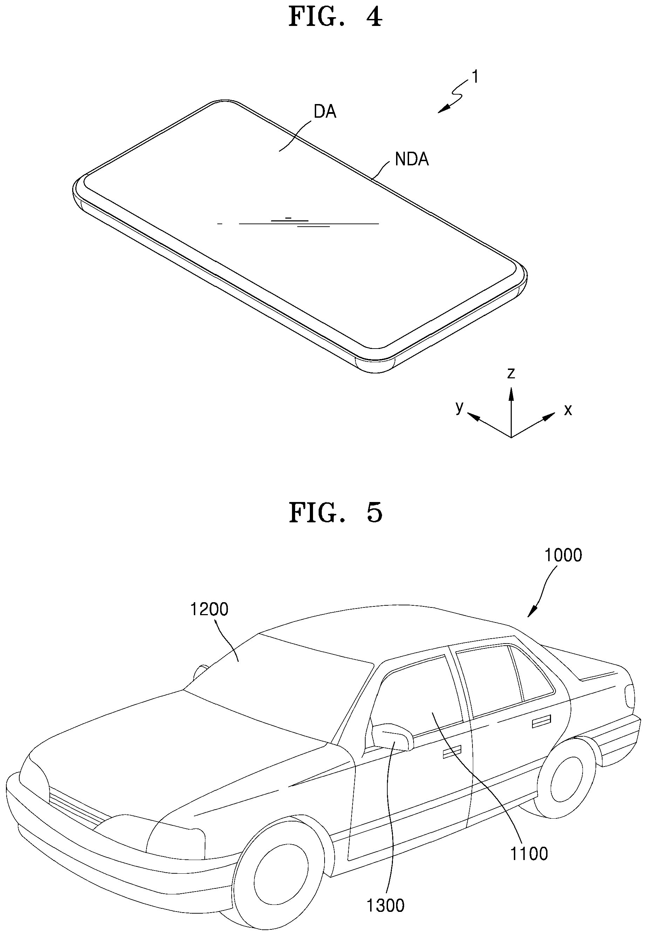

### Description of FIG. 4

FIG. 4 is a schematic perspective view of an electronic apparatus 1 including a light-emitting device according to an embodiment. The electronic apparatus 1 may be, as a device apparatus, that displays a moving image or still image, a portable electronic apparatus, such as a mobile phone, a smart phone, a tablet personal computer (PC), a mobile communication terminal, an electronic notebook, an electronic book, a portable multimedia player (PMP), a navigation, or a ultra mobile PC (UMPC) as well as one or more suitable products, such as a television, a laptop, a monitor, billboard(s) or Internet of thing(s) (IOT). The electronic apparatus 1 may be such a product above or a part thereof. In some embodiments, the electronic apparatus 1 may be a wearable device, such as a smart watch, a watch phone, a glasses-type or kind display, or a head mounted display (HMD), or a part of the wearable device. However, embodiments of the disclosure are not limited thereto. For example, the electronic apparatus 1 may be a center information display (CID) on an instrument panel and a center fascia or dashboard of a vehicle, a room mirror display instead of a side mirror of a vehicle, an entertainment display for the rear seat of a car or a display placed on the back of the front seat, head up display (HUD) installed in front of a vehicle or projected on a front window glass, or a computer generated hologram augmented reality head up display (CGH AR HUD). FIG. 4 illustrates a case in which the electronic apparatus 1 is a smartphone for convenience of explanation.

The electronic apparatus 1 may include a display area DA and a non-display area NDA outside the display area DA. A display device may implement an image through an array of a plurality of pixels that are two-dimensionally arranged in the display area DA.

The non-display area NDA is an area that does not display an image, and may entirely surround the display area DA. On the non-display area NDA, a driver for providing electrical signals or power to display devices arranged on the display area DA may be arranged. On the non-display area NDA, a pad, which is an area to which an electronic element or a printing circuit board may be electrically connected, may be arranged.

In the electronic apparatus 1, a length in the x-axis direction and a length in the y-axis direction may be different from each other. For example, as shown in FIG. 4, the length in the x-axis direction may be shorter than the length in the y-axis direction. In one or more embodiments, the length in the x-axis direction may be the same as the length in the y-axis direction. In one or more embodiments, the length in the x-axis direction may be longer than the length in the y-axis direction.

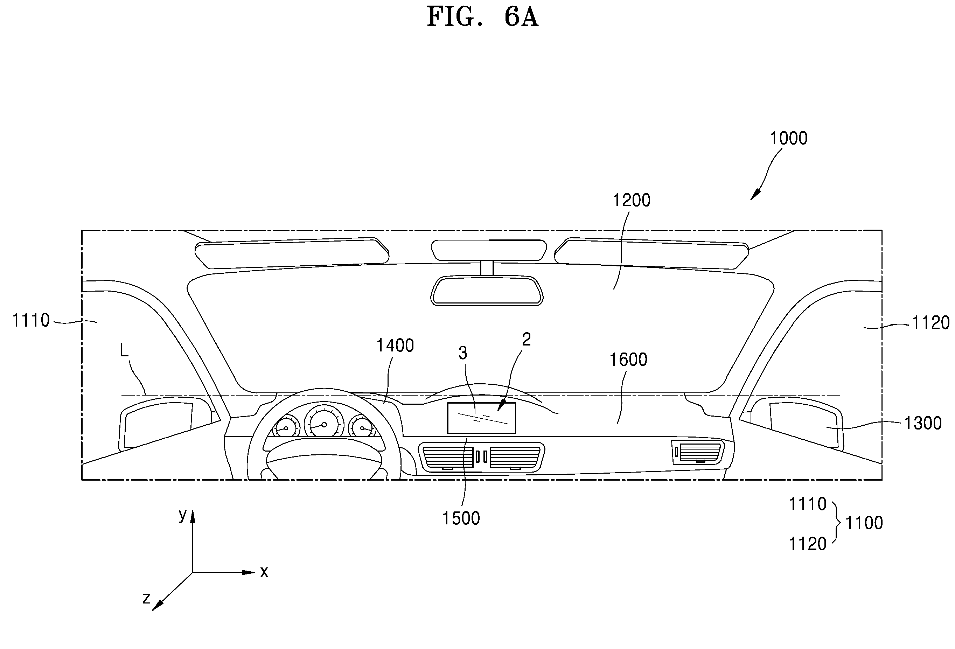

### Descriptions of FIGS. 5 and 6A to 6C

FIG. 5 is a diagram illustrating the exterior of a vehicle 1000 as an electronic apparatus including a light-emitting device according to an embodiment. FIGS. 6A to 6C are each a diagram schematically illustrating the interior of a vehicle 1000 according to one or more suitable embodiments of the disclosure.

Referring to FIGS. 5 and 6A to 6C, the vehicle 1000 may refer to one or more suitable apparatuses for moving a subject object to be transported, such as a human, an object, or an animal, from a departure point to a destination. The vehicle 1000 may include a vehicle traveling on a road or track, a vessel moving over a sea or river, an airplane flying in the sky utilizing the action of air, and/or the like.

The vehicle 1000 may travel on a road or a track. The vehicle 1000 may move in a set or predetermined direction according to the rotation of at least one wheel. For example, the vehicle 1000 may include a three-wheeled or four-wheeled vehicle, a construction machine, a two-wheeled vehicle, a prime mover device, a bicycle, and/or a train running on a track.

The vehicle 1000 may include a body having an interior and an exterior, and a chassis in which mechanical apparatuses necessary for driving are installed as other parts except for the body. The exterior of the vehicle body may include a front panel, a bonnet, a roof panel, a rear panel, a trunk, a filler provided at a boundary between doors, and/or the like. The chassis of the vehicle 1000 may include a power generating device, a power transmitting device, a driving device, a steering device, a braking device, a suspension device, a transmission device, a fuel device, front and rear wheels, left and right wheels, and/or the like.

The vehicle 1000 may include a side window glass 1100, a front window glass 1200, a side mirror 1300, a cluster 1400, a center fascia 1500, a passenger seat dashboard 1600, and a display device 2.

The side window glass 1100 and the front window glass 1200 may be partitioned by a filler arranged between the side window glass 1100 and the front window glass 1200.

The side window glass 1100 may be installed on the side of the vehicle 1000. In an embodiment, the side window glass 1100 may be installed on a door of the vehicle 1000. A plurality of side window glasses 1100 may be provided and may face each other. In an embodiment, the side window glass 1100 may include a first side window glass 1110 and a second side window glass 1120. In an embodiment, the first side window glass 1110 may be arranged adjacent to the cluster 1400. The second side window glass 1120 may be arranged adjacent to the passenger seat dashboard 1600.

In an embodiment, the side window glasses 1100 may be spaced apart from each other in the x-direction or the -x-direction. For example, the first side window glass 1110 and the second side window glass 1120 may be spaced apart from each other in the x direction or the -x direction. In other words, an imaginary straight line L connecting the side window glasses 1100 may extend in the x-direction or the -x-direction. For example, an imaginary straight line L connecting the first side window glass 1110 and the second side window glass 1120 to each other may extend in the x direction or the -x direction.

The front window glass 1200 may be installed in the front of the vehicle 1000. The front window glass 1200 may be arranged between the side window glasses 1100 facing each other.

The side mirror 1300 may provide a rear view of the vehicle 1000. The side mirror 1300 may be installed on the exterior of the vehicle body. In one embodiment, a plurality of side mirrors 1300 may be provided. Any one of the plurality of side mirrors 1300 may be arranged outside the first side window glass 1110. The other one of the plurality of side mirrors 1300 may be arranged outside the second side window glass 1120.

The cluster 1400 may be arranged in front of the steering wheel. The cluster 1400 may include a tachometer, a speedometer, a coolant thermometer, a fuel gauge turn indicator, a high beam indicator, a warning lamp, a seat belt warning lamp, an odometer, a hodometer, an automatic shift selector indicator lamp, a door open warning lamp, an engine oil warning lamp, and/or a low fuel warning light.

The center fascia 1500 may include a control panel on which a plurality of buttons for adjusting an audio device, an air conditioning device, and a heater of a seat are disposed. The center fascia 1500 may be arranged on one side of the cluster 1400.

A passenger seat dashboard 1600 may be spaced apart from the cluster 1400 with the center fascia 1500 arranged therebetween. In an embodiment, the cluster 1400 may be arranged to correspond to a driver seat, and the passenger seat dashboard 1600 may be disposed to correspond to a passenger seat. In an embodiment, the cluster 1400 may be adjacent to the first side window glass 1110, and the passenger seat dashboard 1600 may be adjacent to the second side window glass 1120.

In an embodiment, the display device 2 may include a display panel 3, and the display panel 3 may display an image. The display device 2 may be arranged inside the vehicle 1000. In an embodiment, the display device 2 may be arranged between the side window glasses 1100 facing each other. The display device 2 may be arranged on at least one of the cluster 1400, the center fascia 1500, and/or the passenger seat dashboard 1600.

The display device 2 may include an organic light-emitting display device, an inorganic electroluminescent (EL) display device, a quantum dot display device, and/or the like. Hereinafter, as the display device 2 according to an embodiment, an organic light-emitting display device display including the light-emitting device according to the disclosure will be described as an example, but one or more suitable types (kinds) of display devices as described above may be utilized in embodiments of the disclosure.

Referring to FIG. 6A, the display device 2 may be arranged on the center fascia 1500. In an embodiment, the display device 2 may display navigation information. In an embodiment, the display device 2 may display audio, video, or information regarding vehicle setting(s).

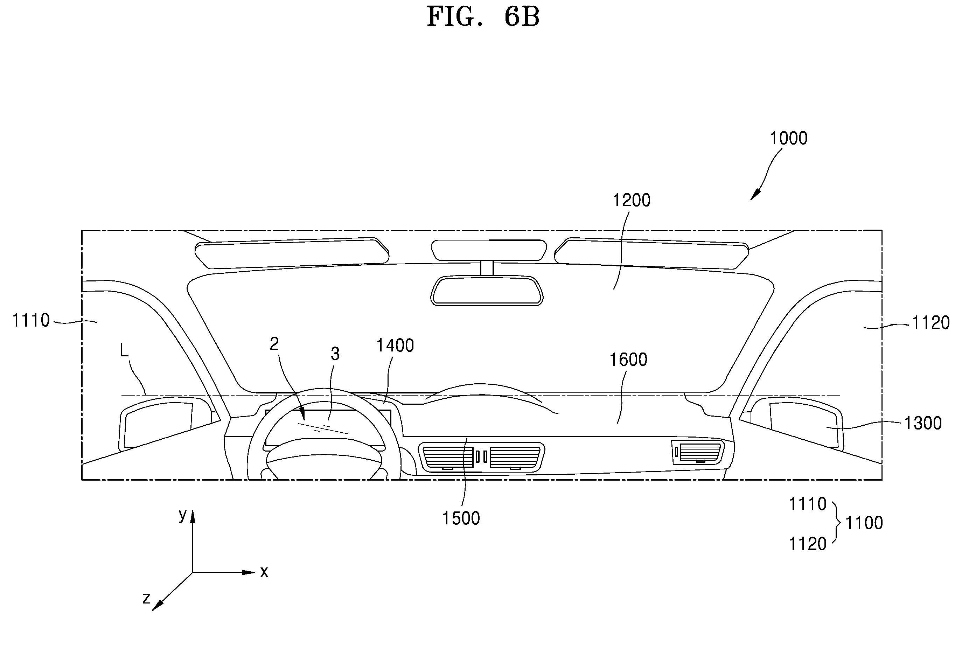

Referring to FIG. 6B, the display device 2 may be arranged on the cluster 1400. When the display device 2 is arranged on the cluster 1400, the cluster 1400 may display driving information and/or the like through the display device 2. For example, the cluster 1400 may be implemented digitally. The digital cluster 1400 may display vehicle information and driving information as images. For example, a needle and a gauge of a tachometer and one or more suitable warning light icons may be displayed by a digital signal.

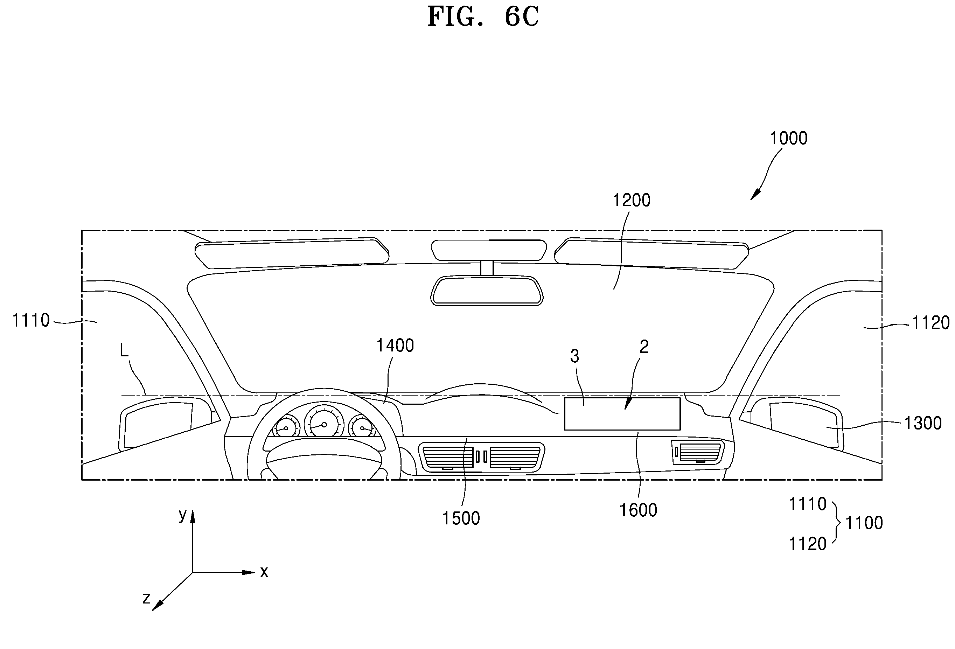

Referring to FIG. 6C, the display device 2 may be arranged on the dashboard 1600 of the passenger seat. The display device 2 may be embedded in the passenger seat dashboard 1600 or arranged on the passenger seat dashboard 1600. In an embodiment, the display device 2 arranged on the dashboard 1600 for the passenger seat may display an image related to information displayed on the cluster 1400 and/or information displayed on the center fascia 1500. In one or more embodiments, the display device 2 arranged on the passenger seat dashboard 1600 may display information different from information displayed on the cluster 1400 and/or information displayed on the center fascia 1500.

### Manufacturing method

Respective layers included in the hole transport region, the emission layer, and respective layers included in the electron transport region may be formed in a certain region by utilizing one or more suitable methods selected from vacuum deposition, spin coating, casting, Langmuir-Blodgett (LB) deposition, ink-jet printing, laser-printing, and laser-induced thermal imaging.

When layers constituting the hole transport region, an emission layer, and layers constituting the electron transport region are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed.

### Definition of Terms

The term "C₃-C₆₀ carbocyclic group" as utilized herein refers to a cyclic group consisting of carbon only as a ring-forming atom and having three to sixty carbon atoms, and the term "C₁-C₆₀ heterocyclic group" as utilized herein refers to a cyclic group that has one to sixty carbon atoms and further has, in addition to carbon, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. For example, the C₁-C₆₀ heterocyclic group has 3 to 61 ring-forming atoms.

The "cyclic group" as utilized herein may include the C₃-C₆₀ carbocyclic group, and the C₁-C₆₀ heterocyclic group.

The term "π electron-rich C₃-C₆₀ cyclic group" as utilized herein refers to a cyclic group that has three to sixty carbon atoms and does not include *-N=*' as a ring-forming moiety, and the term "π electron-deficient nitrogen-containing C₁-C₆₀ cyclic group" as utilized herein refers to a heterocyclic group that has one to sixty carbon atoms and includes *-N=*' as a ring-forming moiety.

For example,
the C₃-C₆₀ carbocyclic group may be i) group T1 or ii) a condensed cyclic group in which two or more groups T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) group T2, ii) a condensed cyclic group in which two or more groups T2 are condensed with each other, or iii) a condensed cyclic group in which at least one group T2 and at least one group T1 are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) group T1, ii) a condensed cyclic group in which two or more groups T1 are condensed with each other, iii) group T3, iv) a condensed cyclic group in which two or more groups T3 are condensed with each other, or v) a condensed cyclic group in which at least one group T3 and at least one group T1 are condensed with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),
the π electron-deficient nitrogen-containing C₁-C₆₀ cyclic group may be i) group T4, ii) a condensed cyclic group in which two or more groups T4 are condensed with each other, iii) a condensed cyclic group in which at least one group T4 and at least one group T1 are condensed with each other, iv) a condensed cyclic group in which at least one group T4 and at least one group T3 are condensed with each other, or v) a condensed cyclic group in which at least one group T4, at least one group T1, and at least one group T3 are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,
group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
group T3 may be a furan group, a thiophene group, a 1H-pyrrole group, a silole group, or a borole group, and
group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the C₃-C₆₀ carbocyclic group, the C₁-C₆₀ heterocyclic group, the π electron-rich C₃-C₆₀ cyclic group, or the π electron-deficient nitrogen-containing C₁-C₆₀ cyclic group" as utilized herein refer to a group condensed to any cyclic group, a monovalent group, or a polyvalent group (for example, a divalent group, a trivalent group, a tetravalent group, etc.) according to the structure of a formula for which the corresponding term is utilized. For example, the "benzene group" may be a benzo group, a phenyl group, a phenylene group, and/or the like, which may be easily understood by one of ordinary skill in the art according to the structure of a formula including the "benzene group."

Examples of the monovalent C₃-C₆₀ carbocyclic group and the monovalent C₁-C₆₀ heterocyclic group are a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of the divalent C₃-C₆₀ carbocyclic group and the monovalent C₁-C₆₀ heterocyclic group are a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as utilized herein refers to a linear or branched aliphatic hydrocarbon monovalent group that has one to sixty carbon atoms, and specific examples thereof are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as utilized herein refers to a divalent group having the same structure as the C₁-C₆₀ alkyl group.

The term "C₂-C₆₀ alkenyl group" as utilized herein refers to a monovalent hydrocarbon group having at least one carbon-carbon double bond in the middle or at the terminus of the C₂-C₆₀ alkyl group, and examples thereof are an ethenyl group, a propenyl group, and a butenyl group. The term "C₂-C₆₀ alkenylene group" as utilized herein refers to a divalent group having the same structure as the C₂-C₆₀ alkenyl group.

The term "C₂-C₆₀ alkynyl group" as utilized herein refers to a monovalent hydrocarbon group having at least one carbon-carbon triple bond in the middle or at the terminus of the C₂-C₆₀ alkyl group, and examples thereof include an ethynyl group and a propynyl group. The term "C₂-C₆₀ alkynylene group" as utilized herein refers to a divalent group having the same structure as the C₂-C₆₀ alkynyl group.

The term "C₁-C₆₀ alkoxy group" as utilized herein refers to a monovalent group represented by -OA₁₀₁ (wherein A₁₀₁ is the C₁-C₆₀ alkyl group), and examples thereof include a methoxy group, an ethoxy group, and an isopropyloxy group.

The term "C₃-C₁₀ cycloalkyl group" as utilized herein refers to a monovalent saturated hydrocarbon cyclic group having 3 to 10 carbon atoms, and examples thereof are a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and a bicyclo[2.2.2]octyl group. The term "C₃-C₁₀ cycloalkylene group" as utilized herein refers to a divalent group having the same structure as the C₃-C₁₀ cycloalkyl group.

The term "C₁-C₁₀ heterocycloalkyl group" as utilized herein refers to a monovalent cyclic group of 1 to 10 carbon atoms, further including, in addition to carbon atoms, at least one heteroatom, as ring-forming atoms, and specific examples are a 1,2,3,4-oxatriazolidinyl group, a tetrahydrofuranyl group, and a tetrahydrothiophenyl group. The term "C₁-C₁₀ heterocycloalkylene group" as utilized herein refers to a divalent group having the same structure as the C₁-C₁₀ heterocycloalkyl group.

The term C₃-C₁₀ cycloalkenyl group utilized herein refers to a monovalent cyclic group that has three to ten carbon atoms and at least one carbon-carbon double bond in the ring thereof and no aromaticity, and specific examples thereof are a cyclopentenyl group, a cyclohexenyl group, and a cycloheptenyl group. The term "C₃-C₁₀ cycloalkenylene group" as utilized herein refers to a divalent group having the same structure as the C₃-C₁₀ cycloalkenyl group.

The term "C₁-C₁₀ heterocycloalkenyl group" as utilized herein refers to a monovalent cyclic group of 1 to 10 carbon atoms, further including, in addition to carbon atoms, at least one heteroatom, as ring-forming atoms, and having at least one carbon-carbon double bond in the cyclic structure thereof. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as utilized herein refers to a divalent group having the same structure as the C₁-C₁₀ heterocycloalkenyl group.

The term "C₆-C₆₀ aryl group" as utilized herein refers to a monovalent group having a carbocyclic aromatic system of 6 to 60 carbon atoms, and the term "C₆-C₆₀ arylene group" as utilized herein refers to a divalent group having a carbocyclic aromatic system of 6 to 60 carbon atoms. Examples of the C₆-C₆₀ aryl group are a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each include two or more rings, the rings may be condensed with each other.

The term "C₁-C₆₀ heteroaryl group" as utilized herein refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group" as utilized herein refers to a divalent group having a heterocyclic aromatic system of 1 to 60 carbon atoms, further including, in addition to carbon atoms, at least one heteroatom, as ring-forming atoms. Examples of the C₁-C₆₀ heteroaryl group are a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the rings may be condensed with each other.

The term "monovalent non-aromatic condensed polycyclic group" as utilized herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group are an indenyl group, a fluorenyl group, a spiro-bifluorenyl group, a benzofluorenyl group, an indenophenanthrenyl group, and an indeno anthracenyl group. The term "divalent or polyvalent non-aromatic condensed polycyclic group" as utilized herein refers to a divalent or polyvalent group having the same structure as the monovalent non-aromatic condensed polycyclic group described above.

The term "monovalent non-aromatic condensed heteropolycyclic group" as utilized herein refers to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure. Examples of the monovalent non-aromatic condensed heteropolycyclic group are a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphtho silolyl group, a benzofurodibenzofuranyl group, a benzofurodibenzothiophenyl group, and a benzothienodibenzothiophenyl group. The term "divalent or polyvalent non-aromatic condensed heteropolycyclic group" as utilized herein refers to a divalent or polyvalent group having the same structure as the monovalent non-aromatic condensed heteropolycyclic group described above.

The term "C₆-C₆₀ aryloxy group" as utilized herein indicates -OA₁₀₂ (wherein A₁₀₂ is the C₆-C₆₀ aryl group), and the term "C₆-C₆₀ arylthio group" as utilized herein indicates -SA₁₀₃ (wherein A₁₀₃ is the C₆-C₆₀ aryl group).

The term "C₇-C₆₀ aryl alkyl group" utilized herein refers to -A₁₀₄A₁₀₅ (where A₁₀₄ may be a C₁-C₅₄ alkylene group, and A₁₀₅ may be a C₆-C₅₉ aryl group), and the term C₂-C₆₀ heteroaryl alkyl group" utilized herein refers to -A₁₀₆A₁₀₇ (where A₁₀₆ may be a C₁-C₅₉ alkylene group, and A₁₀₇ may be a C₁-C₅₉ heteroaryl group).

The term "R₁₀ₐ" as utilized herein refers to:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂), or one or more combinations thereof;
a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), -P(=O)(Q₂₁)(Q₂₂), or one or more combinations thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
Q₁ to Q₃, Q₁₁ to Q₁₃, Q₂₁ to Q₂₃, and Q₃₁ to Q₃₃ utilized herein may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or a combination thereof.

The term "heteroatom" as utilized herein refers to any atom other than a carbon atom. Examples of the heteroatom are O, S, N, P, Si, B, Ge, Se, and one or more combinations thereof.

The term "third-row transition metal" utilized herein includes hafnium (Hf), tantalum (Ta), tungsten (W), rhenium (Re), osmium (Os), iridium (Ir), platinum (Pt), gold (Au), and/or the like.

"Ph" as utilized herein refers to a phenyl group, "Me" as utilized herein refers to a methyl group, "Et" as utilized herein refers to an ethyl group, "ter-Bu" or "Bu^{t}" as utilized herein refers to a tert-butyl group, and "OMe" as utilized herein refers to a methoxy group.

The term "biphenyl group" as utilized herein refers to "a phenyl group substituted with a phenyl group." In other words, the "biphenyl group" is a substituted phenyl group having a C₆-C₆₀ aryl group as a substituent.

The term "terphenyl group" as utilized herein refers to "a phenyl group substituted with a biphenyl group". In other words, the "terphenyl group" is a substituted phenyl group having, as a substituent, a C₆-C₆₀ aryl group substituted with a C₆-C₆₀ aryl group.

* and *' as utilized herein, unless defined otherwise, each refer to a binding site to a neighboring atom in a corresponding formula or moiety.

Hereinafter, a light-emitting device according to embodiments will be described in more detail with reference to Examples.

### Examples

### Evaluation Example 1

HOMO energy level (eV), LUMO energy level (eV), band gap (eV), and ³MLCT (% ) of each of PD01, PD02, PD03, PD04, PD06, PD08, B01, B02, and B03 were evaluated utilizing the method shown in Table 1, and results thereof are shown in Table 2.

**Table 1**

| | |
|---|---|
| HOMO energy level evaluation method | By utilizing cyclic voltammetry (CV) (electrolyte: 0.1 M Bu₄NPF₆ / solvent: dimethylforamide (DMF) / electrode: 3-electrode system (working electrode: GC, reference electrode: Ag/AgCl, and auxiliary electrode: Pt)), the potential (V)-current (A) graph of each compound was obtained, and then, from the oxidation onset of the graph, the HOMO energy level of each compound was calculated. |
| LUMO energy level evaluation method | By utilizing cyclic voltammetry (CV) (electrolyte: 0.1 M Bu₄NPF₆ / solvent: dimethylforamide (DMF) / electrode: 3-electrode system (working electrode: GC, reference electrode: Ag/AgCl, and auxiliary electrode: Pt)), the potential (V)-current (A) graph of each compound was obtained, and then, from the reduction onset of the graph, the LUMO energy level of each compound was calculated. |
| Band gap evaluation method | The absolute value of the difference between HOMO energy level and LUMO energy level was calculated |
| Method for evaluating triplet metal-to-ligand charge transfer state (³MLCT) during total intramolecular charge transfer | For each compound, quantum chemical calculation is performed utilizing Gaussian 09, a quantum chemical calculation program manufactured by Gaussian, USA (B3LYP is utilized for optimization of the ground state structure, and 6-311G (d, p) is utilized as a function) |

**Table 2**

| | HOMO Energy level (eV) | LUMO Energy level (eV) | Band gap (eV) | ³MLCT (%) |
|---|---|---|---|---|
| PD01 | -4.98 | -2.48 | 2.50 | 15.33 |
| PD02 | -5.20 | -2.55 | 2.65 | 11.01 |
| PD03 | -4.98 | -1.66 | 3.32 | 9.96 |
| PD04 | -4.84 | -2.35 | 2.45 | 14.57 |
| PD06 | -4.85 | -2.35 | 2.52 | 12.74 |
| PD08 | -4.98 | -2.14 | 2.84 | 10.31 |
| B01 | -5.05 | -1.98 | 3.07 | 5.91 |
| B02 | -5.06 | -1.89 | 3.17 | -2.11 |
| B03 | -4.95 | -1.90 | 3.05 | 0.29 |

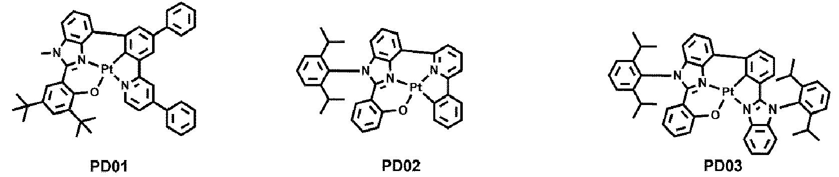

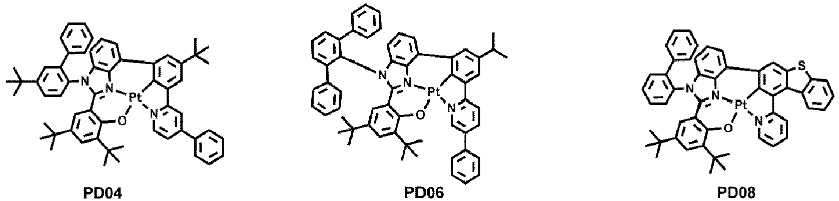

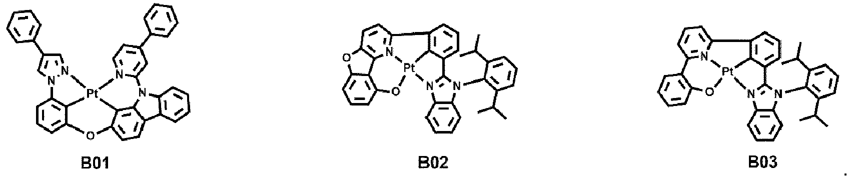

From Table 2, it can be confirmed that the ³MLCT of the compounds PD01, PD02, PD03, PD04, PD06 and PD08 is 9 % or more.

### Evaluation Example 2

PMMA in CH₂Cl₂ solution and compound PD01 (4 wt% compared to PMMA) were mixed, and then, the result obtained therefrom was coated on a quartz substrate utilizing a spin coater, and then heat-treated in an oven at 80 °C and cooled to room temperature, thereby obtaining a 40 nm-thick film PD01. Subsequently, the film PD02, PD03, PD04, PD06, PD08, B01, B02, and B03 were prepared in substantially the same manner as utilized to prepare the film PD01, except that each of the compounds PD02, PD03, PD04, PD06, PD08, B01, B02 and B03 was utilized instead of the compound PD01.

The emission spectrum of each of the films PD01, PD02, PD03, PD04, PD06, PD08, B01, B02 and B03 was measured utilizing a Hamamatsu's Quantaurus-QY Absolute PL quantum yield spectrometer (provided with a xenon light source, a monochromator, a photonic multichannel analyzer, and an integrating sphere, and utilizing PLQY measurement software (Hamamatsu Photonics, Ltd., Shizuoka, Japan). During measurement, the excitation wavelength was scanned from 320 nm to 380 nm at 10 nm intervals, and the spectrum measured at the excitation wavelength of 340 nm was utilized to obtain the maximum emission wavelength (emission peak wavelength) and FWHM of the compound included in each film. Results thereof are summarized in Table 3.

**Table 3**

| Film no. | Compound included in film (4 wt% in PMMA) | Maximum emission wavelength (nm) | Emission FWHM (nm) |
|---|---|---|---|
| PD01 | PD01 | 522 | 32 |
| PD02 | PD02 | 556 | 25 |
| PD03 | PD03 | 511 | 26 |
| PD04 | PD04 | 516 | 53 |
| PD06 | PD06 | 534 | 60 |
| PD08 | PD08 | 604 | 41 |
| B01 | B01 | 496 | 90 |
| B02 | B02 | 524 | 55 |
| B03 | B03 | 522 | 31 |

### Evaluation Example 3

The HOMO energy level and LUMO energy level of each of the compounds ET-1 to ET-6 and PET-1 to PET-6 were evaluated in the method shown in Table 1, and results thereof are shown in Table 4.

The hole mobility and electron mobility of each of the compounds ET-1 to ET-6 and PET-1 to PET-6 were evaluated utilizing the space-charge-limited current (SCLC) described in "Hole mobility of N,N'-bis(naphtanlen-1-yl)-N,N'-bis(phenyl)benzidine investigated by utilizing space-charge-limited currents, 'Appl. Phys. Lett. 90, 203512 (2007)", and results obtained therefrom are shown in Table 4.

**Table 4**

| | HOMO Energy level (eV) | LUMO Energy level (eV) | Band gap (eV) | Hole mobility (cm²/Vs) | Electron mobility (cm²/Vs) |
|---|---|---|---|---|---|
| ET-1 | -6.01 | -2.67 | 3.34 | 2.44 x 10⁻⁴ | 1.16 x 10⁻³ |
| ET-2 | -5.98 | -2.69 | 3.29 | 2.70 x 10⁻⁴ | 8.16 x 10⁻⁴ |
| ET-3 | -5.94 | -2.79 | 3.15 | 1.40 x 10⁻⁴ | 3.45 x 10⁻⁴ |
| ET-4 | -5.82 | -2.67 | 3.15 | 1.90 x 10⁻⁴ | 1.56 x 10⁻⁴ |
| ET-5 | -5.86 | -2.68 | 3.18 | 8.88 x 10⁻⁵ | 3.71 x 10⁻⁴ |
| ET-6 | -6.07 | -2.81 | 3.26 | 2.40 x 10⁻⁵ | 2.41 x 10⁻⁴ |
| PET-1 | -5.35 | -2.50 | 2.85 | 1.31 x 10⁻³ | 1.07 x 10⁻³ |
| PET-2 | -6.10 | -2.57 | 3.53 | 5.34 x 10⁻⁴ | 1.00 x 10⁻³ |
| PET-3 | -5.93 | -2.57 | 3.36 | 3.32 x 10⁻⁴ | 5.88 x 10⁻⁴ |
| PET-4 | -5.95 | -2.13 | 3.82 | 1.97 x 10⁻⁴ | 2.40 x 10⁻³ |
| PET-5 | -5.62 | -2.28 | 3.34 | 4.48 x 10⁻⁵ | 5.91 x 10⁻⁵ |
| PET-6 | -5.73 | -2.23 | 3.50 | 2.73 x 10⁻⁶ | 1.49 x 10⁻⁴ |

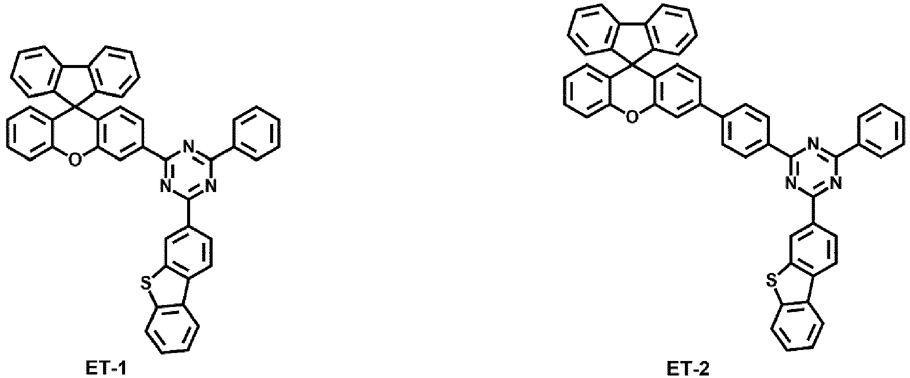

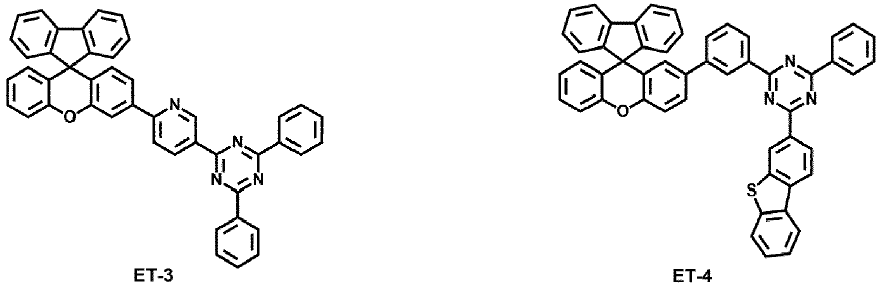

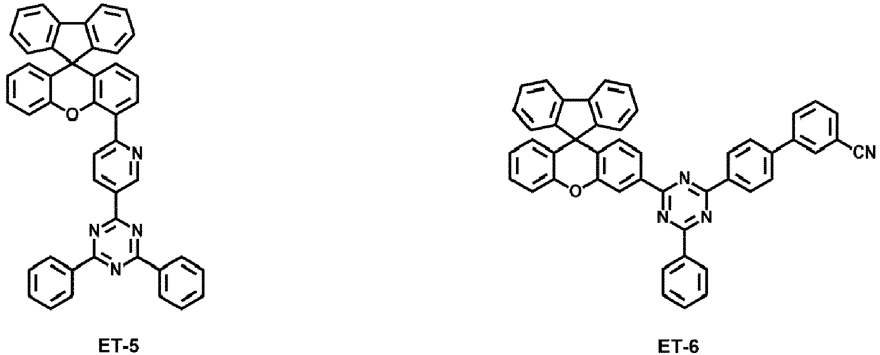

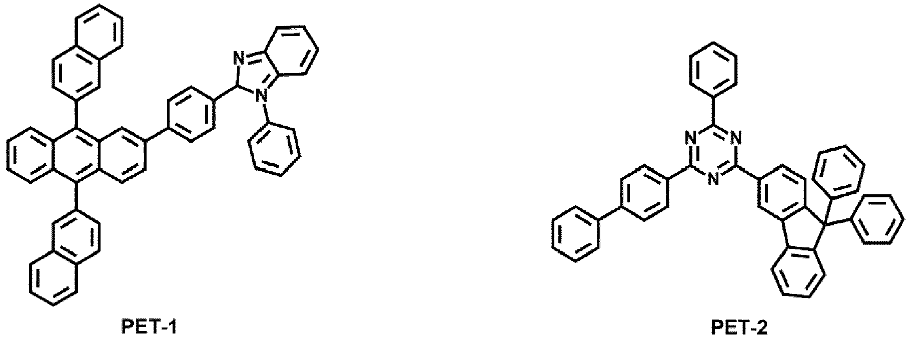

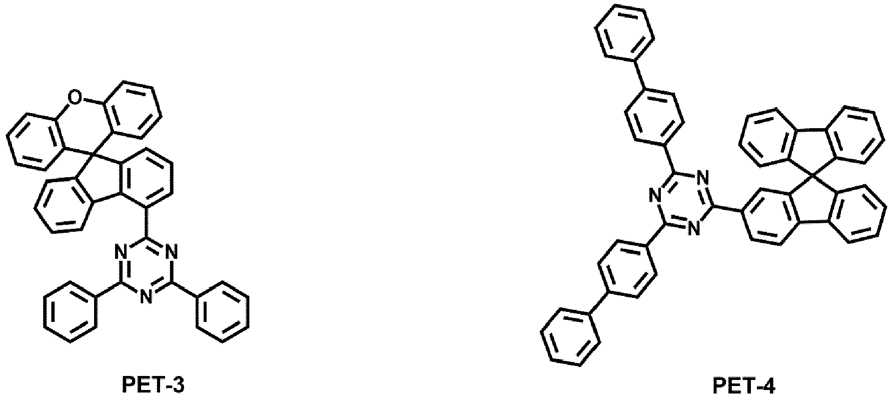

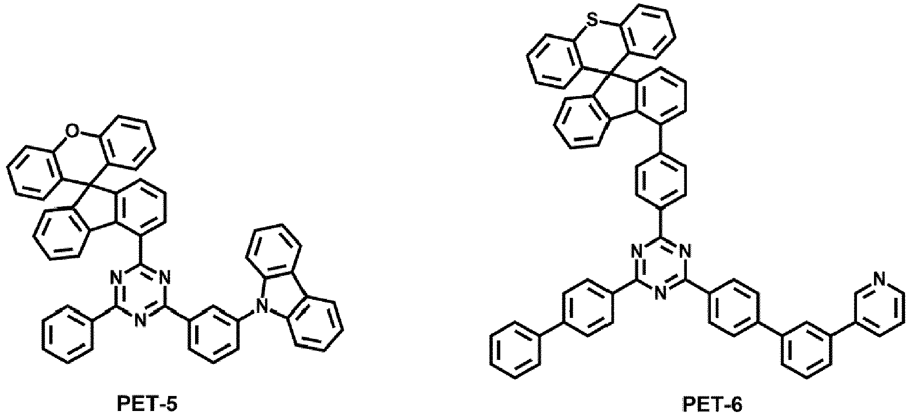

### Example 1

A glass substrate (product of Corning Inc.) with a 15 Ω/cm² (1,200 Å) ITO formed thereon as an anode was cut to a size of 50 mm × 50 mm × 0.7 mm, sonicated utilizing isopropyl alcohol and pure water each for 5 minutes, washed (cleaned) by irradiation of ultraviolet rays and exposure of ozone thereto for 30 minutes, and then mounted on a vacuum deposition apparatus.

HT3 was vacuum-deposited on the ITO anode to form a hole transport layer having a thickness of 600 Å, and HT40 was vacuum-deposited on the hole transport layer to form an emission auxiliary layer having a thickness of 250 Å.

Compound H125, Compound H126, and Compound PD01 (first emitter) were vacuum-deposited on the emission auxiliary layer at the weight ratio of 45 : 45 : 10 to form an emission layer having a thickness of 300 Å.

The compound ET37 was vacuum-deposited on the emission layer to form a hole-blocking layer with a thickness of 50 Å, and ET-1 and LiQ were vacuum-deposited at a weight ratio of 5: 5 on the hole-blocking layer to form an electron transport layer with a thickness of 310 Å. Subsequently, Yb was vacuum-deposited on the electron transport layer to form an electron injection layer with a thickness of 15 Å, and then Ag and Mg were vacuum-deposited to form a cathode with a thickness of 100 Å, thereby completing the manufacture of an organic light-emitting device.

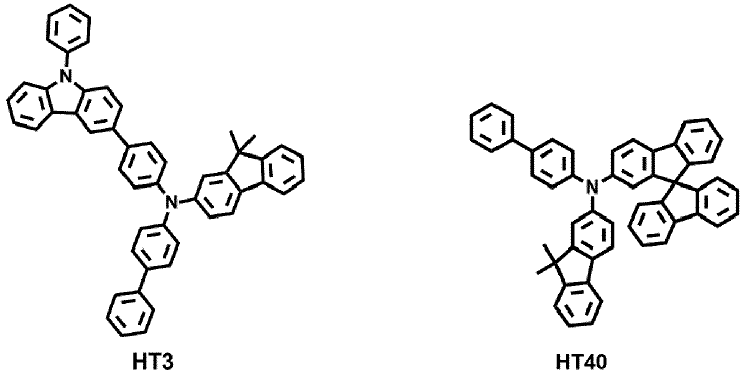

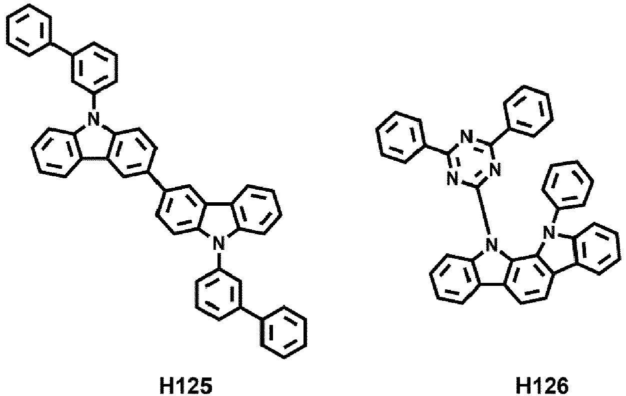

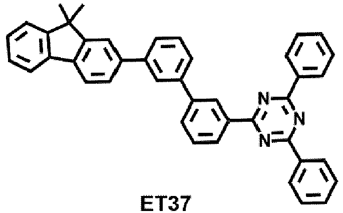

### Other Examples and Comparative Examples

The organic light-emitting devices of Examples and Comparative Examples listed in Tables 5 to 10 were manufactured in substantially the same manner as in Example 1, except that the compounds shown in Tables 5 to 10 were utilized instead of PD01 in the emission layer and/or ET-1 in the electron transport layer.

### Evaluation Example 4

The driving voltage (V), maximum power efficiency (cd/W) and color coordinates (CIE x and CIE y) of the organic light-emitting devices manufactured according to Examples and Comparative Examples utilizing materials for the first emitter and the electron transport layer, were measured by utilizing a Keithley MU 236 and a luminance meter PR650, and results thereof are shown in Tables 5 to 10.

**Table 5**

| | First emitter | Material for electron transport layer | Driving voltage (V) at 1000 cd/m² | Maximum power efficiency (cd/W) | CIE x | CIE y |
|---|---|---|---|---|---|---|
| Example 1 | PD01 | ET-1 | 2.9 | 24.09 | 0.43 | 0.57 |
| Example 2 | PD01 | ET-2 | 2.95 | 23.68 | 0.43 | 0.57 |
| Example 3 | PD01 | ET-3 | 2.75 | 25.38 | 0.43 | 0.57 |
| Example 4 | PD01 | ET-4 | 2.95 | 23.67 | 0.43 | 0.57 |
| Example 5 | PD01 | ET-5 | 2.9 | 24.09 | 0.43 | 0.57 |
| Example 6 | PD01 | ET-6 | 2.8 | 24.94 | 0.43 | 0.57 |
| Comparative Example 1 | PD01 | PET-1 | 3.5 | 19.89 | 0.43 | 0.57 |
| Comparative Example 2 | PD01 | PET-2 | 3.3 | 21.15 | 0.43 | 0.57 |
| Comparative Example 3 | PD01 | PET-3 | 3.3 | 21.17 | 0.43 | 0.57 |
| Comparative Example 4 | PD01 | PET-4 | 3.3 | 21.17 | 0.43 | 0.57 |
| Comparative Example 5 | PD01 | PET-5 | 3.3 | 21.05 | 0.43 | 0.57 |
| Comparative Example 6 | PD01 | PET-6 | 3.3 | 21.14 | 0.43 | 0.57 |
| Comparative Example 37 | B01 | ET-1 | 2.9 | 15.35 | 0.42 | 0.56 |
| Comparative Example 38 | B01 | ET-2 | 2.95 | 15.09 | 0.42 | 0.56 |
| Comparative Example 39 | B01 | ET-3 | 2.75 | 16.17 | 0.42 | 0.56 |
| Comparative Example 40 | B01 | ET-4 | 2.95 | 15.08 | 0.42 | 0.56 |
| Comparative Example 41 | B01 | ET-5 | 2.9 | 15.35 | 0.42 | 0.56 |
| Comparative Example 42 | B01 | ET-6 | 2.8 | 15.89 | 0.42 | 0.56 |
| Comparative Example 43 | B02 | ET-1 | 2.9 | 11.18 | 0.32 | 0.66 |
| Comparative Example 44 | B02 | ET-2 | 2.95 | 10.99 | 0.32 | 0.66 |
| Comparative Example 45 | B02 | ET-3 | 2.75 | 11.77 | 0.32 | 0.66 |
| Comparative Example 46 | B02 | ET-4 | 2.95 | 10.98 | 0.32 | 0.66 |
| Comparative Example 47 | B02 | ET-5 | 2.9 | 11.18 | 0.32 | 0.66 |
| Comparative Example 48 | B02 | ET-6 | 2.8 | 11.57 | 0.32 | 0.66 |
| Comparative Example 49 | B03 | ET-1 | 2.9 | 14.09 | 0.32 | 0.66 |
| Comparative Example 50 | B03 | ET-2 | 2.95 | 13.86 | 0.32 | 0.66 |
| Comparative Example 51 | B03 | ET-3 | 2.75 | 14.85 | 0.32 | 0.66 |
| Comparative Example 52 | B03 | ET-4 | 2.95 | 13.85 | 0.32 | 0.66 |
| Comparative Example 53 | B03 | ET-5 | 2.9 | 14.09 | 0.32 | 0.66 |
| Comparative Example 54 | B03 | ET-6 | 2.8 | 14.59 | 0.32 | 0.66 |
| Comparative Example 55 | B01 | PET-1 | 3.5 | 12.68 | 0.42 | 0.56 |
| Comparative Example 56 | B01 | PET-2 | 3.3 | 13.48 | 0.42 | 0.56 |
| Comparative Example 57 | B01 | PET-3 | 3.3 | 13.49 | 0.42 | 0.56 |
| Comparative Example 58 | B01 | PET-4 | 3.3 | 13.49 | 0.42 | 0.56 |
| Comparative Example 59 | B01 | PET-5 | 3.3 | 13.41 | 0.42 | 0.56 |
| Comparative Example 60 | B01 | PET-6 | 3.3 | 13.47 | 0.42 | 0.56 |
| Comparative Example 61 | B02 | PET-1 | 3.5 | 9.23 | 0.32 | 0.66 |
| Comparative Example 62 | B02 | PET-2 | 3.3 | 9.81 | 0.32 | 0.66 |
| Comparative Example 63 | B02 | PET-3 | 3.3 | 9.82 | 0.32 | 0.66 |
| Comparative Example 64 | B02 | PET-4 | 3.3 | 9.82 | 0.32 | 0.66 |
| Comparative Example 65 | B02 | PET-5 | 3.3 | 9.77 | 0.32 | 0.66 |
| Comparative Example 66 | B02 | PET-6 | 3.3 | 9.81 | 0.32 | 0.66 |
| Comparative Example 67 | B03 | PET-1 | 3.5 | 11.64 | 0.32 | 0.66 |
| Comparative Example 68 | B03 | PET-2 | 3.3 | 12.37 | 0.32 | 0.66 |
| Comparative Example 69 | B03 | PET-3 | 3.3 | 12.39 | 0.32 | 0.66 |
| Comparative Example 70 | B03 | PET-4 | 3.3 | 12.39 | 0.32 | 0.66 |
| Comparative Example 71 | B03 | PET-5 | 3.3 | 12.31 | 0.32 | 0.66 |
| Comparative Example 72 | B03 | PET-6 | 3.3 | 12.37 | 0.32 | 0.66 |

**Table 6**

| | First em itter | Material for electron transport layer | Driving voltage (V) at 1000 cd/m² | Maximum power efficiency (cd/W) | CIE x | CIE y |
|---|---|---|---|---|---|---|
| Example 7 | PD02 | ET-1 | 2.9 | 23.23 | 0.47 | 0.53 |
| Example 8 | PD02 | ET-2 | 2.95 | 22.84 | 0.47 | 0.53 |
| Example 9 | PD02 | ET-3 | 2.75 | 24.47 | 0.47 | 0.53 |
| Example 10 | PD02 | ET-4 | 2.95 | 22.83 | 0.47 | 0.53 |
| Example 11 | PD02 | ET-5 | 2.9 | 23.23 | 0.47 | 0.53 |
| Example 12 | PD02 | ET-6 | 2.8 | 24.05 | 0.47 | 0.53 |
| Comparative Example 7 | PD02 | PET-1 | 3.5 | 19.18 | 0.47 | 0.53 |
| Comparative Example 8 | PD02 | PET-2 | 3.3 | 20.40 | 0.47 | 0.53 |
| Comparative Example 9 | PD02 | PET-3 | 3.3 | 20.42 | 0.47 | 0.53 |
| Comparative Example 10 | PD02 | PET-4 | 3.3 | 20.42 | 0.47 | 0.53 |
| Comparative Example 11 | PD02 | PET-5 | 3.3 | 20.3 | 0.47 | 0.53 |
| Comparative Example 12 | PD02 | PET-6 | 3.3 | 20.39 | 0.47 | 0.53 |

**Table 7**

| | First emitter | Material for electron transport layer | Driving voltage (V) at 1000 cd/m² | Maximum power efficiency (cd/W) | CIE x | CIE y |
|---|---|---|---|---|---|---|
| Example 13 | PD03 | ET-1 | 2.9 | 22.69 | 0.23 | 0.71 |
| Example 14 | PD03 | ET-2 | 2.95 | 22.3 | 0.23 | 0.71 |
| Example 15 | PD03 | ET-3 | 2.75 | 23.9 | 0.23 | 0.71 |
| Example 16 | PD03 | ET-4 | 2.95 | 22.29 | 0.23 | 0.71 |
| Example 17 | PD03 | ET-5 | 2.9 | 22.68 | 0.23 | 0.71 |
| Example 18 | PD03 | ET-6 | 2.8 | 23.49 | 0.23 | 0.71 |
| Comparative Example 13 | PD03 | PET-1 | 3.5 | 18.73 | 0.23 | 0.71 |
| Comparative Example 14 | PD03 | PET-2 | 3.3 | 19.92 | 0.23 | 0.71 |
| Comparative Example 15 | PD03 | PET-3 | 3.3 | 19.94 | 0.23 | 0.71 |
| Comparative Example 16 | PD03 | PET-4 | 3.3 | 19.94 | 0.23 | 0.71 |
| Comparative Example 17 | PD03 | PET-5 | 3.3 | 19.82 | 0.23 | 0.71 |
| Comparative Example 18 | PD03 | PET-6 | 3.3 | 19.91 | 0.23 | 0.71 |

**Table 8**

| | First emitter | Material for electron transport layer | Driving voltage (V) at 1000 cd/m² | Maximum power efficiency (cd/W) | CIE x | CIE y |
|---|---|---|---|---|---|---|
| Example 19 | PD04 | ET-1 | 2.9 | 24.02 | 0.42 | 0.57 |
| Example 20 | PD04 | ET-2 | 2.95 | 23.61 | 0.42 | 0.57 |
| Example 21 | PD04 | ET-3 | 2.75 | 25.3 | 0.42 | 0.57 |
| Example 22 | PD04 | ET-4 | 2.95 | 23.6 | 0.42 | 0.57 |
| Example 23 | PD04 | ET-5 | 2.9 | 24.02 | 0.42 | 0.57 |
| Example 24 | PD04 | ET-6 | 2.8 | 24.87 | 0.42 | 0.57 |
| Comparative Example 19 | PD04 | PET-1 | 3.5 | 19.84 | 0.42 | 0.57 |
| Comparative Example 20 | PD04 | PET-2 | 3.3 | 21.09 | 0.42 | 0.57 |
| Comparative Example 21 | PD04 | PET-3 | 3.3 | 21.11 | 0.42 | 0.57 |
| Comparative Example 22 | PD04 | PET-4 | 3.3 | 21.11 | 0.42 | 0.57 |
| Comparative Example 23 | PD04 | PET-5 | 3.3 | 20.99 | 0.42 | 0.57 |
| Comparative Example 24 | PD04 | PET-6 | 3.3 | 21.08 | 0.42 | 0.57 |

**Table 9**

| | First emitter | Material for electron transport layer | Driving voltage (V) at 1000 cd/m² | Maximum power efficiency (cd/W) | CIE x | CIE y |
|---|---|---|---|---|---|---|
| Example 25 | PD06 | ET-1 | 2.9 | 23.75 | 0.48 | 0.52 |
| Example 26 | PD06 | ET-2 | 2.95 | 23.35 | 0.48 | 0.52 |
| Example 27 | PD06 | ET-3 | 2.75 | 25.02 | 0.48 | 0.52 |
| Example 28 | PD06 | ET-4 | 2.95 | 23.34 | 0.48 | 0.52 |
| Example 29 | PD06 | ET-5 | 2.9 | 23.75 | 0.48 | 0.52 |
| Example 30 | PD06 | ET-6 | 2.8 | 24.59 | 0.48 | 0.52 |
| Comparative Example 25 | PD06 | PET-1 | 3.5 | 19.61 | 0.48 | 0.52 |
| Comparative Example 26 | PD06 | PET-2 | 3.3 | 20.85 | 0.48 | 0.52 |
| Comparative Example 27 | PD06 | PET-3 | 3.3 | 20.87 | 0.48 | 0.52 |
| Comparative Example 28 | PD06 | PET-4 | 3.3 | 20.87 | 0.48 | 0.52 |
| Comparative Example 29 | PD06 | PET-5 | 3.3 | 20.75 | 0.48 | 0.52 |
| Comparative Example 30 | PD06 | PET-6 | 3.3 | 20.84 | 0.48 | 0.52 |

**Table 10**

| | First emitter | Material for electron transport layer | Driving voltage (V) at 1000 cd/m² | Maximum power efficiency (cd/W) | CIE x | CIE y |
|---|---|---|---|---|---|---|
| Example 31 | PD08 | ET-1 | 2.9 | 22.9 | 0.70 | 0.30 |
| Example 32 | PD08 | ET-2 | 2.95 | 22.51 | 0.70 | 0.30 |
| Example 33 | PD08 | ET-3 | 2.75 | 24.12 | 0.70 | 0.30 |
| Example 34 | PD08 | ET-4 | 2.95 | 22.5 | 0.70 | 0.30 |
| Example 35 | PD08 | ET-5 | 2.9 | 22.89 | 0.70 | 0.30 |
| Example 36 | PD08 | ET-6 | 2.8 | 23.7 | 0.70 | 0.30 |
| Comparative Example 31 | PD08 | PET-1 | 3.5 | 18.91 | 0.70 | 0.30 |
| Comparative Example 32 | PD08 | PET-2 | 3.3 | 20.10 | 0.70 | 0.30 |
| Comparative Example 33 | PD08 | PET-3 | 3.3 | 20.12 | 0.70 | 0.30 |
| Comparative Example 34 | PD08 | PET-4 | 3.3 | 20.12 | 0.70 | 0.30 |
| Comparative Example 35 | PD08 | PET-5 | 3.3 | 20 | 0.70 | 0.30 |
| Comparative Example 36 | PD08 | PET-6 | 3.3 | 20.09 | 0.70 | 0.30 |

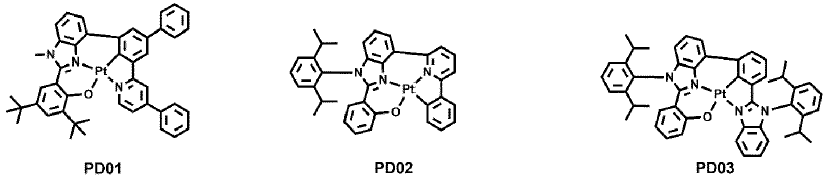

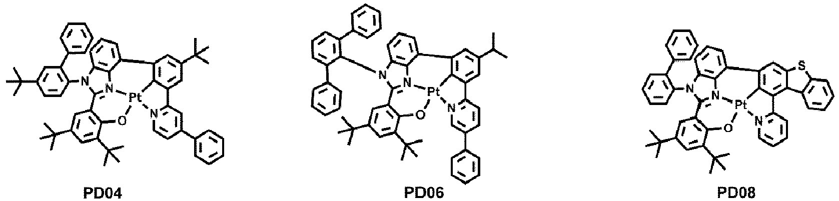

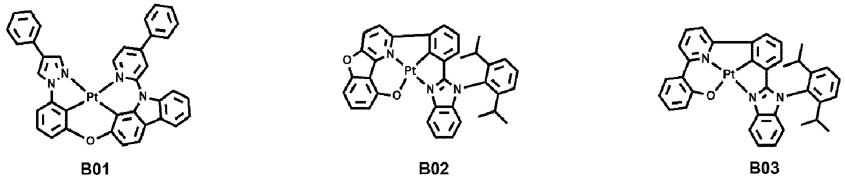

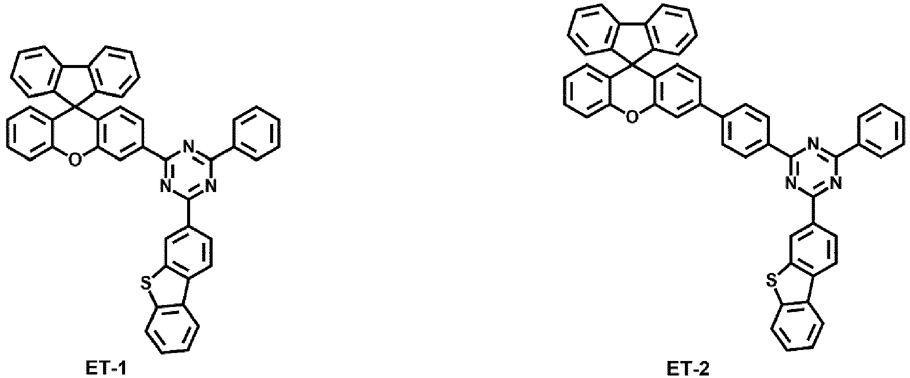

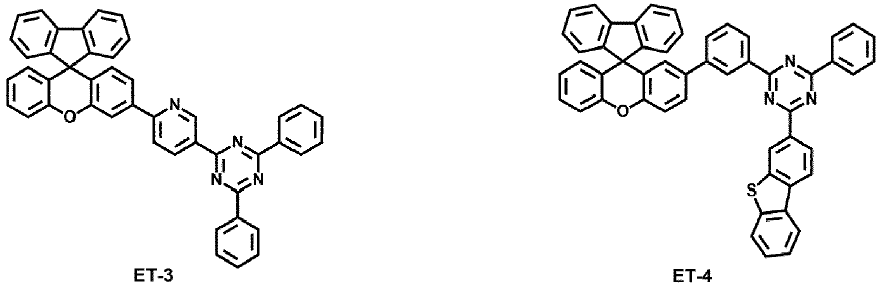

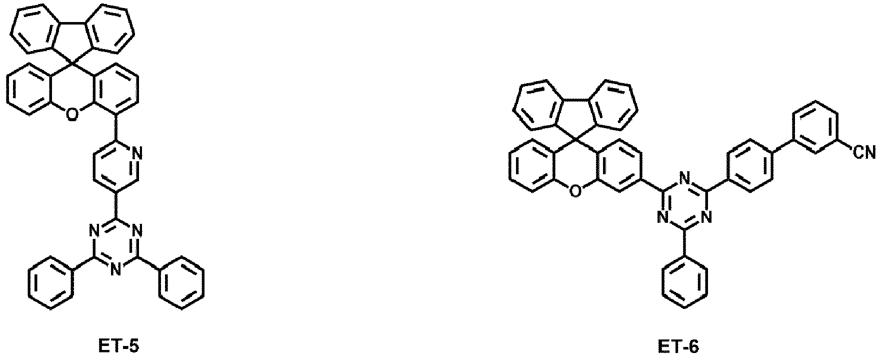

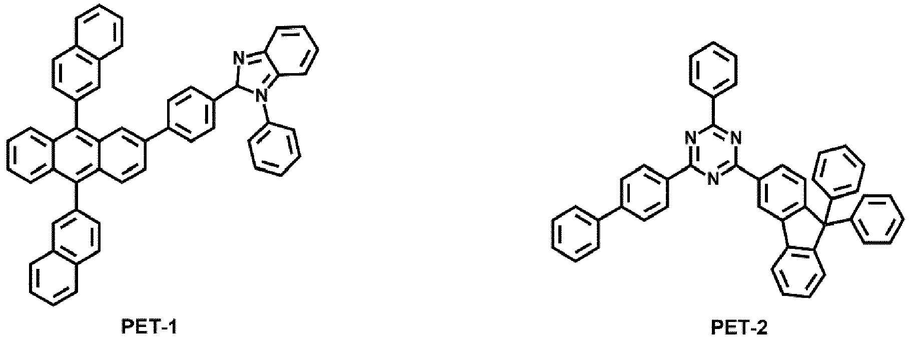

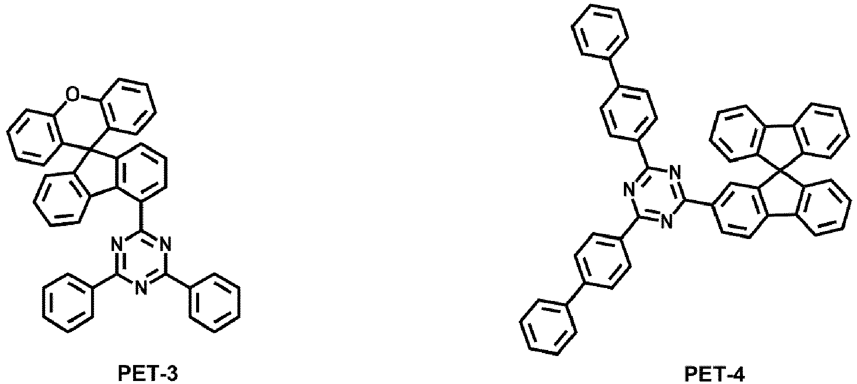

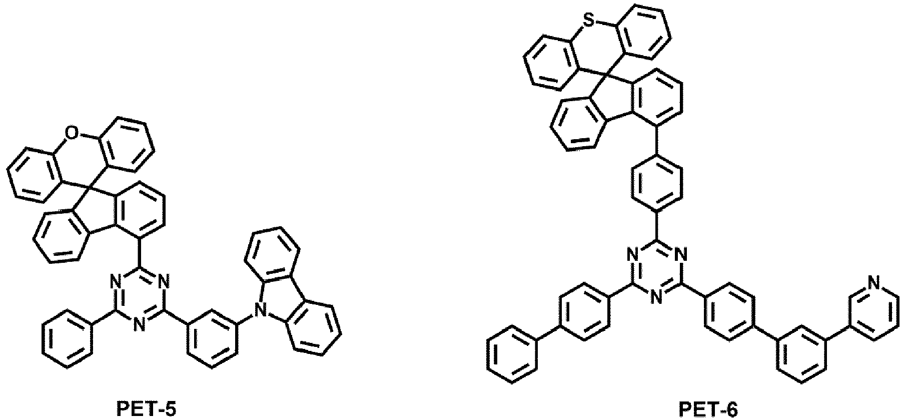

From Tables 5 to 10, it can be confirmed that the light-emitting devices manufactured in Examples each have lower driving voltage and higher maximum power efficiency than the light-emitting devices manufactured in Comparative Examples.

According to the one or more embodiments, a light-emitting device may have a low driving voltage and high power efficiency. Accordingly, the light-emitting device may enable the manufacture of a high-quality electronic device and a high-quality consumer product.

The electronic apparatus, the electronic device and/or the light-emitting device and/or any other relevant devices or components according to embodiments of the present invention described herein may be implemented utilizing any suitable hardware, firmware (e.g. an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the [device] may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

## Claims

1. A light-emitting device (10) comprising:
a first electrode (110);
a second electrode (150) facing the first electrode (110); and
an interlayer (130) between the first electrode (110) and the second electrode (150),
wherein the interlayer (130) comprises an emission layer and an electron transport region,
the electron transport region is between the emission layer and the second electrode (150),
the emission layer comprises a first emitter,
the first emitter is configured to emit a first light having a first emission spectrum,
the first emitter comprises platinum,
a triplet metal-to-ligand charge transfer state (³MLCT) of the first emitter is 7 % or more,
the ³MLCT is evaluated by quantum chemical calculations based on density functional theory (DFT),
the electron transport region comprises a heterocyclic compound, and
the heterocyclic compound comprises:
a first moiety comprising a group represented by one of Formulae 8-1 to 8-4; and
a second moiety comprising a diazine group, a triazine group, or one or more combinations thereof;
wherein
the first moiety and the second moiety are linked to each other through a single bond or a first linking group: 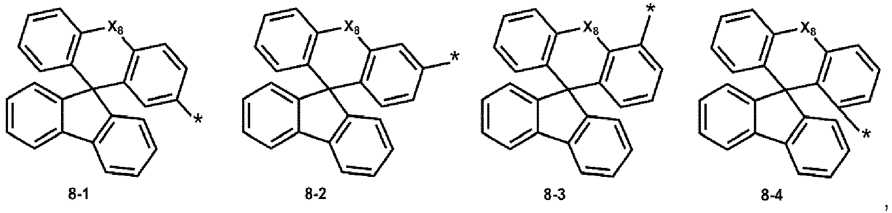 and wherein, in Formulae 8-1 to 8-4,
X₈ is O, S, or Se, and
* indicates a binding site to a single bond bonded to the second moiety or a first linking group bonded to the second moiety.

2. The light-emitting device of claim 1, wherein
an emission peak wavelength of the first light is 510 nm to 610 nm.

3. The light-emitting device of claim 1, wherein
a full width at half maximum of the first light is 15 nm to 85 nm.

4. The light-emitting device of claim 1, wherein
the first emitter further comprises a first ligand bonded to the platinum, and
the first emitter satisfies at least one of Conditions A to Condition C:
**Condition A**
the first ligand is a tetradentate ligand, and
the number of cyclometallated rings formed by a chemical bond between the platinum and the first ligand is three;
**Condition B**
each of carbon, nitrogen, and oxygen of the first ligand is chemically bonded to the platinum; and
**Condition C**
the first ligand comprises an imidazole group, a benzimidazole group, a naphthoimidazole group, or one or more combinations thereof.

5. The light-emitting device of claim 1, wherein
the first emitter is an organometallic compound represented by Formula 1: 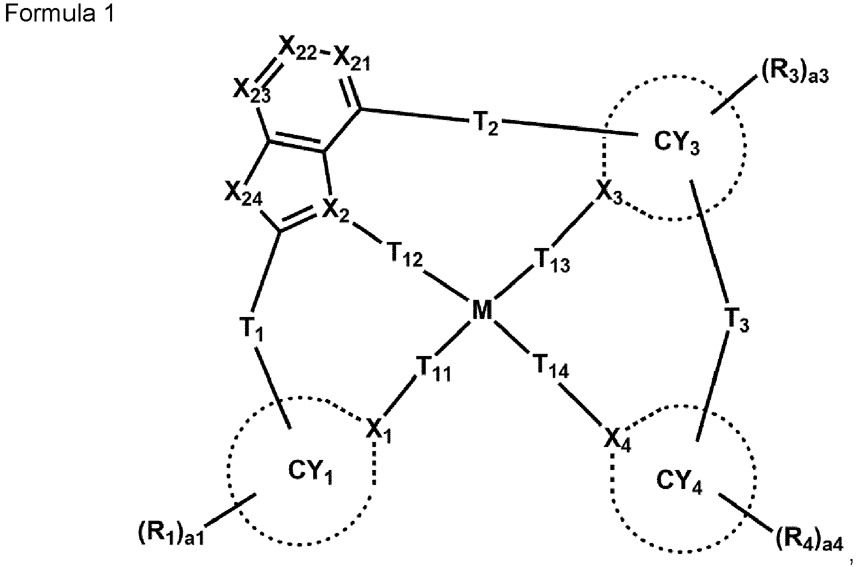 wherein, in Formula 1,
M is platinum (Pt),
X₁ to X₄ are each independently N or C,
T₁₁ to T₁₄ are each independently a chemical bond, O, S, B(R'), N(R'), P(R'), C(R')(R"), Si(R')(R"), Ge(R')(R"), C(=O), B(R')(R"), N(R')(R"), or P(R')(R"),
when T₁₁ is a chemical bond, X₁ and M are directly bonded to each other,
when T₁₂ is a chemical bond, X₂ and M are directly bonded to each other,
when T₁₃ is a chemical bond, X₃ and M are directly bonded to each other,
when T₁₄ is a chemical bond, X₄ and M are directly bonded to each other,
two of the bonds selected from a bond between X₁ or T₁₁ and M, a bond between X₂ or T₁₂ and M, a bond between X₃ or T₁₃ and M, and a bond between X₄ or T₁₄ and M are coordinate bonds, and the other two bonds are covalent bonds,
T₁ is a single bond, a double bond, *-N(Rs)-*', *-B(Rs)-*', *-P(Rs)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)₂-*', *-C(Rs)=*', *=C(R₅)-*', *-C(R₅ₐ)=C(R_{5b})-*', *-C(=S)-*', or *-C≡C-*',
T₂ is a single bond, a double bond, *-N(R₆)-*', *-B(R₆)-*', *-P(R₆)-*', *-C(R₆ₐ)(R_{6b})-*', *-Si(R₆ₐ)(R_{6b})-*', *-Ge(R₆ₐ)(R_{6b})-*', *-S-*', *-Se-*', *-O-*', *-C(=O)-*', *-S(=O)-*', *-S(=O)₂-*', *-C(R₆)=*', *=C(R₆)-*', *-C(R₆ₐ)=C(R_{6b})-*', *-C(=S)-*', or *-C≡C-*',
T₃ is a single bond, a double bond, *-N(R₇)-*', *-B(R₇)-*', *-P(R₇)-*', *-C(R₇ₐ)(R_{7b})-*', *-Si(R₇ₐ)(R_{7b})-*', *-Ge(R₇ₐ)(R_{7b})-*', *-S-*', *-Se-*', *-O-*', *-C(=O)-*', *-S(=O)-*', *-S(=O)₂-*', *-C(R₇)=*', *=C(R₇)-*', *-C(R₇a)=C(R_{7b})-*', *-C(=S)-*', or *-C≡C-*',
ring CY₁, ring CY₃, and ring CY₄ are each independently a C₃-C₆₀ carbocyclic group or a C₁-C₆₀ heterocyclic group,
X₂₁ is N or C(R₂₁), X₂₂ is N or C(R₂₂), and X₂₃ is N or C(R₂₃),
X₂₄ is O, S, N(R₂₄), or C(R₂₄ₐ)(R_{24b}),
R₁, R₂₁ to R₂₄, R₂₄ₐ, R_{24b}, R₃ to R₇, R₅ₐ, R_{5b}, R₆ₐ, R_{6b}, R₇ₐ, R_{7b}, R", and R" are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with R₁₀ₐ, a C₂-C₆₀ alkynyl group unsubstituted or substituted with R₁₀ₐ, a C₁-C₆₀ alkoxy group unsubstituted or substituted with R₁₀ₐ, a C₃-C₆₀ carbocyclic group unsubstituted or substituted with R₁₀ₐ, a C₁-C₆₀ heterocyclic group unsubstituted or substituted with R₁₀ₐ, a C₆-C₆₀ aryloxy unsubstituted or substituted with R₁₀ₐ, a C₆-C₆₀ arylthio group unsubstituted or substituted with R₁₀ₐ, a C₇-C₆₀ arylalkyl group unsubstituted or substituted with R₁₀ₐ, a C₂-C₆₀ heteroarylalkyl group unsubstituted or substituted with R₁₀ₐ, -C(Q₁)(Q₂)(Q₃), - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
a1, a3, and a4 are each independently an integer from 0 to 20,
* and *' each indicate a binding site to an adjacent atom, and
i) two groups of a1 R₁, ii) two groups of R₂₁ to R₂₃, iii) two groups of a3 R₃, iv) two groups of a4 R₄, v) R₅ₐ and R_{5b}, vi) R₆ₐ and R_{6b}, and vii) R₇ₐ and R_{7b} are each optionally linked to each other via a single bond, a double bond, or a first linking group to form a C₃-C₆₀ carbocyclic group unsubstituted or substituted with at least one R₁₀ₐ or a C₁-C₆₀ heterocyclic group unsubstituted or substituted with at least one R₁₀ₐ, and
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂)₇-C(=O)(Q₁₁), -S(=O)₂(Q₁₁), -P(=O)(Q₁₁)(Q₁₂), or one or more combinations thereof;
a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), -C(=O)(Q₂₁),-S(=O)₂(Q₂₁), -P(=O)(Q₂₁)(Q₂₂), or one or more combinations thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
wherein Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or one or more combinations thereof.

6. The light-emitting device of claim 5, wherein
X₁ and X₃ are each C, and
X₂ and X₄ are each N.

7. The light-emitting device of claim 6, wherein
T₁₁ is O or S, and
T₁₂ to T₁₄ are each a chemical bond.

8. The light-emitting device of claim 1, wherein
the electron transport region comprises an electron transport layer, and
the heterocyclic compound is in the electron transport layer.

9. The light-emitting device of claim 8, wherein
the electron transport layer is in direct contact with the emission layer.

10. The light-emitting device of claim 1, wherein
the electron transport region comprises a hole-blocking layer and an electron transport layer,
the hole-blocking layer is between the emission layer and the electron transport layer,
the hole-blocking layer does not comprise the heterocyclic compound, and
the heterocyclic compound is in the electron transport layer.

11. The light-emitting device of claim 1, wherein
the heterocyclic compound is a compound represented by Formula 8: 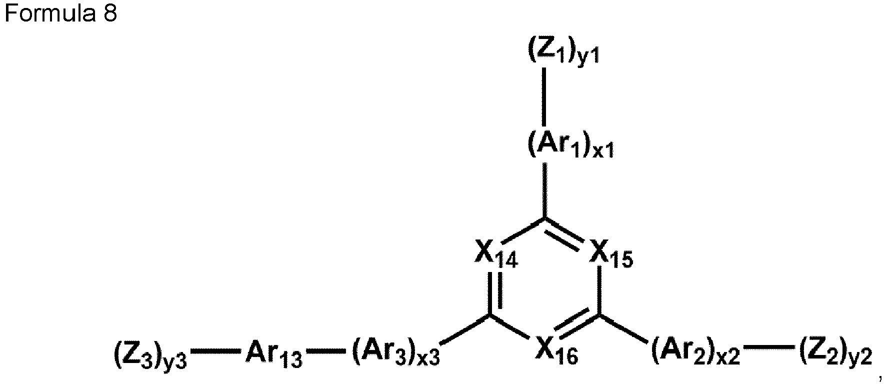 wherein, in Formula 8,
X₁₄ is N or C(Z₄), X₁₅ is N or C(Z₅), and X₁₆ is N or C(Z₆),
two or more of X₁₄ to X₁₆ are each N,
Ar₁ to Ar₃ are each independently a C₃-C₆₀ carbocyclic group unsubstituted or substituted with R₁₀ₐ, or a C₁-C₆₀ heterocyclic group unsubstituted or substituted with R10a,
x1 to x3 are each independently an integer from 0 to 10,
i) when x1 is 0, *-(Ar₁)ₓ₁-*' is a single bond,
ii) when x2 is 0, *-(Ar₂)ₓ₂-*' is a single bond,
iii) when x3 is 0, *-(Ar₃)ₓ₃-*' is a single bond,
Ar₁₃ is a group represented by one of Formulae 8-1 to 8-4,
Z₁ to Z₆ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃),-N(Q₁)(Q₂), -B(Q₁)(Q₂), -C(=O)(Q₁), -S(=O)₂(Q₁), or -P(=O)(Q₁)(Q₂),
y1 to y3 are each independently one of the integers from 0 to 5, and
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂),-C(=O)(Q₁₁), -S(=O)₂(Q₁₁), -P(=O)(Q₁₁)(Q₁₂), or one or more combinations thereof;
a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), -C(=O)(Q₂₁),-S(=O)₂(Q₂₁), -P(=O)(Q₂₁)(Q₂₂), or one or more combinations thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
wherein Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or one or more combinations thereof: 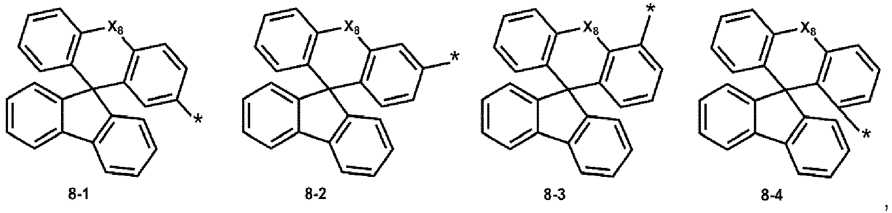 and wherein, in Formulae 8-1 to 8-4,
X₈ is O, S, or Se, and
* indicates a binding site to Ar₃ in Formula 8.

12. The light-emitting device of claim 11, wherein
at least one of x1 or x2 is 2 or more.

13. The light-emitting device of claim 11, wherein
x1 and x2 are each independently an integer from 0 to 10,
x3 is 0, 1, or 2, and
Ar₁ to Ar₃ are each independently a benzene group, a naphthalene group, phenanthrene group, an anthracene group, a dibenzofuran group, a dibenzothiophene group, a carbazole group, a fluorene group, or a pyridine group, unsubstituted or substituted with at least one R₁₀ₐ.

14. An electronic device comprising the light-emitting device of any one of claims 1 to 13;
optionally further comprising:
a color filter, a color conversion layer, a touch screen layer, a polarizing layer, or one or more combinations thereof.

15. An electronic apparatus comprising the light-emitting device of any one of claims 1 to 13;
optionally wherein the electronic apparatus is a flat panel display; a curved display; a computer monitor; a medical monitor; a TV; a billboard; an indoor or outdoor illumination and/or signal light; a head-up display; a fully or partially transparent display; a flexible display; a rollable display; a foldable display; a stretchable display; a laser printer; a phone; a cell phone; a tablet; a phablet; a personal digital assistant, PDA; a wearable device; a laptop computer; a digital camera; a camcorder; a viewfinder; a micro display; a three-dimensional (3D) display; a virtual or augmented reality display; a vehicle; a video wall comprising multiple displays tiled together; a theater or stadium screen; a phototherapy device; a signage; or one or more combinations thereof.
